# EUROPEAN PATENT APPLICATION

(11) **EP 4 709 127 A1**
(43) Date of publication of application: **11.03.2026**
(21) Application number: 24797229.2
(22) Date of filing: 26.04.2024
(51) Int. Cl.: H10N 10/856, H10N 10/17, H10N 10/817, H10N 10/857

(54) **THERMOELECTRIC CONVERSION ELEMENT AND THERMOELECTRIC CONVERSION METHOD**

(30) Priority: 26.04.2023 JP 2023072635; 26.04.2023 JP 2023072648; 26.04.2023 JP 2023072658; 26.04.2023 JP 2023072664
(71) Applicant: Tsujiuchi, Yutaka, Akita-shi, Akita 010-0001 (JP)
(72) Inventor: Tsujiuchi, Yutaka, Akita-shi, Akita 010-0001 (JP)
(74) Representative: Müller-Boré & Partner Patentanwälte PartG mbB
(86) International application number: PCT/JP2024/016610
(87) International publication number: WO 2024/225487

(57) **Abstract**

Provided are: a thermoelectric conversion device capable of converting heat energy to electrical energy even in an environment of no temperature difference, the thermoelectric conversion device including a positive electrode and a negative electrode that are made from materials having different conductivities, and an organic semiconductor layer between the positive electrode and the negative electrode that contains a material that generates electrons and holes by thermal excitation; and a thermoelectric conversion method using this thermoelectric conversion device.

## Description

### [Technical Field]

The present invention relates to thermoelectric conversion devices and thermoelectric conversion methods, and specifically, to a thermoelectric conversion device usable in isothermal environments, and a thermoelectric conversion method using this thermoelectric conversion device.

### [Background Art]

Conventionally, the following phenomenon is utilized as a technique of direct conversion from heat energy to electrical energy: heating one end of a rod-shaped metal or semiconductor sample and cooling the other end thereof to make a temperature difference between both the ends generates a voltage in proportion to the temperature difference. This was discovered by T. J. Seebeck in 1821, and named the Seebeck effect (non patent literatures 1 to 3).

Conversely, the heating and cooling phenomenon depending on the direction of a current flowing from the one end is also known. This was discovered by J. C. Peltier in 1834, and named the Peltier effect (non patent literature 4).

The following phenomenon is also known: when a temperature difference is made between aligned n-type and p-type semiconductors based on the principle of the Seebeck effect, the carriers in the semiconductors, which carry charges, are diffused by heat, which causes electromotive force to be generated. The method of using a bismuth and tellurium material that contains element bismuth and element tellurium is known as an example where a great electromotive force was obtained (non patent literature 5).

### [Citation List]

### [Non Patent Literature]

[Non Patent Literature 1] SEEBECK, T. J. Uber den Magnetismus der galvanischen Kette. Abhadlungen der Physikalischen Klasse der Koniglisch-PreuBsischen. Akademie der Wissenschaftten aus den Jahren. 1822, 1820-1821: 289-346.
[Non Patent Literature 2] SEEBECK, T. J. Magnetische Polarisation der Metalle und Erze durch Temperatur-Differenz. Abhandlungen der Koniglichen Akademie der Wissenschaften zu Berlin. 1825, pp. 265-373, (Magnetic Polarization of Metals and Minerals by Temperature Differences. Treatises of the Royal Academy of Sciences in Berlin.)
[Non Patent Literature 3] SEEBECK. Ueber die Magnetische Polarisation der Metalle und Erze durch Temperatur-Differenz. Annalen der Physik und Chemie. 1826, 6:1-20, 133-160, 253-286, (on the Magnetic Polarization of Metals and Minerals by Temperature Differences.)
[Non Patent Literature 4] PELTIER. Nouvelles experiences sur la caloricite des courants electrique. Annales de Chimie et de Physique (in French). 1834, 56: 371-386, (New Experiments on the Heat Effects of Electric Currents.)
[Non Patent Literature 5] ROSI, F. D., ABELES, B., JENSEN, R. V. J. Phys. Chem. Solids. 1959, 10, 191-200

### [Summary of Invention]

### [Technical Problem]

The methods of non patent literatures 1 to 3 always require a low temperature portion and a high temperature portion, but it is not considered that an environment broadly satisfying such a condition can be firmly prepared. The technique of non patent literature 5 needs to use bismuth and tellurium, which are rare metals, which is economically inferior.

An object of the present invention is to provide a thermoelectric conversion device capable of converting heat energy to electrical energy even in an environment of no temperature difference, and a thermoelectric conversion method using this thermoelectric conversion device.

### [Solution to Problem]

The inventor of the present invention intensively carried out the study to solve the foregoing problems, and completed the following invention.
[1] A thermoelectric conversion device comprising:
   a positive electrode;
   a negative electrode, the positive electrode and the negative electrode being made from materials having different conductivities; and
   an organic semiconductor layer between the positive electrode and the negative electrode, the organic semiconductor layer containing a material that generates electrons and holes by thermal excitation.
[2] The thermoelectric conversion device according to [1], wherein
   the materials having different conductivities are a material of a higher conductivity that constitutes the negative electrode and a material of a lower conductivity that constitutes the positive electrode, and difference in conductivity between the material of a higher conductivity and the material of a lower conductivity is 50 S/m to 10,000 S/m.
[3] The thermoelectric conversion device according to [1] or [2], wherein
   the positive electrode is made from indium tin oxide or a carbon material, and the negative electrode is made from a metallic material.
[4] The thermoelectric conversion device according to any of [1] to [3], wherein
   the material that generates electrons and holes by thermal excitation is a viscous liquid containing a material that generates electrons and holes by thermal excitation.
[5] The thermoelectric conversion device according to [4], wherein
   the viscous liquid is a viscous liquid capable of transporting ions as charge carriers.
[6] The thermoelectric conversion device according to any of [1] to [5], wherein
   the material that generates electrons and holes by thermal excitation is iron phthalocyanine or zinc phthalocyanine.
[7] A thermoelectric conversion method comprising:
   disposing the thermoelectric conversion device according to any of [1] to [6] in a thermal environment.
[8] A thermoelectric conversion device comprising:
   a positive electrode;
   a negative electrode, the positive electrode and the negative electrode being made from materials having different conductivities; and
   an organic semiconductor layer between the positive electrode and the negative electrode, the organic semiconductor layer containing materials that generate electrons and holes by thermal excitation, the organic semiconductor layer including a first organic semiconductor layer on a side of the positive electrode, and a second semiconductor layer on a side of the negative electrode, and
   the first organic semiconductor layer is higher than the second semiconductor layer in HOMO energy level.
[9] The thermoelectric conversion device according to [8], wherein
   the materials having different conductivities are a material of a higher conductivity that constitutes the negative electrode and a material of a lower conductivity that constitutes the positive electrode, and difference in conductivity between the material of a higher conductivity and the material of a lower conductivity is 50 S/m to 10,000 S/m.
[10] The thermoelectric conversion device according to [8] or [9], wherein
   the positive electrode is made from indium tin oxide or a carbon material, and the negative electrode is made from a metallic material.
[11] The thermoelectric conversion device according to any of [8] to [10], wherein
   the materials that generate electrons and holes by thermal excitation are viscous liquids containing materials that generate electrons and holes by thermal excitation.
[12] The thermoelectric conversion device according to [11], wherein
   the viscous liquids are viscous liquids capable of transporting ions as charge carriers.
[13] The thermoelectric conversion device according to any of [8] to [12], wherein
   the materials that generate electrons and holes by thermal excitation are iron phthalocyanine or zinc phthalocyanine.
[14] The thermoelectric conversion device according to any of [8] to [13], wherein
   the materials that generate electrons and holes by thermal excitation are iron phthalocyanine contained in the first organic semiconductor layer, and zinc phthalocyanine contained in the second organic semiconductor layer.
[15] A thermoelectric conversion method comprising:
   disposing the thermoelectric conversion device according to any of [8] to [14] in a thermal environment.
[16] A thermoelectric conversion device comprising:
   a positive electrode;
   a negative electrode, the positive electrode and the negative electrode being made from materials having different conductivities; and
   an organic semiconductor layer between the positive electrode and the negative electrode, the organic semiconductor layer containing a material that generates electrons and holes by thermal excitation, the organic semiconductor layer further containing ions of a transition metal.
[17] The thermoelectric conversion device according to [16], wherein
   the materials having different conductivities are a material of a higher conductivity that constitutes the negative electrode and a material of a lower conductivity that constitutes the positive electrode, and difference in conductivity between the material of a higher conductivity and the material of a lower conductivity is 50 S/m to 10,000 S/m.
[18] The thermoelectric conversion device according to [16] or [17], wherein
   the positive electrode is made from indium tin oxide or a carbon material, and the negative electrode is made from a metallic material.
[19] The thermoelectric conversion device according to any of [16] to [18], wherein
   the material that generates electrons and holes by thermal excitation is a viscous liquid containing a material that generates electrons and holes by thermal excitation.
[20] The thermoelectric conversion device according to [19], wherein
   the viscous liquid is a viscous liquid capable of transporting ions as charge carriers.
[21] The thermoelectric conversion device according to any of [16] to [20], wherein
   the material that generates electrons and holes by thermal excitation is iron phthalocyanine or zinc phthalocyanine.
[22] The thermoelectric conversion device according to any of [16] to [21], wherein
   the ions of a transition metal are at least one kind selected from iron ions, manganese ions, zinc ions, copper ions, cobalt ions, and nickel ions.
[23] A thermoelectric conversion method comprising:
   disposing the thermoelectric conversion device according to any of [16] to [22] in a thermal environment.
[24] A thermoelectric conversion device comprising:
   a positive electrode;
   a negative electrode, the positive electrode and the negative electrode being made from materials having different conductivities;
   an organic semiconductor layer between the positive electrode and the negative electrode, the organic semiconductor layer containing materials that generate electrons and holes by thermal excitation, the organic semiconductor layer including a first organic semiconductor layer on a side of the positive electrode, and a second semiconductor layer on a side of the negative electrode; and
   a layer between the first organic semiconductor layer and the second semiconductor layer, the layer being made from a carbonaceous substance.
[25] The thermoelectric conversion device according to [24], wherein
   the materials having different conductivities are a material of a higher conductivity that constitutes the negative electrode and a material of a lower conductivity that constitutes the positive electrode, and difference in conductivity between the material of a higher conductivity and the material of a lower conductivity is 50 S/m to 10,000 S/m.
[26] The thermoelectric conversion device according to [24] or [25], wherein
   the positive electrode is made from indium tin oxide or a carbon material, and the negative electrode is made from a metallic material.
[27] The thermoelectric conversion device according to any of [24] to [26], wherein
   the materials that generate electrons and holes by thermal excitation are viscous liquids containing materials that generate electrons and holes by thermal excitation.
[28] The thermoelectric conversion device according to [27], wherein
   the viscous liquids are viscous liquids capable of transporting ions as charge carriers.
[29] The thermoelectric conversion device according to any of [24] to [28], wherein
   the first organic semiconductor layer is higher than the second semiconductor layer in HOMO energy level.
[30] The thermoelectric conversion device according to any of [24] to [29], wherein
   the materials that generate electrons and holes by thermal excitation are iron phthalocyanine or zinc phthalocyanine.
[31] The thermoelectric conversion device according to any of [24] to [30], wherein
   the materials that generate electrons and holes by thermal excitation are iron phthalocyanine contained in the first organic semiconductor layer, and zinc phthalocyanine contained in the second organic semiconductor layer.
[32] The thermoelectric conversion device according to any of [24] to [31], wherein
   the layer made from a carbonaceous substance is a layer made from graphite.
[33] A thermoelectric conversion method comprising:
   disposing the thermoelectric conversion device according to any of [24] to [32] in a thermal environment.

### [Advantageous Effects of Invention]

According to the thermoelectric conversion device and the thermoelectric conversion method of the present invention, heat energy can be converted to electrical energy even in an environment of no temperature difference.

### [Brief Description of Drawings]

[Fig. 1]

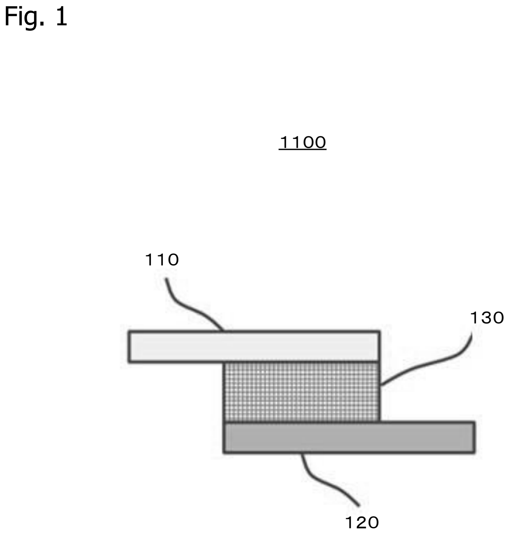

   Fig. 1 is a schematic view of a thermoelectric conversion device of the present invention according to the first embodiment.
[Fig. 2]

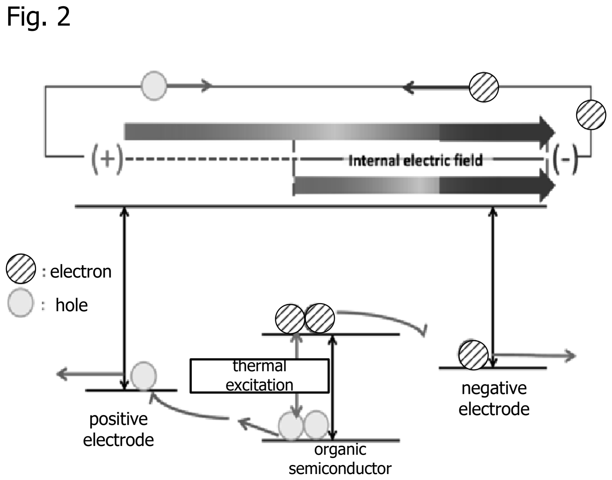

   Fig. 2 shows a model for theoretically illustrating the thermoelectric conversion device of the present invention according to the first embodiment.
[Fig. 3]

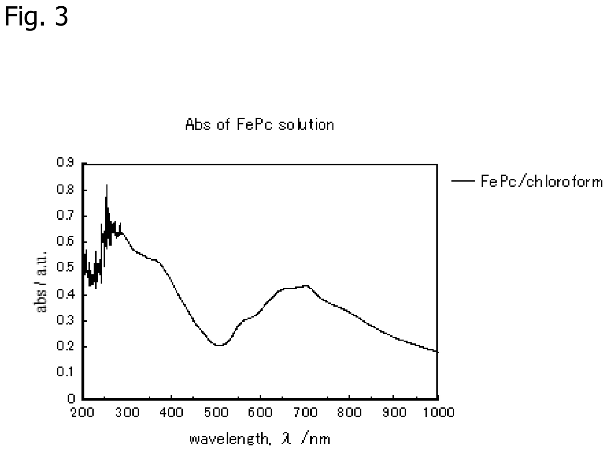

   Fig. 3 shows the light absorption spectrum measured concerning iron phthalocyanine (FePc).
[Fig. 4]

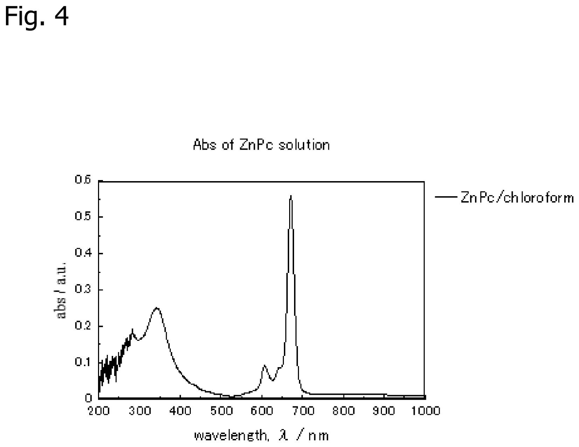

   Fig. 4 shows the light absorption spectrum measured concerning zinc phthalocyanine (ZnPc).
[Fig. 5]

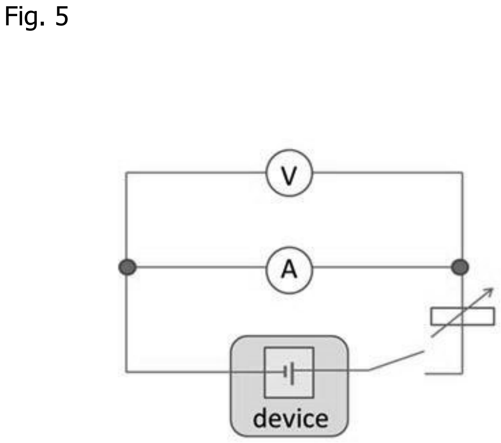

   Fig. 5 shows a circuit assembled for measuring electrical energy concerning the devices prepared in examples and comparative examples.
[Fig. 6]

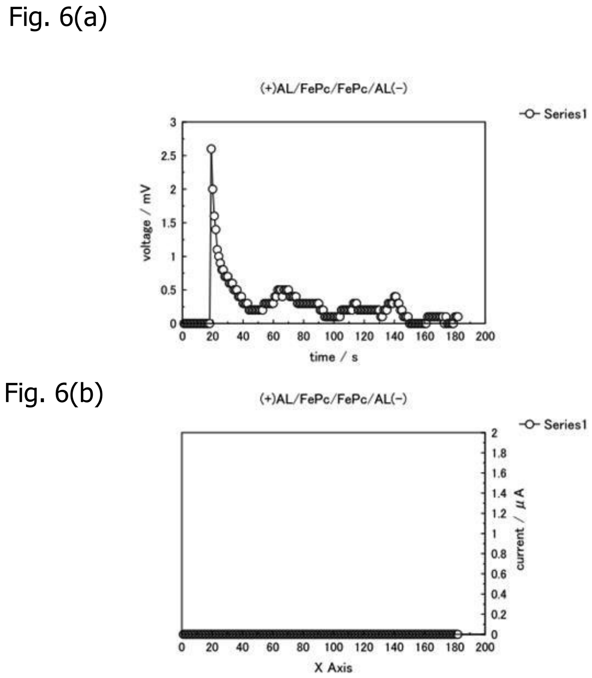

   Fig. 6(a) shows the measurement results of the voltage of the device of comparative example 1-1, and Fig. 6(b) shows the measurement results of the current of the device of comparative example 1-1.
[Fig. 7]

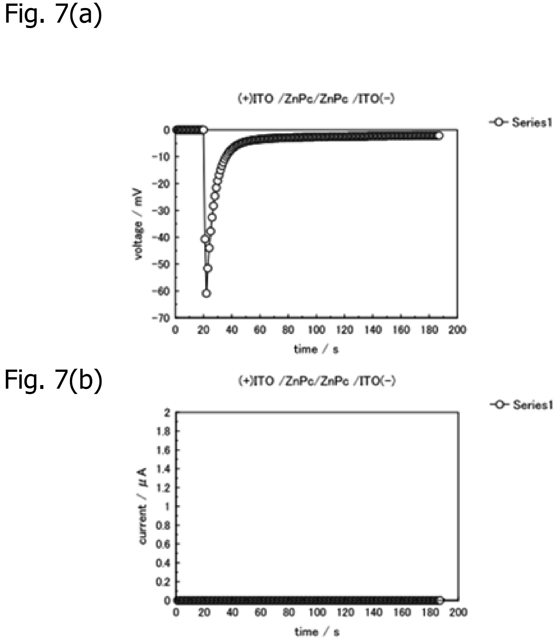

   Fig. 7(a) shows the measurement results of the voltage of the device of comparative example 1-2, and Fig. 7(b) shows the measurement results of the current of the device of comparative example 1-2.
[Fig. 8]

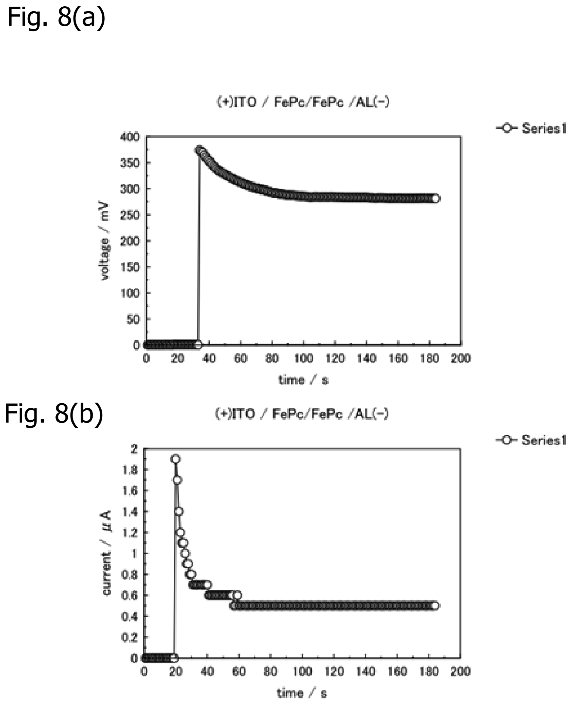

   Fig. 8(a) shows the measurement results of the voltage of the device of example 1-1, and Fig. 8(b) shows the measurement results of the current of the device of example 1-1.
[Fig. 9]

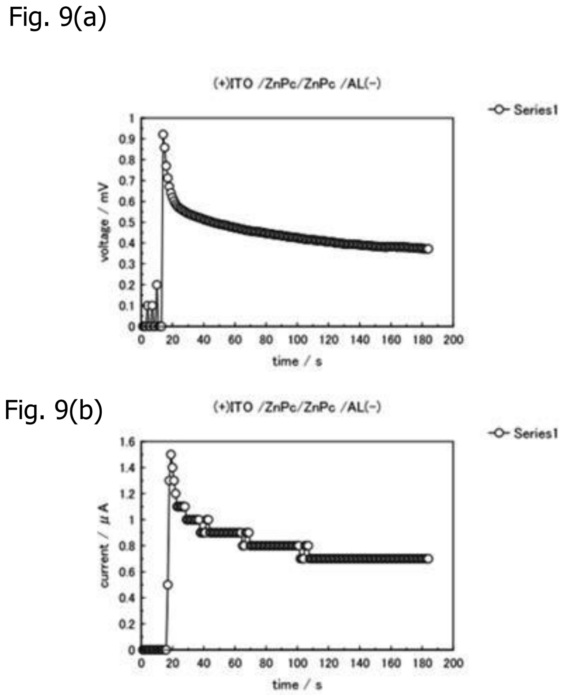

   Fig. 9(a) shows the measurement results of the voltage of the device of example 1-2, and Fig. 9(b) shows the measurement results of the current of the device of example 1-2.
[Fig. 10]

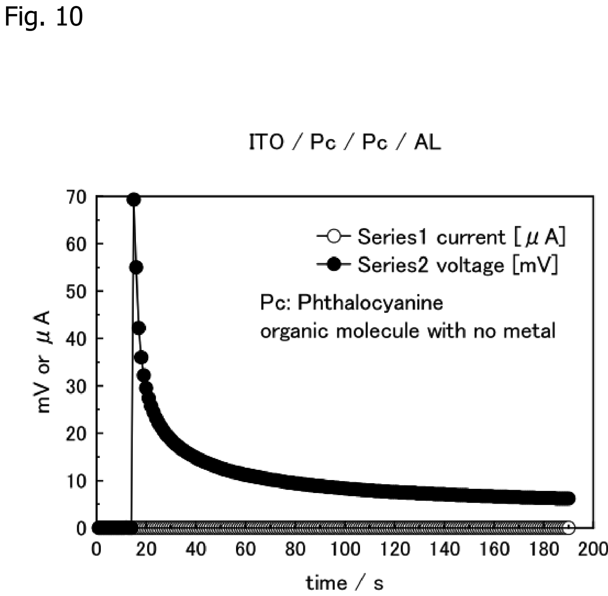

   Fig. 10 shows the measurement results of the current and the voltage of the device of comparative example 1-3.
[Fig. 11]

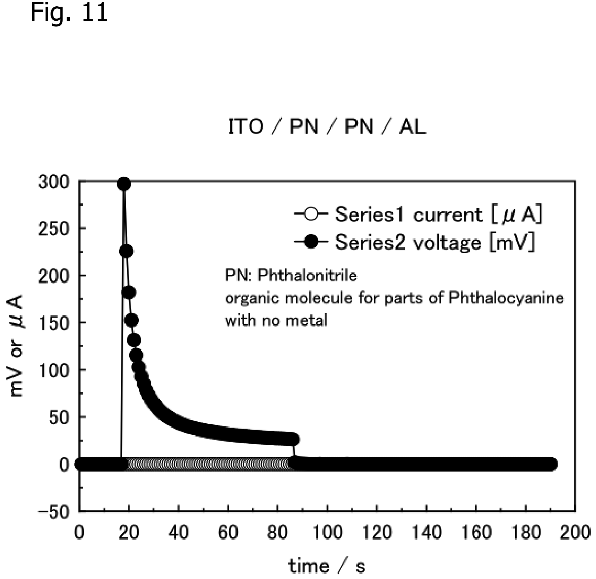

   Fig. 11 shows the measurement results of the current and the voltage of the device of comparative example 1-4.
[Fig. 12]

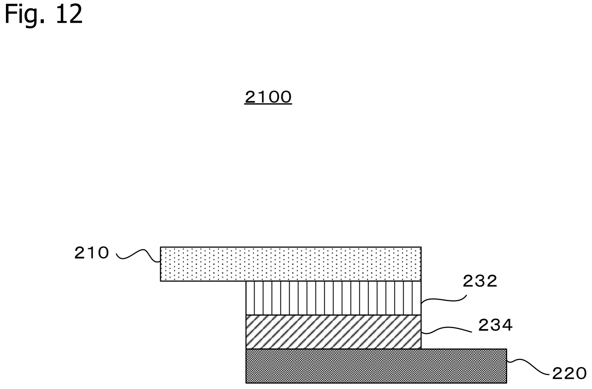

   Fig. 12 is a schematic view of a thermoelectric conversion device of the present invention according to the second embodiment.
[Fig. 13]

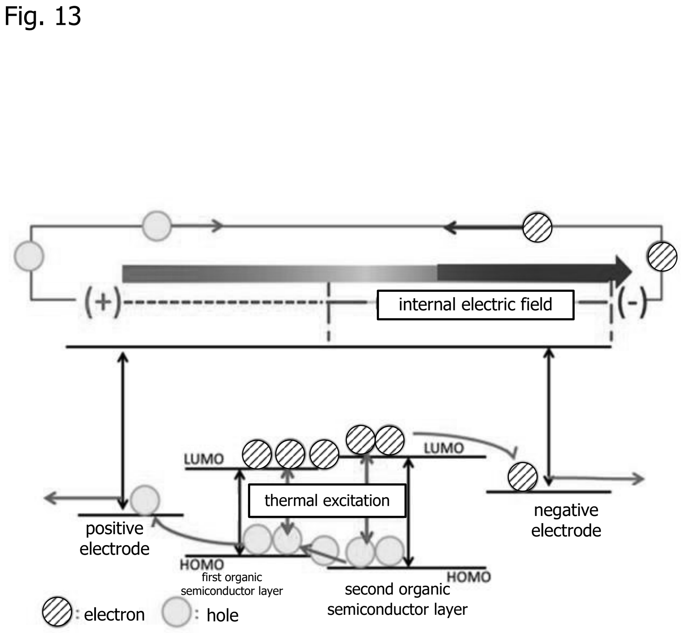

   Fig. 13 shows a model for theoretically illustrating the thermoelectric conversion device of the present invention according to the second embodiment.
[Fig. 14]

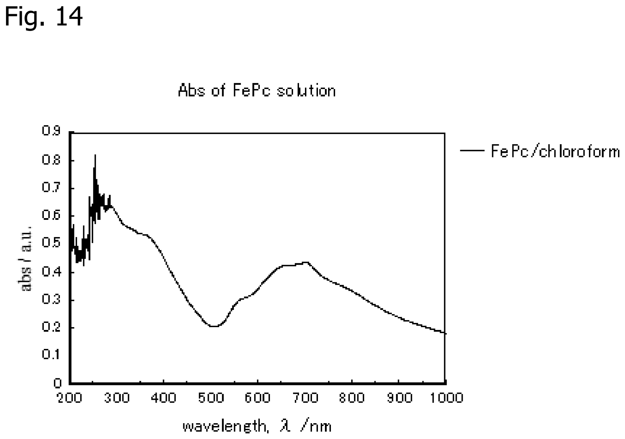

   Fig. 14 shows the light absorption spectrum measured concerning iron phthalocyanine (FePc).
[Fig. 15]

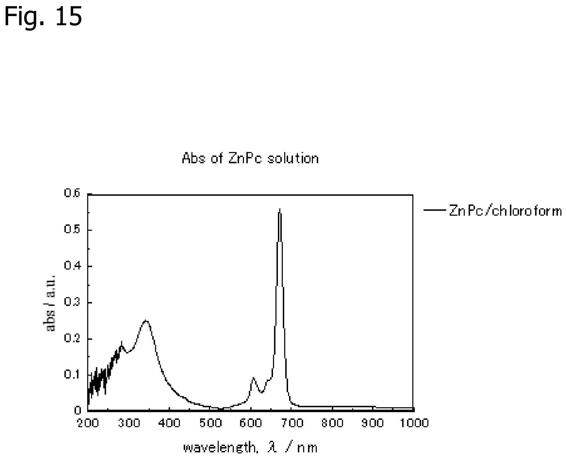

   Fig. 15 shows the light absorption spectrum measured concerning zinc phthalocyanine (ZnPc).
[Fig. 16]

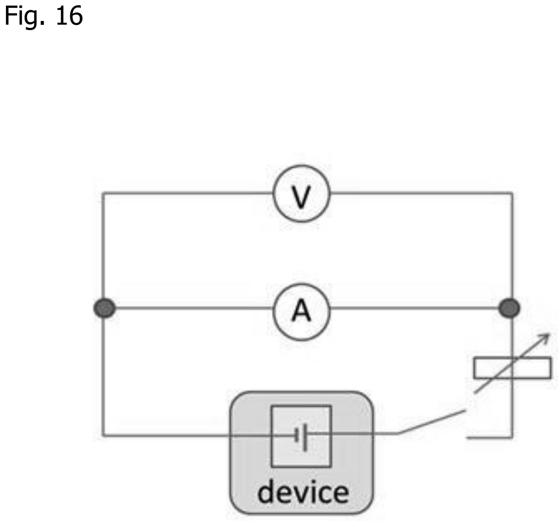

   Fig. 16 shows a circuit assembled for measuring electrical energy concerning the devices prepared in examples and comparative examples.
[Fig. 17]

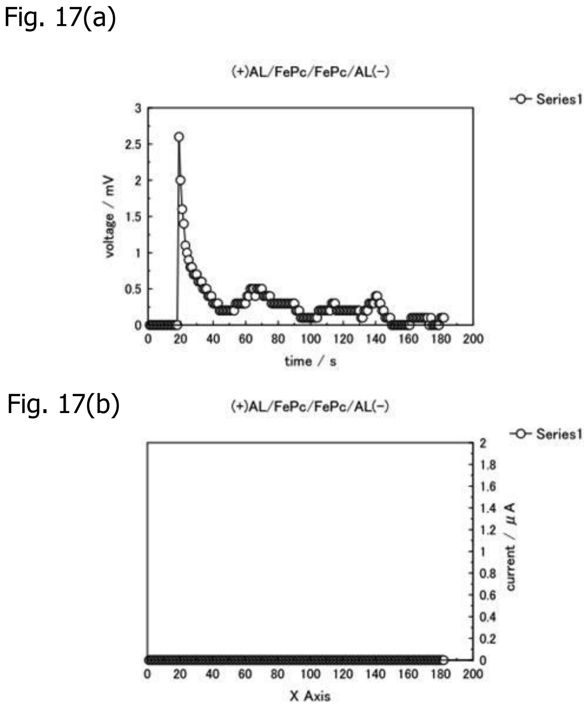

   Fig. 17(a) shows the measurement results of the voltage of the device of comparative example 2-1, and Fig. 17(b) shows the measurement results of the current of the device of comparative example 2-1.
[Fig. 18]

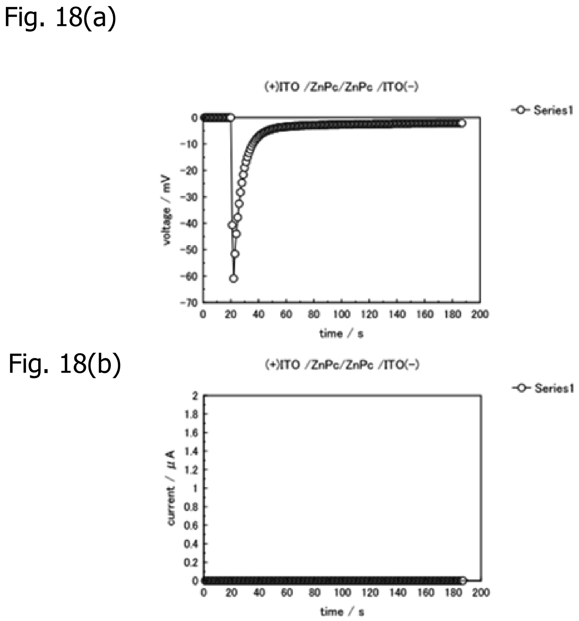

   Fig. 18(a) shows the measurement results of the voltage of the device of comparative example 2-2, and Fig. 18(b) shows the measurement results of the current of the device of comparative example 2-2.
[Fig. 19]

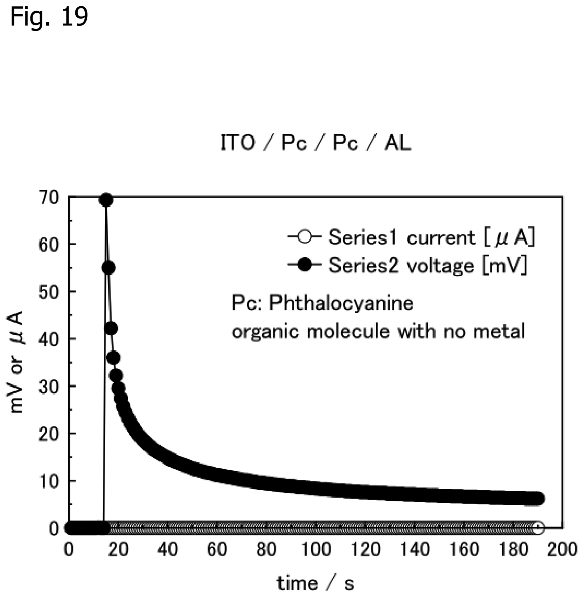

   Fig. 19 shows the measurement results of the current and the voltage of the device of comparative example 2-3.
[Fig. 20]

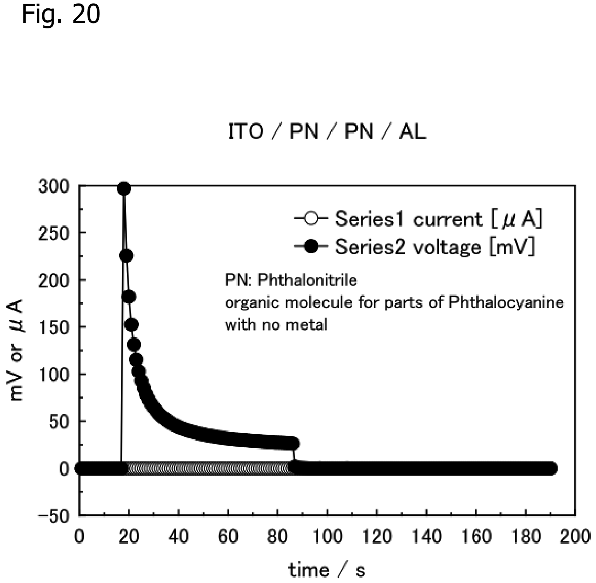

   Fig. 20 shows the measurement results of the current and the voltage of the device of comparative example 2-4.
[Fig. 21]

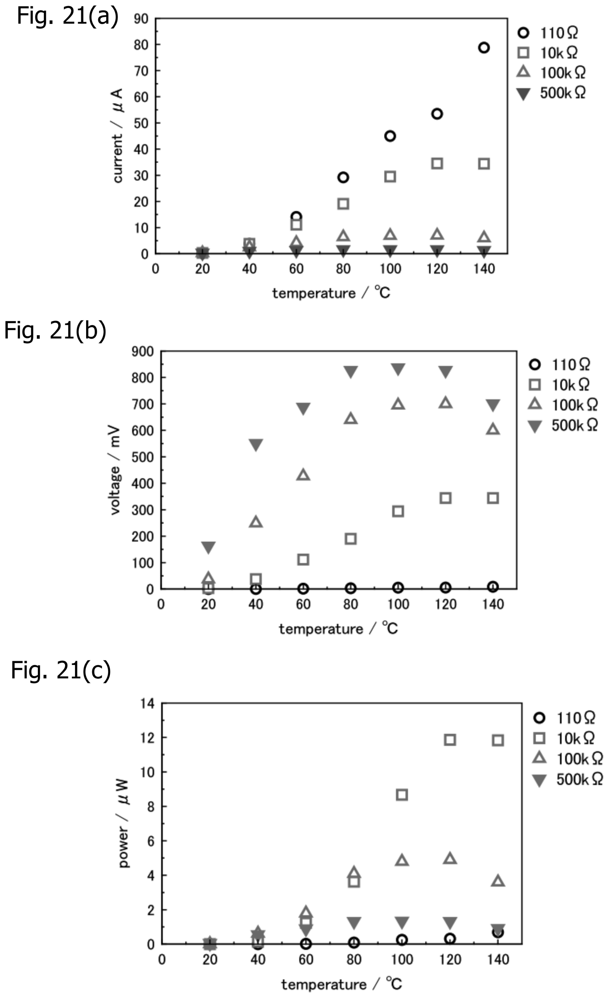

   Fig. 21(a) shows the measurement results of the current value to the temperature in example 2-1, Fig. 21(b) shows the measurement results of the voltage value to the temperature in example 2-1, and Fig. 21(c) shows the measurement results of the electric power value to the temperature in example 2-1.
[Fig. 22]

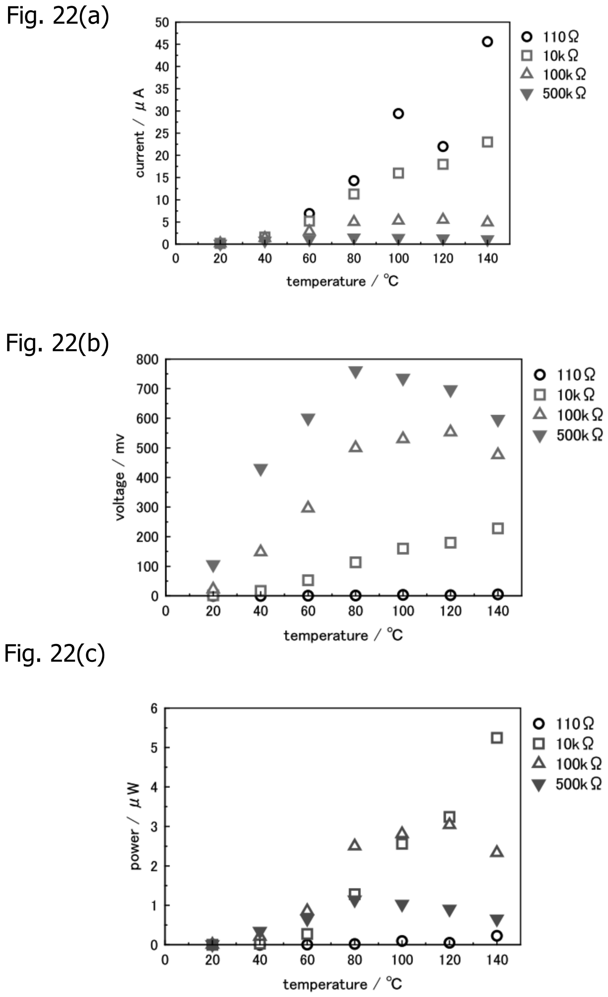

   Fig. 22(a) shows the measurement results of the current value to the temperature in comparative example 2-5, Fig. 22(b) shows the measurement results of the voltage value to the temperature in comparative example 2-5, and Fig. 22(c) shows the measurement results of the electric power value to the temperature in comparative example 2-5.
[Fig. 23]

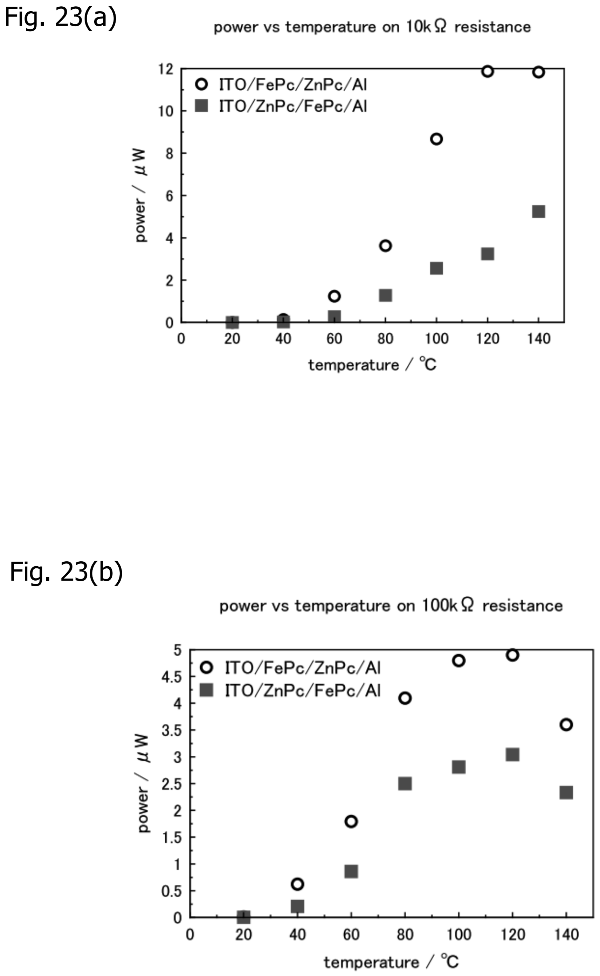

   Fig. 23(a) shows the comparison of electric power between the thermoelectric conversion device of example 2-1 and that of comparative example 2-5 when the resistance was 10 kΩ, where especially a large electric power was calculated, and Fig. 23(b) shows the same comparison when the resistance was 100 kΩ, where especially a large electric power was calculated.
[Fig. 24]

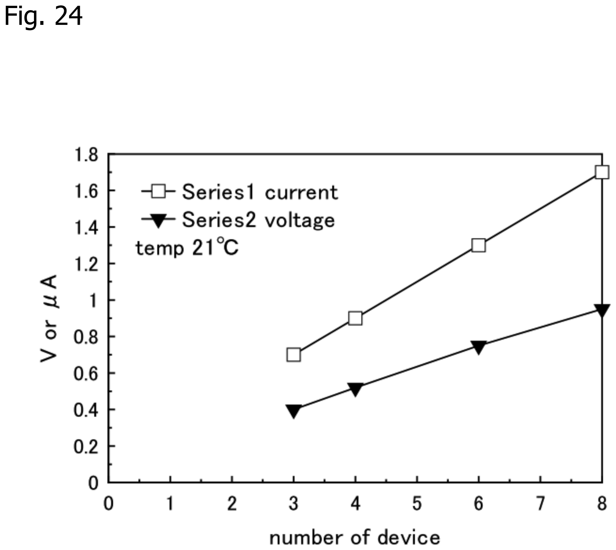

   Fig. 24 shows the current value changes and the voltage value changes when a plurality of the thermoelectric conversion devices of example 2-1 were connected.
[Fig. 25]

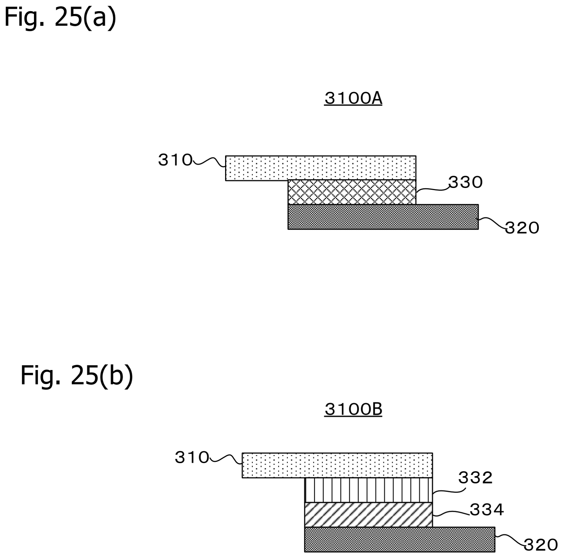

   Figs. 25(a) and 25(b) are schematic views of thermoelectric conversion devices of the present invention according to the third embodiment.
[Fig. 26]

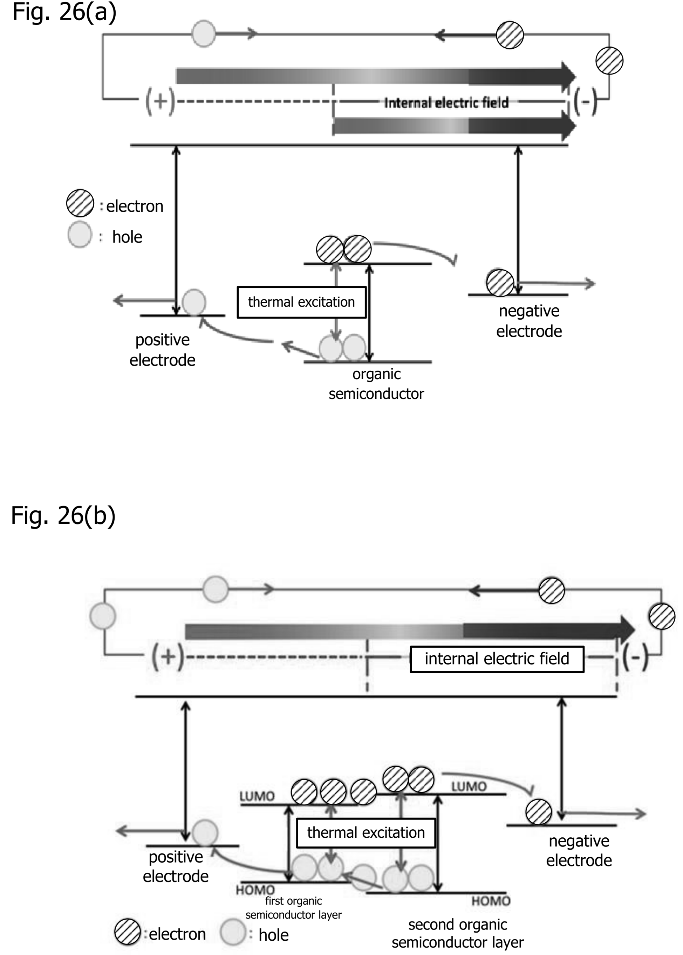

   Fig. 26(a) and 26(b) show models for theoretically illustrating the thermoelectric conversion devices of the present invention according to the third embodiment.
[Fig. 27]

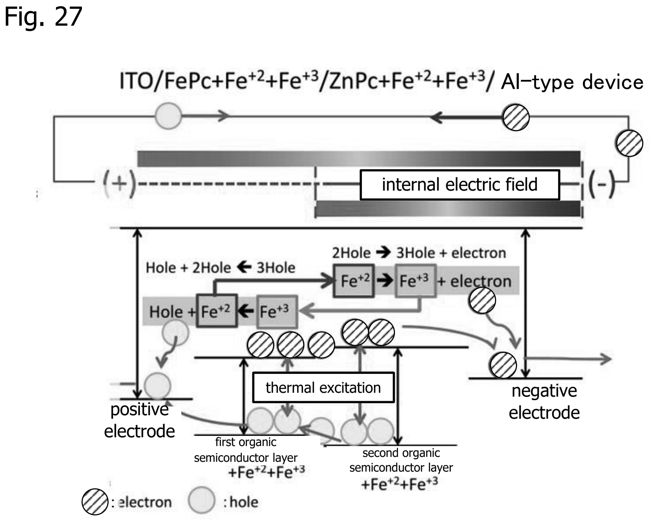

   Fig. 27 shows a model for theoretically illustrating electromotive force improvement by addition of transition metal ions.
[Fig. 28]

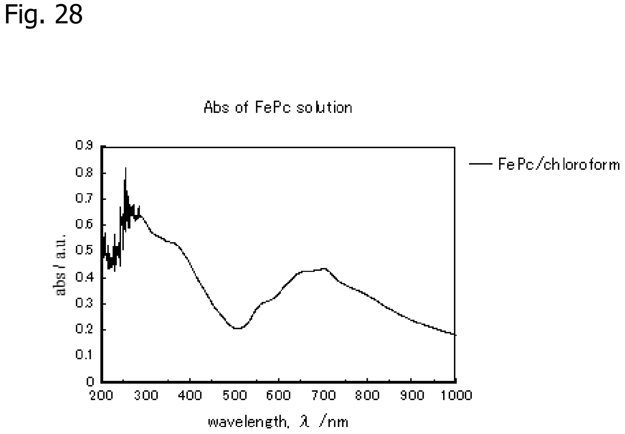

   Fig. 28 shows the light absorption spectrum measured concerning iron phthalocyanine (FePc).
[Fig. 29]

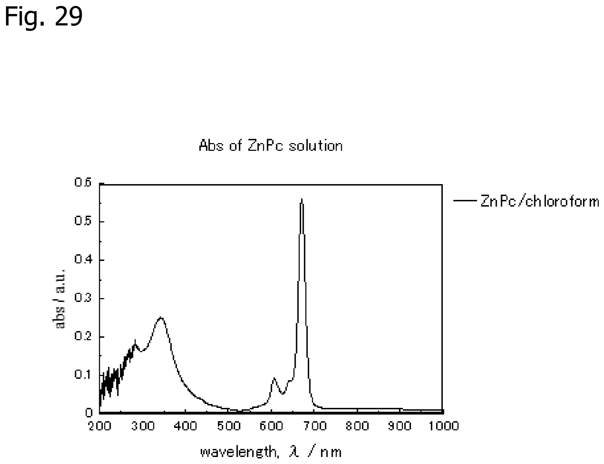

   Fig. 29 shows the light absorption spectrum measured concerning zinc phthalocyanine (ZnPc).
[Fig. 30]

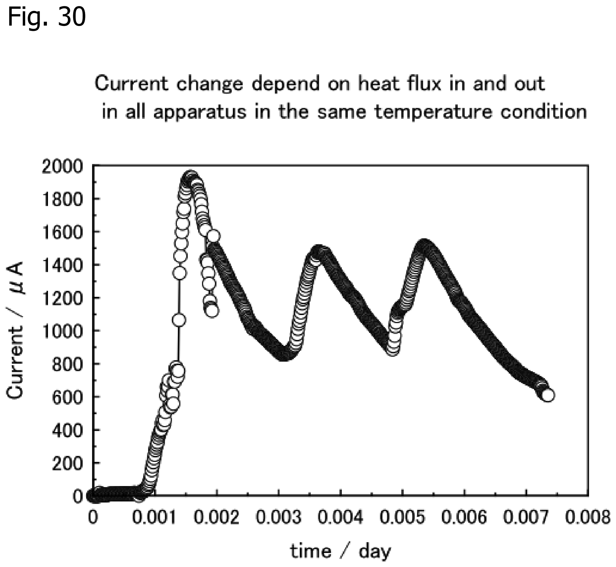

   Fig. 30 shows the measurement results of the current value of the device prepared in example 3-1 when a temperature rise was begun and ceased repeatedly.
[Fig. 31]

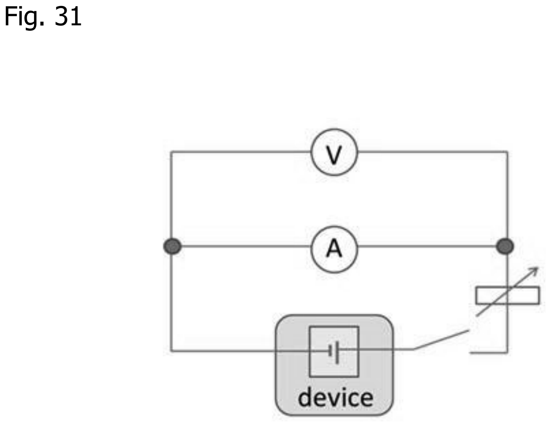

   Fig. 31 shows a circuit assembled for measuring electrical energy concerning the devices prepared in comparative examples.
[Fig. 32]

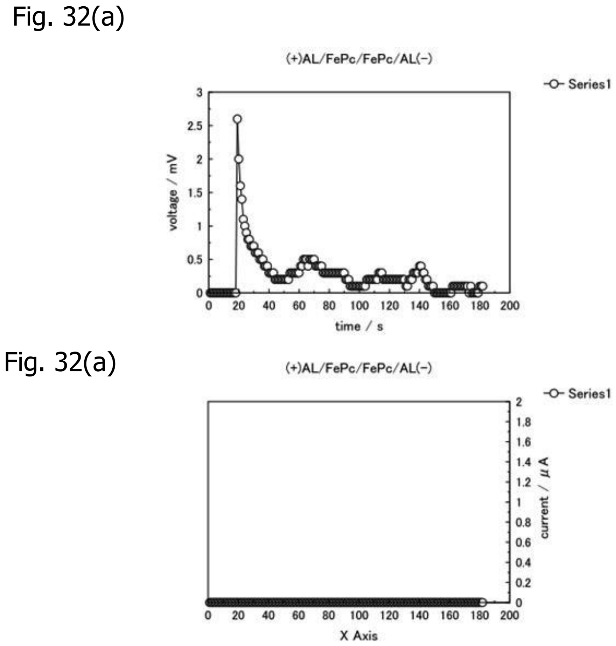

   Fig. 32(a) shows the measurement results of the voltage of the device of comparative example 3-1, and Fig. 32(b) shows the measurement results of the current of the device of comparative example 3-1.
[Fig. 33]

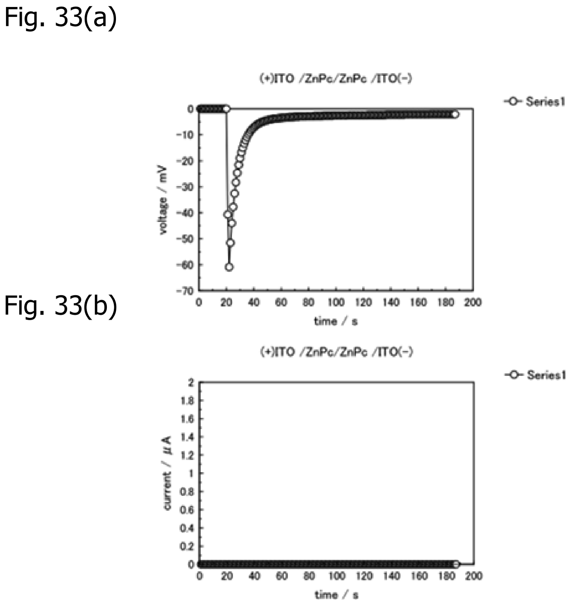

   Fig. 33(a) shows the measurement results of the voltage of the device of comparative example 3-2, and Fig. 33(b) shows the measurement results of the current of the device of comparative example 3-2.
[Fig. 34]

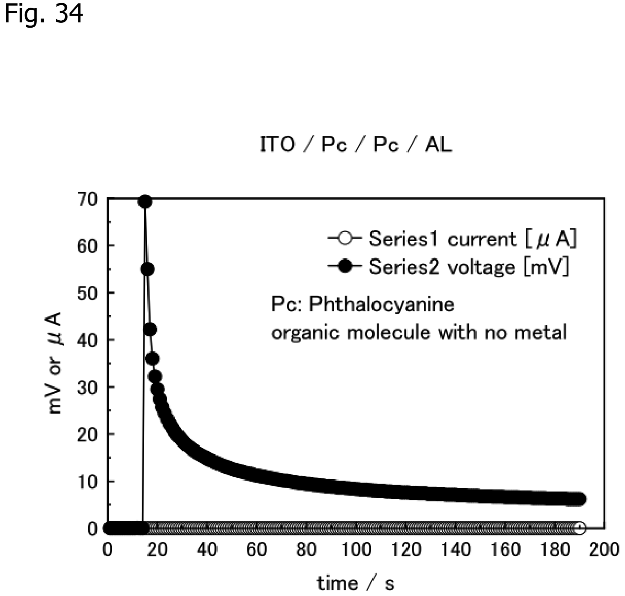

   Fig. 34 shows the measurement results of the current and the voltage of the device of comparative example 3-3.
[Fig. 35]

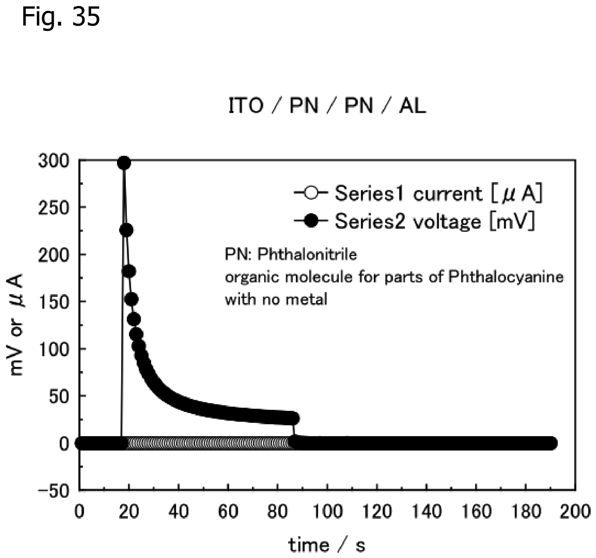

   Fig. 35 shows the measurement results of the current and the voltage of the device of comparative example 3-4.
[Fig. 36]

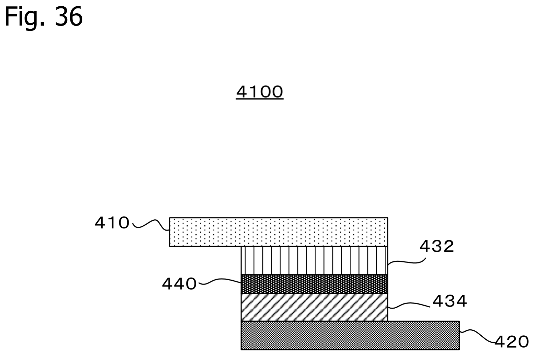

   Fig. 36 is a schematic view of a thermoelectric conversion device of the present invention according to the fourth embodiment.
[Fig. 37]

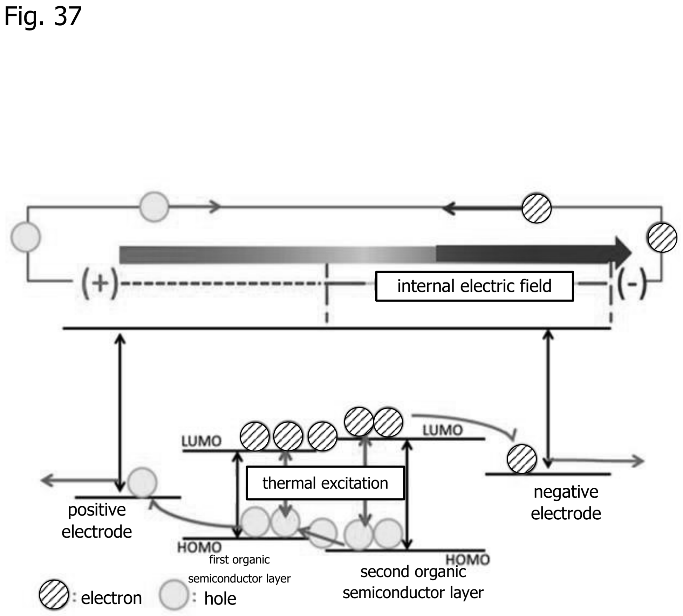

   Fig. 37 shows a model for theoretically illustrating the thermoelectric conversion device of the present invention according to the fourth embodiment.
[Fig. 38]

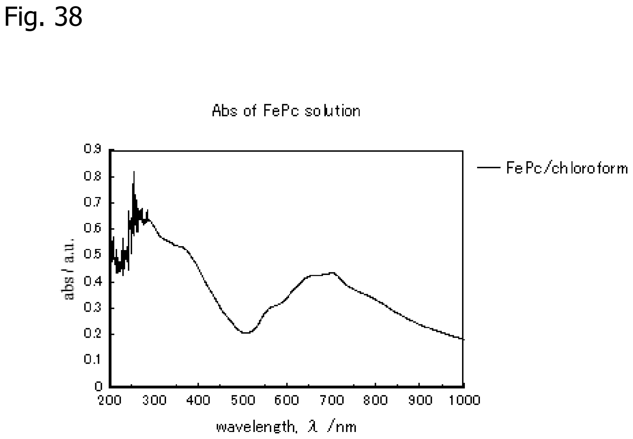

   Fig. 38 shows the light absorption spectrum measured concerning iron phthalocyanine (FePc).
[Fig. 39]

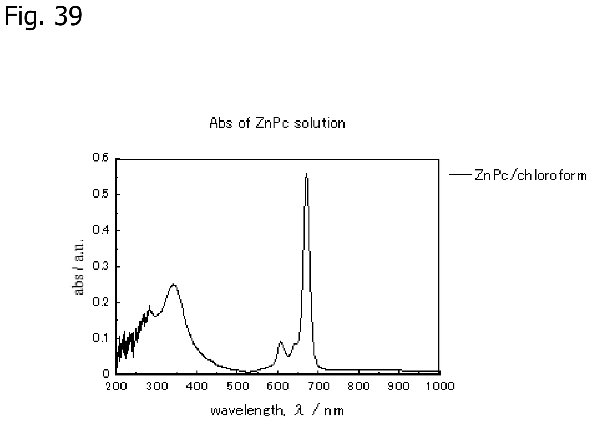

   Fig. 39 shows the light absorption spectrum measured concerning zinc phthalocyanine (ZnPc).
[Fig. 40]

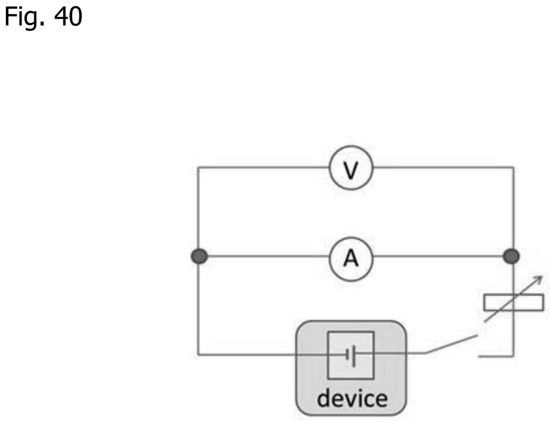

   Fig. 40 shows a circuit assembled for measuring electrical energy concerning the devices prepared in examples and comparative examples.
[Fig. 41]

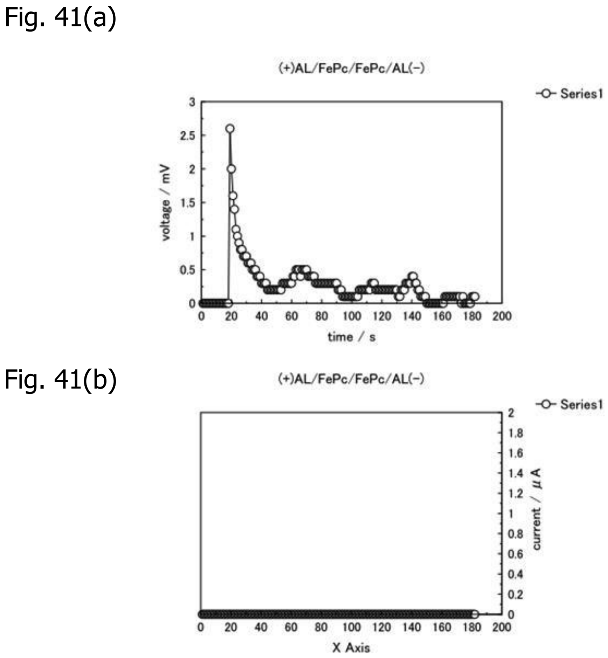

   Fig. 41(a) shows the measurement results of the voltage of the device of comparative example 4-1, and Fig. 41(b) shows the measurement results of the current of the device of comparative example 4-1.
[Fig. 42]

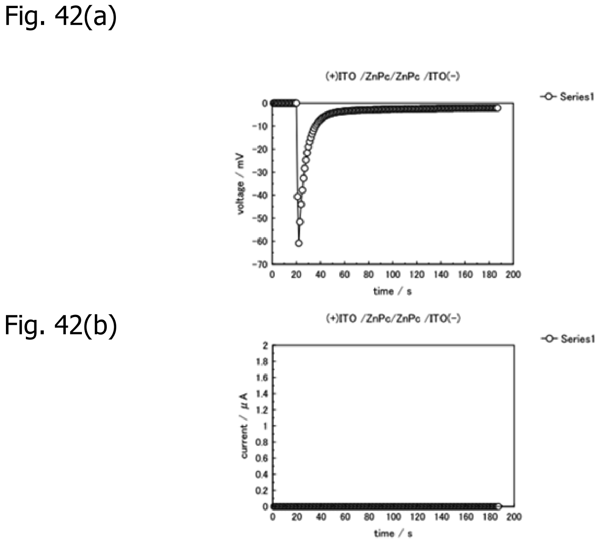

   Fig. 42(a) shows the measurement results of the voltage of the device of comparative example 4-2, and Fig. 42(b) shows the measurement results of the current of the device of comparative example 4-2.
[Fig. 43]

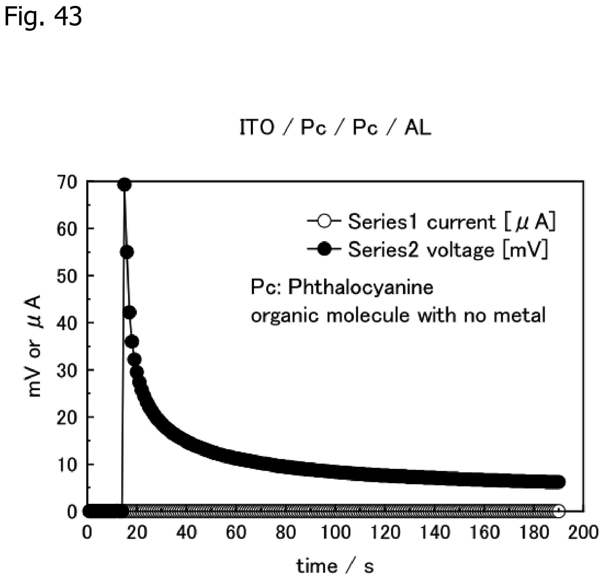

   Fig. 43 shows the measurement results of the current and the voltage of the device of comparative example 4-3.
[Fig. 44]

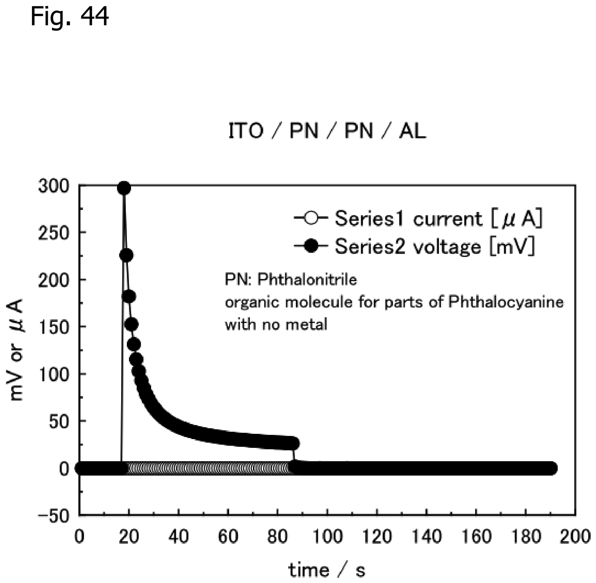

   Fig. 44 shows the measurement results of the current and the voltage of the device of comparative example 4-4.
[Fig. 45]

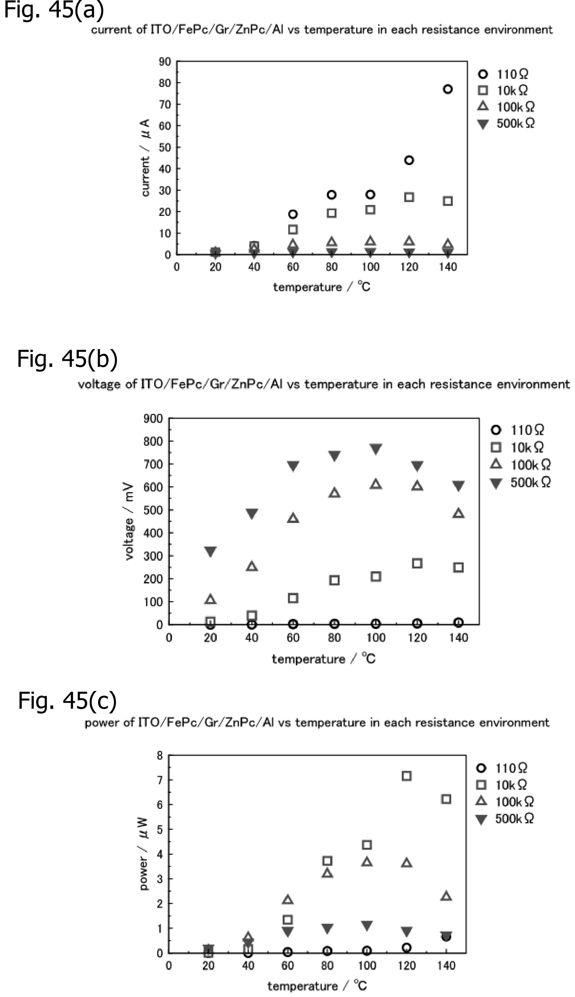

   Fig. 45(a) shows the measurement results of the current value to the temperature in example 4-1, Fig. 45(b) shows the measurement results of the voltage value to the temperature in example 4-1, and Fig. 45(c) shows the measurement results of the electric power value to the temperature in example 4-1.
[Fig. 46]

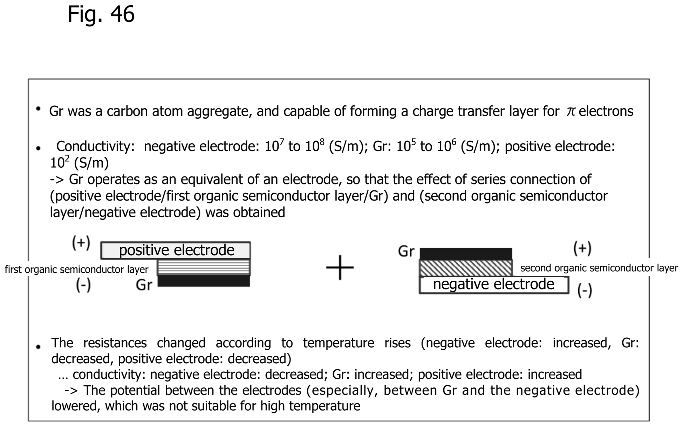

   Fig. 46 illustrates that improvement in performance of circuits of a smaller resistance was observed at around 20°C to 60°C by graphite insertion.
[Fig. 47]

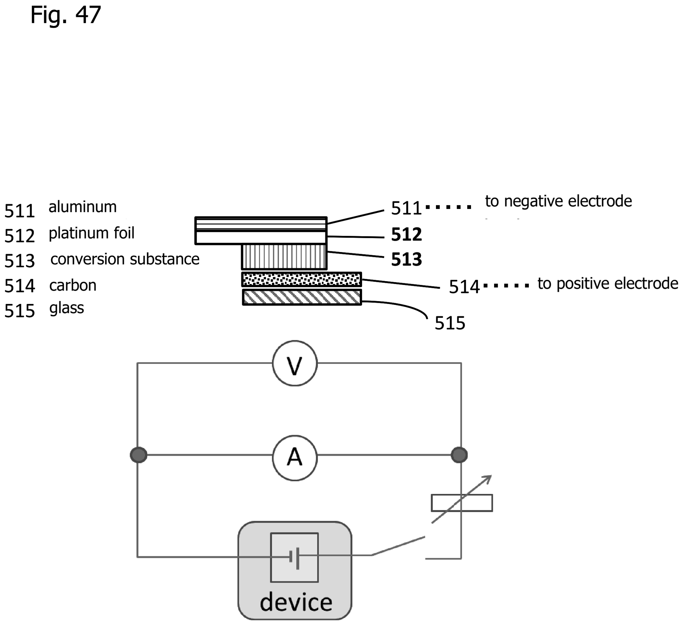

   Fig. 47 is a schematic view showing a way of an experiment for proving that the thermoelectric conversion method of the present invention is not a phenomenon by ionization energy.
[Fig. 48]

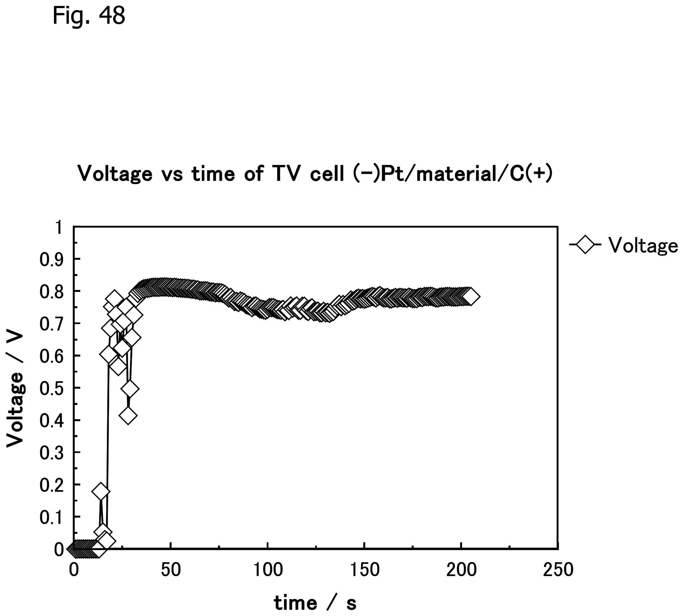

   Fig. 48 shows the voltage measurement results of the foregoing experiment.
[Fig. 49]

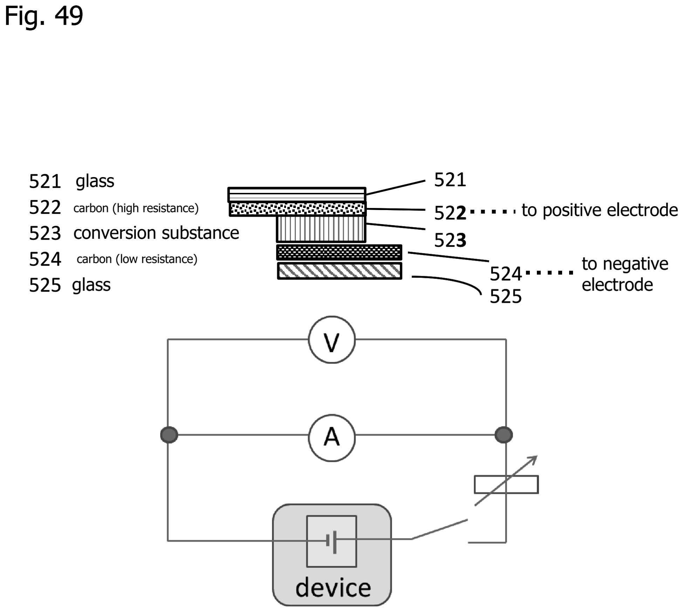

   Fig. 49 is a schematic view showing a way of an experiment for proving that the thermoelectric conversion method of the present invention is not a phenomenon following chemical reaction.
[Fig. 50]

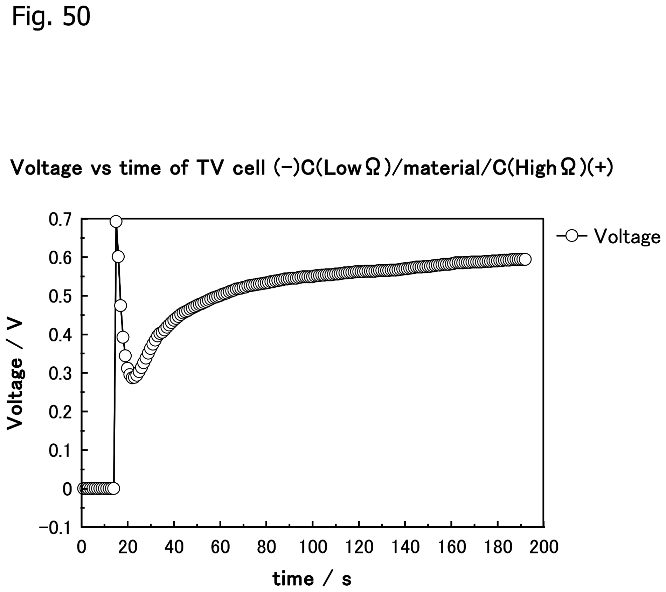

   Fig. 50 shows the voltage measurement results of the foregoing experiment.
[Fig. 51]

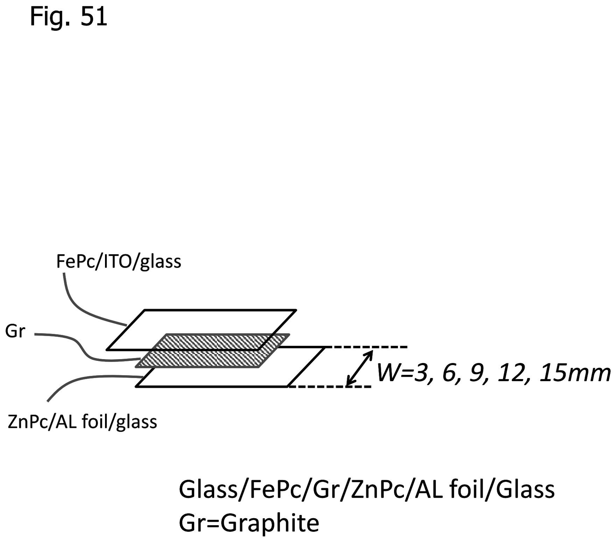

   Fig. 51 is a schematic view showing a way of an experiment about thinning of a negative electrode of a device, and a charge transfer phenomenon based on the correlation between the area and the electricity generating amount.
[Fig. 52]

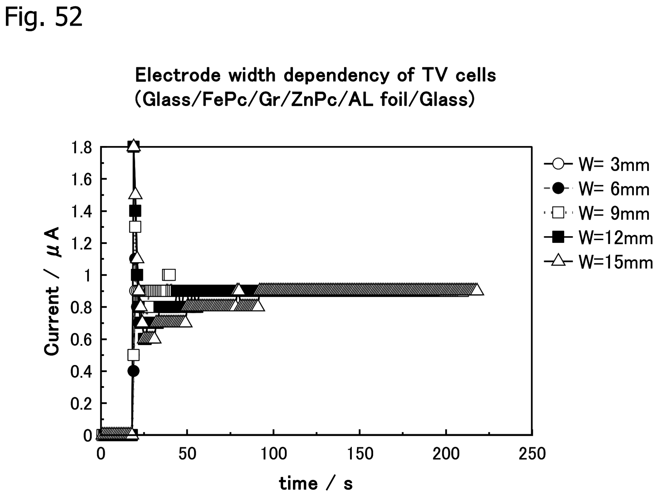

   Fig. 52 shows the current measurement results of the foregoing experiment.
[Fig. 53]
   Fig. 53 shows the current measurement results of the foregoing experiment (enlarged view).
[Fig. 54] Fig. 54 is a schematic view of devices used in an experiment showing a series connection effect by stacking the devices.
[Fig. 55]

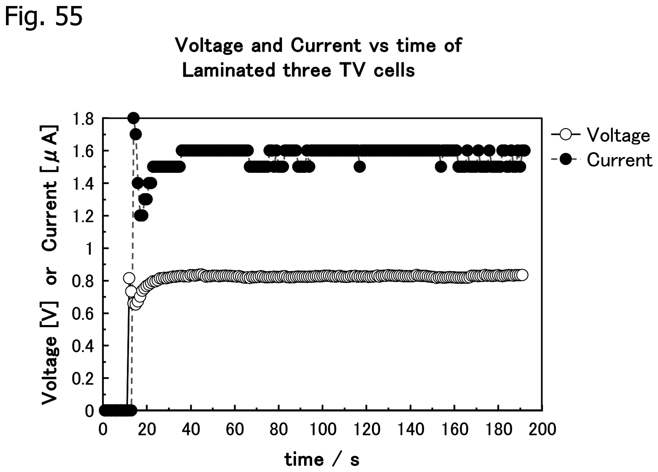

   Fig. 55 shows the voltage and current measurement results of the foregoing experiment.
[Fig. 56]

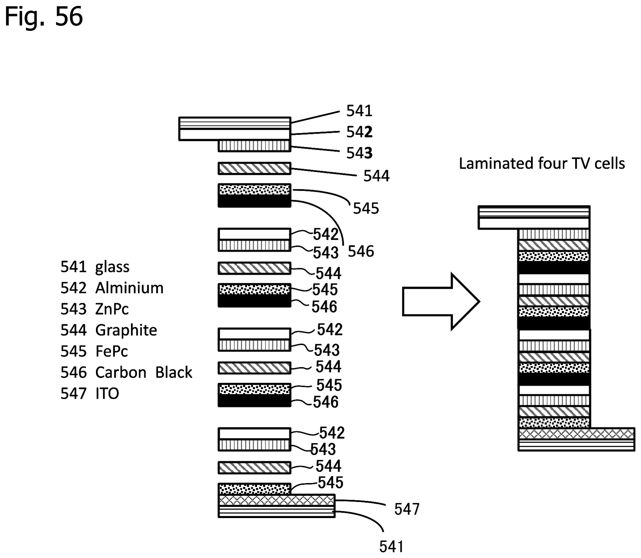

   Fig. 56 is a schematic view of devices used in an experiment showing a series connection effect by stacking the devices.
[Fig. 57]

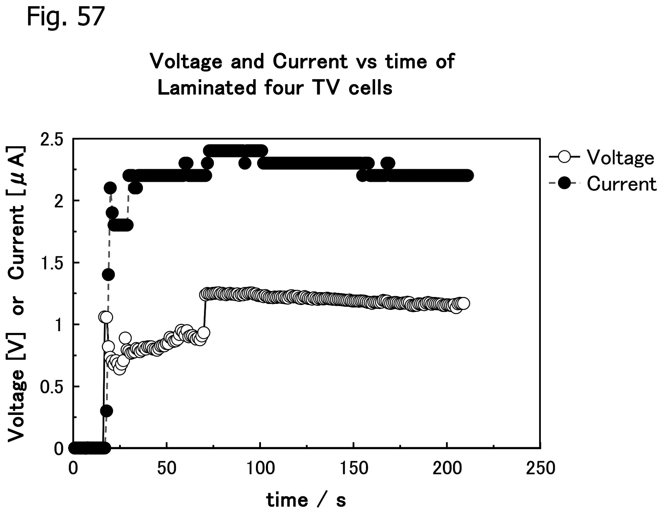

   Fig. 57 shows the voltage and current measurement results of the foregoing experiment.
[Fig. 58]

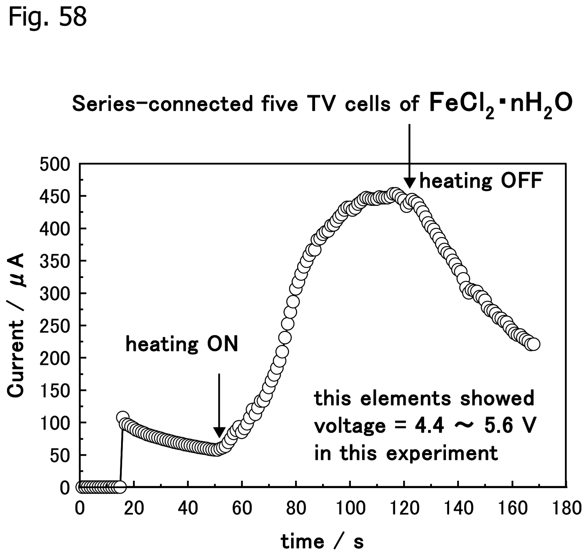

   Fig. 58 shows the current changes measured when five devices obtained by forming the thermoelectric conversion devices the third embodiment were connected in series.
[Fig. 59]

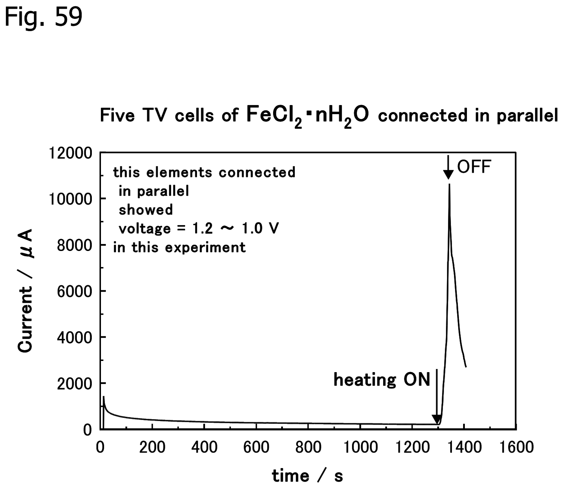

   Fig. 59 shows the current changes measured when five devices obtained by forming the thermoelectric conversion devices of the third embodiment were connected in parallel.
[Fig. 60]

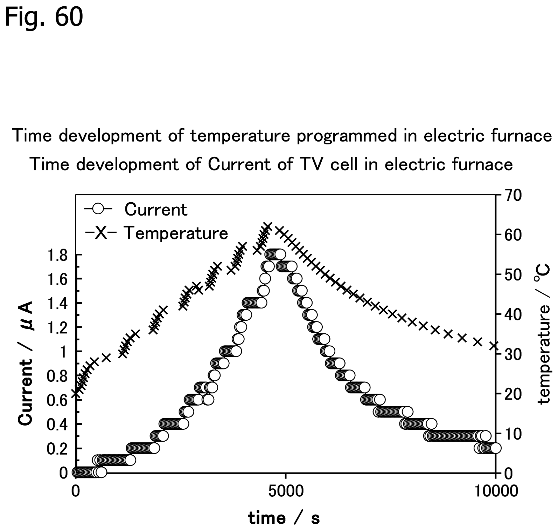

   Fig. 60 shows the results of the following measurement: the temperature in an electric furnace was changed using a program, a device was disposed in the furnace, and the current was measured with an ammeter and a voltmeter.
[Fig. 61]

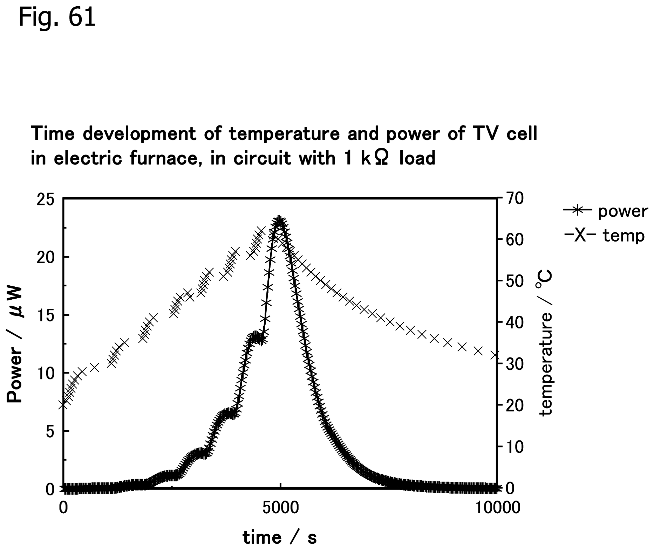

   Fig. 61 shows the measurement results when a device that generated a larger current was used.
[Fig. 62]

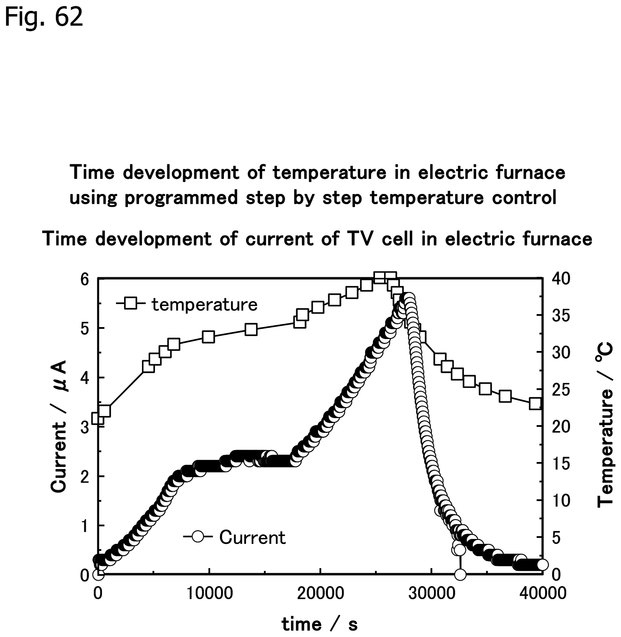

   Fig. 62 shows the measurement results of the current generated from a device under the conditions where temperature change was programed, so that there were the time period when the temperature gradually rose step by step, and the time period when the temperature suddenly rose.
[Fig. 63]

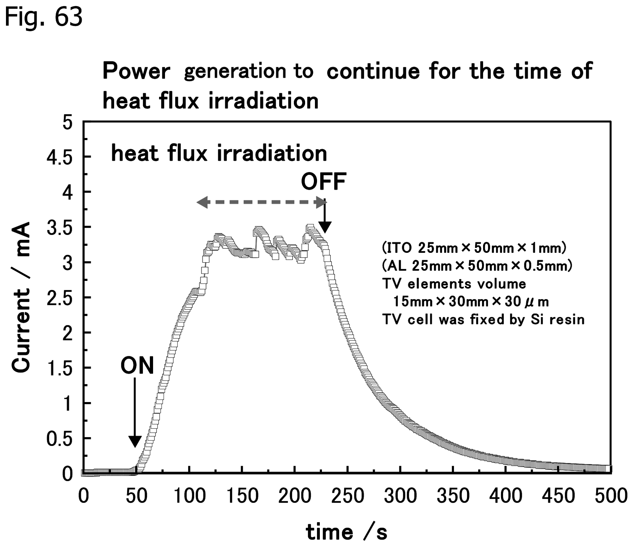

   Fig. 63 shows the results of an experiment in which the measurement when the electricity generating amount of the thermoelectric conversion device of the present invention approaches the upper limit was tried.
[Fig. 64]

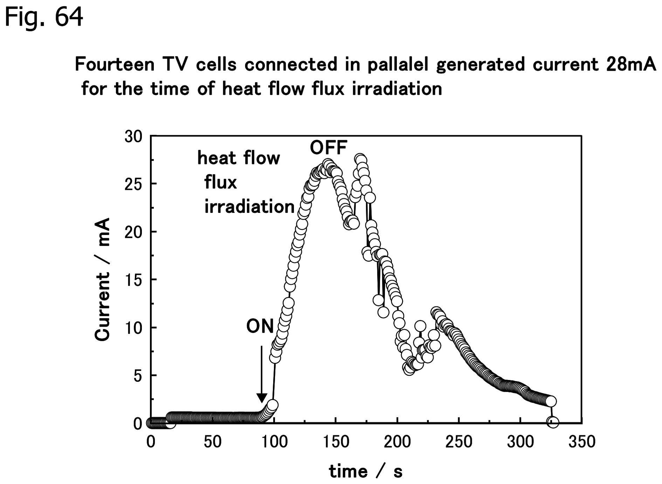

   Fig. 64 shows the results showing the potential of the thermoelectric conversion device of the present invention for scaleups.
[Fig. 65]

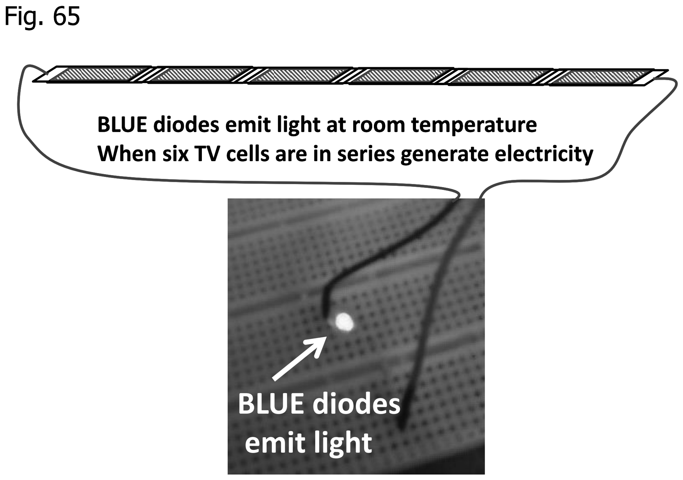

   Fig. 65 shows the electricity generating effect around room temperature.
[Fig. 66]

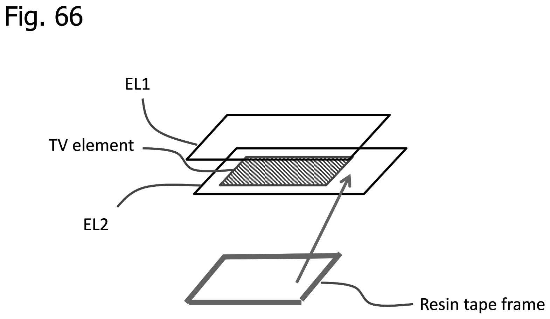

   Fig. 66 is a schematic view showing a way of an experiment about device sealing ranks, and device durability.
[Fig. 67]

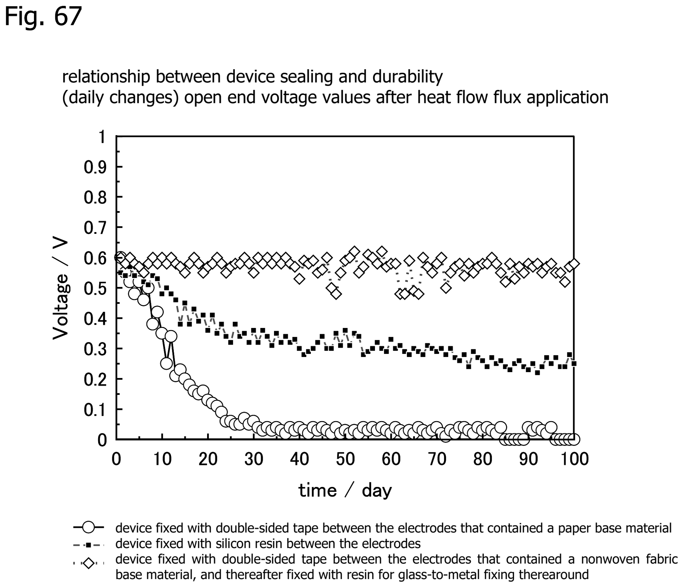

   Fig. 67 shows the open end voltage values (daily changes) after a heat flow flux was applied in the foregoing experiment.

### [Description of Embodiments]

### [First Embodiment]

### <Thermoelectric Conversion Device (First Embodiment)>

As shown in the schematic view of Fig. 1, a thermoelectric conversion device 1100 according to the present invention is provided with a positive electrode 110 and a negative electrode 120 that are made from materials having different conductivities, and an organic semiconductor layer 130 between the positive electrode 110 and the negative electrode 120. The organic semiconductor layer contains a material that generates electrons and holes by thermal excitation.

### (Positive Electrode and Negative Electrode Made from Materials of Different Conductivities)

The thermoelectric conversion device of the present invention uses the positive electrode and the negative electrode, which are made from materials of different conductivities. Because of this, an internal electric field is generated in the inside between the electrodes, and the electrons and the holes, which are charge carriers generated by thermal excitation in the organic semiconductor layer, move to the negative electrode and the positive electrode, respectively, by the internal electric field, which causes electromotive force to be generated.

As the foregoing, the thermoelectric conversion device of the present invention generates electromotive force even when the positive electrode and the negative electrode are in the same temperature environment, and is based on a theory different from the conventional Seebeck effect.

Showing a model in Fig. 2, the thermoelectric conversion device of the present invention will be theoretically illustrated.

The most underlying phenomenon is that the two electrode materials of different conductivities generate an internal electric field in the inside between the electrodes. Direct joining of two different electrode materials is a known thermocouple technique, that is, a Seebeck device structure.

However, according to the present invention, the device provided with the negative electrode of a higher conductivity, the positive electrode of a lower conductivity, and the organic semiconductor layer containing a material that emits electrons and holes by thermal excitation and sandwiched between the electrodes is prepared without two different electrode materials joined whereby the present invention succeeded in generating a large internal electric field.

It was proved that the electromotive force obtained in the foregoing way is hundred thousand times to million times as great as the electromotive force by a thermocouple, and the structure of moving to polarize the charge carriers causes the heat flow having entered from the outside to easily move the electrons to the negative electrode and the holes to the positive electrode, which brings a method capable of generating a great electromotive force.

Described based on Fig. 2, the energy levels of the positive electrode and the negative electrode in the drawing are the Fermi levels. Organic semiconductors include the lowest unoccupied molecular orbital (LUMO) and the highest occupied molecular orbital (HOMO) in descending order of energy level. It is noted that when the energy level in organic semiconductors is discussed, it is permitted to compare the band gap between the LUMO and the HOMO with the energy level of any inorganic substance.

In the thermoelectric conversion device of the present invention, the organic semiconductor receives heat energy therearound, which leads to thermal excitation, and the electrons emitted from this organic semiconductor move. Specifically, charge separation created in the organic semiconductor generates carriers (electrons and holes), and these carriers move inside the device and around external circuits according to the energy levels of the substances. That is, the electrons in the LUMO of the organic semiconductor obtain energy that is higher than the Fermi level of the negative electrode and move to the conduction band; and at the same time, the holes in the HOMO of the organic semiconductor obtain energy that is higher than the Fermi level of the positive electrode and move to the conduction band. Such movement of the carriers generates electromotive force.

As described above, according to the thermoelectric conversion device of the present invention, electromotive force can be obtained even when the negative electrode and the positive electrode are present at the same temperature. In the electromotive force generating phenomenon by thermocouples, the temperature difference between the reference point in the measurement system, and the contact point with a heat flow is reflected. However, according to the present invention, the results equivalent to those when electromotive force and electricity generating amount measurements are performed under the condition where the device alone is brought into contact with a heat flow can be obtained when measurement is performed under the conditions where all of copper wires, measuring instruments, and the device in the measurement system are put in the same temperature environment and a heat flow is provided. This means that in the thermoelectric conversion device of the present invention, the thermally excited electrons and holes function as devices having diode characteristics, showing behaviors equivalent to electrons and holes optically excited inside photocells generated by photoelectric conversion, and generate electromotive force. This is a novel point underlyingly different from the conventional Seebeck device.

In the materials of different conductivities, the electrode made from a material of a lower conductivity, which has a high hole density, is the positive electrode, and the electrode made from a material of a higher conductivity, which has a high electron density, is the positive electrode. Here, a higher conductivity and a lower conductivity are determined by comparing the material constituting the positive electrode and the material constituting the negative electrode.

The bigger the difference between the positive electrode 110 and the negative electrode 120 in conductivity is, the larger the internal electric field generated between the electrodes is. Thus, the lower limit of the difference between the positive electrode 110 and the negative electrode 120 in conductivity is preferably at least 50 S/m, and more preferably at least 100 S/m. Too big a difference in conductivity however causes the electrodes themselves to begin to show a resistance function, which not only causes energy loss, but also leads to deteriorated performance such as a lowered speed of thermoelectric conversion. The upper limit of this difference is not particularly limited, and in view of selectable materials, is normally preferably at most 10,000 S/m, and more preferably at most 1,000 S/m.

The conductivity of the negative electrode 120, which has a higher conductivity, is preferably 1×10⁷ to 1×10⁸ S/m. The conductivity of the positive electrode 110, which has a lower conductivity, is preferably 1×10³ to 1×10⁵ S/m.

Examples of the materials constituting the electrodes include metals, conductive organic substances, carbon materials such as amorphous carbon, ceramics, and amorphous metals. Examples of the material constituting the positive electrode 10 include tin doped indium oxide (ITO) that is an oxide of indium and tin, carbonaceous substances, and carbon black. Examples of the material constituting the negative electrode 20 include metallic materials such as aluminum, gold, silver, platinum, and copper.

In the thermoelectric conversion device of the present invention, it is important to generate an internal electric field between the electrodes. Various conductive materials may be selected as appropriate and applied as long as a desired internal electric field can be generated. For example, the same conductive material may be used for both the positive electrode and the negative electrode. As an example, pencils obtained by blending carbon and clay have different conductivities according to the blending ratio. An electrode obtained by penciling with a highly conductive pencil can be used as the negative electrode, and an electrode obtained by penciling with a low conductive pencil can be used as the positive electrode.

### (Organic Semiconductor Layer)

A layer made from any of various materials may be used as the organic semiconductor layer as long as provided with the functions of generating electrons and holes by thermal excitation, and of transferring the generated electrons and holes to the electrodes, respectively. For example, examples of the material that generates electrons and holes by thermal excitation include organic semiconductors.

Examples of organic semiconductors as used herein include organic charge transfer complexes such as a complex of phthalocyanine and any of various transition metals, and more specifically, include: magnetic metal-containing organic complex compounds such as iron phthalocyanine (FePc), nickel phthalocyanine (NiPc), manganese phthalocyanine (MnPc), cobalt phthalocyanine (CoPc), iron porphyrin complexes, nickel porphyrin complexes, manganese porphyrin complexes, and cobalt porphyrin complexes; and diamagnetic metal-containing organic complex compounds such as copper phthalocyanine (CuPc), zinc phthalocyanine (ZnPc), copper porphyrin complexes, and zinc porphyrin complexes.

The organic semiconductor layer preferably contains a medium that transfers the electrons and the holes emitted from the foregoing organic semiconductor by thermal excitation to the negative electrode and the positive electrode. For example, polyoxyethylene sorbitan monostearate or the like may be used as such a transport medium for the charge carriers.

### <Method of Producing Thermoelectric Conversion Device (First Embodiment)>

For example, the thermoelectric conversion device of the present invention can be produced by the following procedures:
1. the step of preparing a mixed solution containing the organic semiconductor;
2. the step of forming the organic semiconductor layer on the surfaces of the electrodes; and
3. the step of forming the thermoelectric conversion device.

### (Preparing Mixed Solution Containing Organic Semiconductor)

A mixed solution containing the organic semiconductor can be obtained by mixing and, if necessary, stirring the organic semiconductor, the transport medium for the charge carriers, and a solvent where the transport medium can dissolve. The solvent amount can be appropriately adjusted, so that the handleability (applicability) of the solution is excellent. No solvent may be added as long as there is no problem about the applicability. The solvent is not particularly limited, and for example, chloroform may be used.

### (Step of Forming Organic Semiconductor Layer on Surfaces of Electrodes)

The organic semiconductor layer can be formed on the surfaces of the electrodes by applying, to the surfaces of the positive electrode and the negative electrode, and drying the mixed solution formed in the above step. The following is a preferred mode: the organic semiconductor layer of a single layer is preferably formed by applying the mixed solution to each of the surfaces of the positive electrode and the negative electrode to form organic semiconductor layers on the respective surfaces of the positive electrode and the negative electrode, and laminating, pressing, and if necessary, heating the formed organic semiconductor layers. According to this method, the adhesiveness of the positive electrode and the negative electrode to the organic semiconductor layer can be improved.

Alternatively, the device may be formed by forming the organic semiconductor layer on one of the positive electrode and the negative electrode, and laminating the resultant and the other electrode, where no organic semiconductor layer is formed. In this case, it is necessary to adjust the pressing force and the heating temperature so as to achieve the adhesiveness of the electrodes to the organic semiconductor layer when the electrodes are laminated.

### (Step of Forming Thermoelectric Conversion Device)

The thermoelectric conversion device is formed by laminating the organic semiconductor layers formed on the surfaces of the positive electrode and the negative electrode, which are obtained in the above step. Preferably, a pressing force of approximately 1,200 hPa to 1,500 hPa is applied to the positive electrode/organic semiconductor layer/organic semiconductor layer/negative electrode, which is formed by the lamination, and preferably, this state is kept for 60 minutes to 120 minutes whereby the organic semiconductor layer/organic semiconductor layer is united into one body to form the thermoelectric conversion device made of the positive electrode/organic semiconductor layer/negative electrode.

The organic semiconductor layers can be united into one body more effectively by heating in addition when laminated. Preferably, heating may be performed at a temperature in the range of 50°C to 140°C.

### <Thermoelectric Conversion Method (First Embodiment)>

According to the thermoelectric conversion method of the present invention, heat energy can be converted to electrical energy just by the step of disposing the aforementioned thermoelectric conversion device in the presence of a heat energy flow that realizes a certain thermal environment. That is, conventional methods based on the Seebeck effect require making a temperature difference between the positive electrode and the negative electrode, whereas the method of the present application requires no temperature difference but the thermoelectric conversion device is just disposed in a thermal environment at a certain temperature in the presence of a heat energy flow.

A thermal environment at a certain temperature in the presence of a heat energy flow may be any environment as long as being a thermal environment so as to give the thermoelectric conversion device a certain amount of heat energy, and preferably the atmosphere at 20°C (room temperature) or higher, more preferably the atmosphere at 25°C or higher, further preferably the atmosphere at 30°C or higher, particularly preferably the atmosphere at 35°C or higher, and most preferably the atmosphere at 40°C or higher, etc. can be applied. This is the phenomenon understandable by comparison with a certain photoirradiation environment in the presence of a light energy flow in solar cells, where electrons and holes excited by light energy move inside the device, and is a physically understandable phenomenon. When the light energy flow stops, the function of generating electromotive force in the solar cells stops, whereas a decrease in inflow of a heat energy flow in the thermoelectric conversion method of the present invention corresponds to the stop of the light energy flow in the solar cells, and is understandable by comparison with deterioration of the function of generating electromotive force. It is noted that the phenomenon of generating electromotive force does not suddenly become zero since the energy distributions of the atoms and the molecules that carry the heat energy flow are not instantly into zero states, but are gradually attenuating, which is different from the stop of photoirradiation.

Even an environment in a gaseous atmosphere other than the atmosphere, for example, an environment in an inert gas such as nitrogen can be considered to be an environment that can give the thermoelectric conversion device heat energy as long as the temperature is the same as the above. Further, the environment may be in an atmosphere excluding gas, for example, may be in a liquid such as water. In view of efficiently giving thermoelectric conversion device heat energy, it is considered to be preferable to dispose the thermoelectric conversion device in a watery atmosphere at a predetermined temperature. As a thermal environment in water, preferably water at 20°C (room temperature) or higher, more preferably water at 25°C or higher, further preferably water at 30°C or higher, particularly preferably water at 35°C or higher, and most preferably water at 40°C or higher, etc. can be applied.

Other than water, any organic solvent such as alcohols at a temperature equal to or higher than the aforementioned temperatures may be applied. That is, any environment where thermal vibration of atoms and molecules can be conducted may be applied.

### [Second Embodiment]

### <Thermoelectric Conversion Device (Second Embodiment)>

As shown in the schematic view of Fig. 12, a thermoelectric conversion device 2100 according to the present invention is provided with a positive electrode 210 and a negative electrode 220 that are made from materials having different conductivities, and an organic semiconductor layer between the positive electrode 210 and the negative electrode 220. The organic semiconductor layer contains materials that generate electrons and holes by thermal excitation, and includes a first organic semiconductor layer 232 on the positive electrode side, and a second semiconductor layer 234 on the negative electrode side. The first organic semiconductor layer 232 is higher than the second semiconductor layer 234 in HOMO energy level.

### (Positive Electrode and Negative Electrode Made from Materials of Different Conductivities)

The thermoelectric conversion device of the present invention uses the positive electrode and the negative electrode, which are made from materials of different conductivities. Because of this, an internal electric field is generated in the inside between the electrodes, and the electrons and the holes, which are charge carriers generated by thermal excitation in the organic semiconductor layer, move to the negative electrode and the positive electrode, respectively, by the internal electric field, which causes electromotive force to be generated.

As the foregoing, the thermoelectric conversion device of the present invention generates electromotive force even when the positive electrode and the negative electrode are in the same temperature environment, and is based on a theory different from the conventional Seebeck effect.

Showing a model in Fig. 13, the thermoelectric conversion device of the present invention will be theoretically illustrated.

The most underlying phenomenon is that the two electrode materials of different conductivities generate an internal electric field in the inside between the electrodes. Direct joining of two different electrode materials is a known thermocouple technique, that is, a Seebeck device structure.

However, according to the present invention, the device provided with the negative electrode of a higher conductivity, the positive electrode of a lower conductivity, and the organic semiconductor layer containing materials that emit electrons and holes by thermal excitation and sandwiched between the electrodes is prepared without two different electrode materials joined whereby the present invention succeeded in generating a large internal electric field.

It was proved that the electromotive force obtained in the foregoing way is hundred thousand times to million times as great as the electromotive force by a thermocouple, and the structure of moving to polarize the charge carriers causes the heat flow having entered from the outside to easily move the electrons to the negative electrode and the holes to the positive electrode, which brings a method capable of generating a great electromotive force.

Described based on Fig. 13, the energy levels of the positive electrode and the negative electrode in the drawing are the Fermi levels. Organic semiconductors include the lowest unoccupied molecular orbital (LUMO) and the highest occupied molecular orbital (HOMO) in descending order of energy level. It is noted that when the energy level in organic semiconductors is discussed, it is permitted to compare the band gap between the LUMO and the HOMO with the energy level of any inorganic substance.

In the thermoelectric conversion device of the present invention, the organic semiconductors receive heat energy therearound, which leads to thermal excitation, and the electrons emitted from these organic semiconductors move. Specifically, charge separation created in the organic semiconductors generates carriers (electrons and holes), and these carriers move inside the device and around external circuits according to the energy levels of the substances. That is, the electrons in the LUMO of the second organic semiconductor layer obtain energy that is higher than the Fermi level of the negative electrode and move to the conduction band; and at the same time, the holes in the HOMO of the second organic semiconductor layer move to the HOMO of the first organic semiconductor layer, and further, obtain energy that is higher than the Fermi level of the positive electrode and move to the conduction band. Such movement of the carriers generates electromotive force.

In the present invention, the energy level of the HOMO of the first organic semiconductor layer is higher than the energy level of the HOMO of the second organic semiconductor layer. Therefore, the energy levels of the holes are stepwise towards the positive electrode, and the holes move smoothly. Because of this, a great electromotive force is obtained.

Further, the energy difference between the HOMO and the LUMO of the second organic semiconductor layer is bigger than the energy difference between the HOMO and the LUMO of the first organic semiconductor layer. The electrons having acquired a large amount of energy are positioned on the negative electrode side, where an internal electric field is larger. Therefore, the obtained electromotive force is great.

As described above, according to the thermoelectric conversion device of the present invention, electromotive force can be obtained even when the negative electrode and the positive electrode are present at the same temperature. In the electromotive force generating phenomenon by thermocouples, the temperature difference between the reference point in the measurement system, and the contact point with a heat flow is reflected. However, according to the present invention, the results equivalent to those when electromotive force and electricity generating amount measurements are performed under the condition where the device alone is brought into contact with a heat flow can be obtained even when measurement is performed under the conditions where all of copper wires, measuring instruments, and the device in the measurement system are put in the same temperature environment and a heat flow is provided. This means that in the thermoelectric conversion device of the present invention, the thermally excited electrons and holes function as devices having diode characteristics, showing behaviors equivalent to electrons and holes optically excited inside photocells generated by photoelectric conversion, and generate electromotive force. This is a novel point underlyingly different from the conventional Seebeck device.

In the materials of different conductivities, the electrode made from a material of a lower conductivity, which has a high hole density, is the positive electrode, and the electrode made from a material of a higher conductivity, which has a high electron density, is the positive electrode. Here, a higher conductivity and a lower conductivity are determined by comparing the material constituting the positive electrode and the material constituting the negative electrode.

The bigger the difference between the positive electrode 210 and the negative electrode 220 in conductivity is, the larger the internal electric field generated between the electrodes is. Thus, the lower limit of the difference between the positive electrode 210 and the negative electrode 220 in conductivity is preferably at least 50 S/m, and more preferably at least 100 S/m. Too big a difference in conductivity however causes the electrodes themselves to begin to show a resistance function, which not only causes energy loss, but also leads to deteriorated performance such as a lowered speed of thermoelectric conversion.

The upper limit of this difference is not particularly limited, and in view of selectable materials, is normally preferably at most 10,000 S/m, and more preferably at most 1,000 S/m.

The conductivity of the negative electrode 220, which has a higher conductivity, is preferably 1×10⁷ to 1×10⁸ S/m. The conductivity of the positive electrode 210, which has a lower conductivity, is preferably 1×10³ to 1×10⁵ S/m.

Examples of the materials constituting the electrodes include metals, conductive organic substances, carbon materials such as amorphous carbon, ceramics, and amorphous metals. Examples of the material constituting the positive electrode 210 include tin doped indium oxide (ITO) that is an oxide of indium and tin, carbonaceous substances, and carbon black. Examples of the material constituting the negative electrode 220 include metallic materials such as aluminum, gold, silver, platinum, and copper.

In the thermoelectric conversion device of the present invention, it is important to generate an internal electric field between the electrodes. Various conductive materials may be selected as appropriate and applied as long as a desired internal electric field can be generated. For example, the same conductive material may be used for both the positive electrode and the negative electrode. As an example, pencils obtained by blending carbon and clay have different conductivities according to the blending ratio. An electrode obtained by penciling with a highly conductive pencil can be used as the negative electrode, and an electrode obtained by penciling with a low conductive pencil can be used as the positive electrode.

### (Organic Semiconductor Layer)

A layer made from any of various materials may be used as the organic semiconductor layer as long as provided with the functions of generating electrons and holes by thermal excitation, and transferring the generated electrons and holes to the electrodes, respectively. For example, examples of the materials that generate electrons and holes by thermal excitation include organic semiconductors.

Examples of organic semiconductors as used herein include organic charge transfer complexes such as a complex of phthalocyanine and any of various transition metals, and more specifically, include: magnetic metal-containing organic complex compounds such as iron phthalocyanine (FePc), nickel phthalocyanine (NiPc), manganese phthalocyanine (MnPc), cobalt phthalocyanine (CoPc), iron porphyrin complexes, nickel porphyrin complexes, manganese porphyrin complexes, and cobalt porphyrin complexes; and diamagnetic metal-containing organic complex compounds such as copper phthalocyanine (CuPc), zinc phthalocyanine (ZnPc), copper porphyrin complexes, and zinc porphyrin complexes.

The organic semiconductor layer preferably contains a medium that transfers the electrons and the holes emitted from the foregoing organic semiconductor by thermal excitation to the negative electrode and the positive electrode. For example, polyoxyethylene sorbitan monostearate or the like may be used as such a transport medium for the charge carriers.

In the present invention, the organic semiconductor layer is formed of the two layers of the first organic semiconductor layer 232 on the positive electrode 210 side, and the second organic semiconductor layer 234 on the negative electrode 220 side. As described above, the energy level of the HOMO of the first organic semiconductor layer 232 is higher than the energy level of the HOMO of the second organic semiconductor layer 234 whereby a great electromotive force is obtained.

An example of combination of organic semiconductors as used herein that leads to such a feature is the combination of iron phthalocyanine as an organic semiconductor contained in the first organic semiconductor layer, and any of copper phthalocyanine, cobalt phthalocyanine, nickel phthalocyanine, and zinc phthalocyanine as an organic semiconductor contained in the second organic semiconductor layer.

### <Method of Producing Thermoelectric Conversion Device (Second Embodiment)>

For example, the thermoelectric conversion device of the present invention can be produced by the following procedures:
1. the step of preparing mixed solutions containing the organic semiconductors;
2. the step of forming the organic semiconductor layer on the surfaces of the electrodes; and
3. the step of forming the thermoelectric conversion device.

### (Preparing Mixed Solutions Containing Organic Semiconductors)

Mixed solutions containing the organic semiconductors can be each obtained by mixing and, if necessary, stirring the organic semiconductor, the transport medium for the charge carriers, and a solvent where the transport medium can dissolve. The solvent amount can be appropriately adjusted, so that the handleability (applicability) of the solutions is excellent. No solvent may be added as long as there is no problem about the applicability. The solvent is not particularly limited, and for example, chloroform may be used.

### (Step of Forming Organic Semiconductor Layer on Surfaces of Electrodes)

The organic semiconductor layer can be formed on the surfaces of the electrodes by applying, to the surfaces of the positive electrode and the negative electrode, and drying the mixed solutions formed in the above step. An example of a preferred mode is the following: the first organic semiconductor layer is formed on the surface of the positive electrode and the second organic semiconductor layer is formed on the surface of the negative electrode by applying the mixed solutions to the respective surfaces of the positive electrode and the negative electrode. According to this mode, the adhesiveness of the positive electrode and the negative electrode to the organic semiconductor layers, respectively, can be improved.

Alternatively, the device may be formed by forming the first organic semiconductor layer and the second organic semiconductor layer in order on the surface of the positive electrode, and laminating the resultant, so that the second organic semiconductor layer side thereof faces the surface of the negative electrode. Similarly, the device may be also formed by forming the second organic semiconductor layer and the first organic semiconductor layer in order on the surface of the negative electrode, and laminating the resultant, so that the first organic semiconductor layer side thereof faces the surface of the positive electrode. However, in this case, it is necessary to adjust the pressing force and the heating temperature so as to achieve the adhesiveness of the electrodes to the organic semiconductor layer when the electrodes are laminated.

### (Step of Forming Thermoelectric Conversion Device)

The thermoelectric conversion device is formed by laminating the first organic semiconductor layer formed on the surface of the positive electrode and the second organic semiconductor layer formed on the surface of the negative electrode, which are obtained in the above step. Preferably, a pressing force of approximately 1,200 hPa to 1,500 hPa is applied to the positive electrode/first organic semiconductor layer/second organic semiconductor layer/negative electrode, which is formed by the lamination, and preferably, this state is retained for 60 minutes to 120 minutes whereby the first organic semiconductor layer/second organic semiconductor layer can be adhered.

The organic semiconductor layers can be united into one body more effectively by heating in addition when laminated. Preferably, heating may be performed at a temperature in the range of 50°C to 140°C.

### <Thermoelectric Conversion Method (Second Embodiment)>

According to the thermoelectric conversion method of the present invention, heat energy can be converted to electrical energy just by the step of disposing the aforementioned thermoelectric conversion device in the presence of a heat energy flow that realizes a certain thermal environment. That is, conventional methods based on the Seebeck effect require making a temperature difference between the positive electrode and the negative electrode, whereas the method of the present application requires no temperature difference but the thermoelectric conversion device is just disposed in a thermal environment at a certain temperature in the presence of a heat energy flow.

A thermal environment at a certain temperature in the presence of a heat energy flow may be any environment as long as being a thermal environment so as to give the thermoelectric conversion device a certain amount of heat energy, and preferably the atmosphere at 20°C (room temperature) or higher, more preferably the atmosphere at 25°C or higher, further preferably the atmosphere at 30°C or higher, particularly preferably the atmosphere at 35°C or higher, and most preferably the atmosphere at 40°C or higher, etc. can be applied. This is the phenomenon understandable by comparison with a certain photoirradiation environment in the presence of a light energy flow in solar cells, where electrons and holes excited by light energy move inside the device, and is a physically understandable phenomenon. When the light energy flow stops, the function of generating electromotive force in the solar cells stops, whereas a decrease in inflow of a heat energy flow in the thermoelectric conversion method of the present invention corresponds to the stop of the light energy flow in the solar cells, and is understandable by comparison with deterioration of the function of generating electromotive force. It is noted that the phenomenon of generating electromotive force does not suddenly become zero since the energy distributions of the atoms and the molecules that carry the heat energy flow are not instantly into zero states, but are gradually attenuating, which is different from the stop of photoirradiation.

Even an environment in a gaseous atmosphere other than the atmosphere, for example, an environment in an inert gas such as nitrogen can be considered to be an environment that can give the thermoelectric conversion device heat energy as long as the temperature is the same as the above. Further, the environment may be in an atmosphere excluding gas, for example, may be in a liquid such as water. In view of efficiently giving thermoelectric conversion device heat energy, it is considered to be preferable to dispose the thermoelectric conversion device in a watery atmosphere at a predetermined temperature. As a thermal environment in water, preferably water at 20°C (room temperature) or higher, more preferably water at 25°C or higher, further preferably water at 30°C or higher, particularly preferably water at 35°C or higher, and most preferably water at 40°C or higher, etc. can be applied.

Other than water, any organic solvent such as alcohols at a temperature equal to or higher than the aforementioned temperatures may be applied.

That is, any environment where thermal vibration of atoms and molecules can be conducted may be applied.

### [Third Embodiment]

### <Thermoelectric Conversion Device (Third Embodiment)>

As shown in the schematic view of Fig. 25(a), a thermoelectric conversion device 3100A according to the present invention is provided with a positive electrode 310 and a negative electrode 320 that are made from materials having different conductivities, and an organic semiconductor layer 330 between the positive electrode 310 and the negative electrode 320. The organic semiconductor layer 330 contains a material that generates electrons and holes by thermal excitation.

As shown in the schematic view of Fig. 25(b), a thermoelectric conversion device 3100B according to a preferred embodiment of the present invention is provided with: the positive electrode 310 and the negative electrode 320 that are made from materials having different conductivities; and a first organic semiconductor layer 332 on the positive electrode 310 side and a second semiconductor layer 334 on the negative electrode side 320 between the positive electrode 310 and the negative electrode 320 as an organic semiconductor layer containing materials that generate electrons and holes by thermal excitation.

### (Positive Electrode and Negative Electrode Made from Materials of Different Conductivities)

The thermoelectric conversion device of the present invention uses the positive electrode and the negative electrode, which are made from materials of different conductivities. Because of this, an internal electric field is generated in the inside between the electrodes, and the electrons and the holes, which are charge carriers generated by thermal excitation in the organic semiconductor layer, move to the negative electrode and the positive electrode, respectively, by the internal electric field, which causes electromotive force to be generated.

As the foregoing, the thermoelectric conversion device of the present invention generates electromotive force even when the positive electrode and the negative electrode are in the same temperature environment, and is based on a theory different from the conventional Seebeck effect.

Showing a model when the organic semiconductor layer has a single layer structure in Fig. 26(a), and a model when the organic semiconductor layer has a two layer structure in Fig. 26(b), the thermoelectric conversion device of the present invention will be theoretically illustrated.

The most underlying phenomenon is that the two electrode materials of different conductivities generate an internal electric field in the inside between the electrodes. Direct joining of two different electrode materials is a known thermocouple technique, that is, a Seebeck device structure.

However, according to the present invention, the device provided with the negative electrode of a higher conductivity, the positive electrode of a lower conductivity, and the organic semiconductor layer containing a material that emits electrons and holes by thermal excitation and sandwiched between the electrodes is prepared without two different electrode materials joined whereby the present invention succeeded in generating a large internal electric field.

It was proved that the electromotive force obtained in the foregoing way is hundred thousand times to million times as great as the electromotive force by a thermocouple, and the structure of moving to polarize the charge carriers causes the heat flow having entered from the outside to easily move the electrons to the negative electrode and the holes to the positive electrode, which brings a method capable of generating a great electromotive force.

Described based on Fig. 26(a), the energy levels of the positive electrode and the negative electrode in the drawing are the Fermi levels. Organic semiconductors include the lowest unoccupied molecular orbital (LUMO) and the highest occupied molecular orbital (HOMO) in descending order of energy level. It is noted that when the energy level in organic semiconductors is discussed, it is permitted to compare the band gap between the LUMO and the HOMO with the energy level of any inorganic substance.

In the thermoelectric conversion device of the present invention, the organic semiconductor receives heat energy therearound, which leads to thermal excitation, and the electrons emitted from this organic semiconductor move. Specifically, charge separation created in the organic semiconductor generates carriers (electrons and holes), and these carriers move inside the device and around external circuits according to the energy levels of the substances. That is, the electrons in the LUMO of the organic semiconductor obtain energy that is higher than the Fermi level of the negative electrode and move to the conduction band; and at the same time, the holes in the HOMO of the organic semiconductor obtain energy that is higher than the Fermi level of the positive electrode and move to the conduction band. Such movement of the carriers generates electromotive force.

Further, described based on Fig. 26(b), the energy levels of the positive electrode and the negative electrode in the drawing are the Fermi levels. Organic semiconductors include the lowest unoccupied molecular orbital (LUMO) and the highest occupied molecular orbital (HOMO) in descending order of energy level. It is noted that when the energy level in organic semiconductors is discussed, it is permitted to compare the band gap between the LUMO and the HOMO with the energy level of any inorganic substance.

In the thermoelectric conversion device of the present invention, the organic semiconductors receive heat energy therearound, which leads to thermal excitation, and the electrons emitted from these organic semiconductors move. Specifically, charge separation created in the organic semiconductors generates carriers (electrons and holes), and these carriers move inside the device and around external circuits according to the energy levels of the substances. That is, the electrons in the LUMO of the second organic semiconductor layer obtain energy that is higher than the Fermi level of the negative electrode and move to the conduction band; and at the same time, the holes in the HOMO of the second organic semiconductor layer move to the HOMO of the first organic semiconductor layer, and further, obtain energy that is higher than the Fermi level of the positive electrode and move to the conduction band. Such movement of the carriers generates electromotive force.

In the mode of Fig. 26(b), the energy level of the HOMO of the first organic semiconductor layer is higher than the energy level of the HOMO of the second organic semiconductor layer. Therefore, the energy levels of the holes are stepwise towards the positive electrode, and the holes move smoothly. Because of this, a great electromotive force is obtained.

Further, the energy difference between the HOMO and the LUMO of the second organic semiconductor layer is bigger than the energy difference between the HOMO and the LUMO of the first organic semiconductor layer. The electrons having acquired a large amount of energy are positioned on the negative electrode side, where an internal electric field is larger. Therefore, the obtained electromotive force is great.

As described above, according to the thermoelectric conversion device of the present invention, electromotive force can be obtained even when the negative electrode and the positive electrode are present at the same temperature. In the electromotive force generating phenomenon by thermocouples, the temperature difference between the reference point in the measurement system, and the contact point with a heat flow is reflected. However, according to the present invention, the results equivalent to those when electromotive force and electricity generating amount measurements are performed under the condition where the device alone is brought into contact with a heat flow can be obtained even when measurement is performed under the conditions where all of copper wires, measuring instruments, and the device in the measurement system are put in the same temperature environment and a heat flow is provided. This means that in the thermoelectric conversion device of the present invention, the thermally excited electrons and holes function as devices having diode characteristics, showing behaviors equivalent to electrons and holes optically excited inside photocells generated by photoelectric conversion, and generate electromotive force. This is a novel point underlyingly different from the conventional Seebeck device.

In the materials of different conductivities, the electrode made from a material of a lower conductivity, which has a high hole density, is the positive electrode, and the electrode made from a material of a higher conductivity, which has a high electron density, is the positive electrode. Here, a higher conductivity and a lower conductivity are determined by comparing the material constituting the positive electrode, and the material constituting the negative electrode.

The bigger the difference between the positive electrode 310 and the negative electrode 320 in conductivity is, the larger the internal electric field generated between the electrodes is. Thus, the lower limit of the difference between the positive electrode 10 and the negative electrode 20 in conductivity is preferably at least 50 S/m, and more preferably at least 100 S/m. Too big a difference in conductivity however causes the electrodes themselves to begin to show a resistance function, which not only causes energy loss, but also leads to deteriorated performance such as a lowered speed of thermoelectric conversion.

The upper limit of this difference is not particularly limited, and in view of selectable materials, is normally preferably at most 10,000 S/m, and more preferably at most 1,000 S/m.

The conductivity of the negative electrode 320, which has a higher conductivity, is preferably 1×10⁷ to 1×10⁸ S/m. The conductivity of the positive electrode 310, which has a lower conductivity, is preferably 1×10³ to 1×10⁵ S/m.

Examples of the materials constituting the electrodes include metals, conductive organic substances, carbon materials such as amorphous carbon, ceramics, and amorphous metals. Examples of the material constituting the positive electrode 10 include tin doped indium oxide (ITO) that is an oxide of indium and tin, and carbonaceous substances. Examples of the material constituting the negative electrode 320 include metallic materials such as aluminum, gold, silver, platinum, and copper.

In the thermoelectric conversion device of the present invention, it is important to generate an internal electric field between the electrodes. Various conductive materials may be selected as appropriate and applied as long as a desired internal electric field can be generated. For example, the same conductive material may be used for both the positive electrode and the negative electrode. As an example, pencils obtained by blending carbon and clay have different conductivities according to the blending ratio. An electrode obtained by penciling with a highly conductive pencil can be used as the negative electrode, and an electrode obtained by penciling with a low conductive pencil can be used as the positive electrode.

### (Organic Semiconductor Layer)

A layer made from any of various materials may be used as the organic semiconductor layer as long as provided with the functions of generating electrons and holes by thermal excitation, and transferring the generated electrons and holes to the electrodes, respectively. For example, examples of the material that generates electrons and holes by thermal excitation include organic semiconductors.

Examples of organic semiconductors as used herein include organic charge transfer complexes such as a complex of phthalocyanine and any of various transition metals, and more specifically, include: magnetic metal-containing organic complex compounds such as iron phthalocyanine (FePc), nickel phthalocyanine (NiPc), manganese phthalocyanine (MnPc), cobalt phthalocyanine (CoPc), iron porphyrin complexes, nickel porphyrin complexes, manganese porphyrin complexes, and cobalt porphyrin complexes; and diamagnetic metal-containing organic complex compounds such as copper phthalocyanine (CuPc), zinc phthalocyanine (ZnPc), copper porphyrin complexes, and zinc porphyrin complexes.

The organic semiconductor layer preferably contains a medium that transfers the electrons and the holes emitted from the foregoing organic semiconductor by thermal excitation to the negative electrode and the positive electrode. For example, polyoxyethylene sorbitan monostearate or the like may be used as such a transport medium for the charge carriers.

As shown in Fig. 25(b), the organic semiconductor layer 330 is preferably formed of the two layers of the first organic semiconductor layer 332 on the positive electrode 310 side, and the second organic semiconductor layer 334 on the negative electrode 320 side. As described above, preferably, the energy level of the HOMO of the first organic semiconductor layer 332 is higher than the energy level of the HOMO of the second organic semiconductor layer 334 whereby a great electromotive force is obtained.

An example of combination of organic semiconductors as used herein that leads to such a feature is the combination of iron phthalocyanine as an organic semiconductor contained in the first organic semiconductor layer, and zinc phthalocyanine as an organic semiconductor contained in the second organic semiconductor layer.

### (Addition of Transition metal Ions to Organic Semiconductor Layer)

In the thermoelectric conversion device of the present invention, the organic semiconductor layer contains transition metal ions. The inventor of the present invention presumes that the electromotive force by the thermoelectric conversion device of the present invention is improved by the contained transition metal ions because the transition metal ions generate excitons (electrons and holes) by thermal excitation and these excitons function as supplements to excitons of the organic semiconductor.

Hereinafter the mechanism to improve electromotive force mentioned above will be described with reference to Fig. 27.

The transitional elements in a phthalocyanine (Pc) complex (for example, Fe is illustrated in the drawing), which is an organic semiconductor, are thermally excited to generate excitons (electrons and holes), and polarize by the internal electric field.

When, for example, FeCl₂ or FeCl₃ is added whereby transition metal ions (for example, Fe ions) are introduced into the organic semiconductor layer, the number density of the Fe elements around phthalocyanine (Pc) increases. At this time, Fe²⁺ (which can be regarded as the presence of 2 × a hole) is excited equivalently to Fe in the phthalocyanine complex to generate excitons (3 × a hole, and an electron). The electron then moves to the negative electrode, Fe³⁺ (which can be regarded as 3 × a hole) generate Fe²⁺ and a hole, and the rest one hole moves to the positive electrode.

This phenomenon is repeated in the field generated by phthalocyanine, and the function as a thermal excitation diode-type electric power generating device is obtained. The undermentioned examples confirmed that the electricity generating amount depended on the number density of the added Fe ions.

Examples of the transition metal ions added to the organic semiconductor layer, that is, the transition metal ions that the organic semiconductor layer further contains include: iron ions, zinc ions, manganese ions, nickel ions, copper ions, and cobalt ions; ions of first transitional elements such as scandium, titanium, vanadium, and chromium; ions of second transitional elements such as yttrium, zirconium, niobium, molybdenum, technetium, ruthenium, rhodium, palladium, and silver; and ions of third transitional elements such as lanthanum, cerium, praseodymium, neodymium, promethium, samarium, europium, gadolinium, terbium, dysprosium, holmium, erbium, thulium, ytterbium, ruthenium, hafnium, tantalum, tungsten, rhenium, osmium, iridium, platinum, and gold. Among them, in view of the effect of increasing the electromotive force by the thermoelectric conversion device, and in view of rich existence on the earth and thus being usable, iron ions are preferable. These transition metal ions can be added in the form of: halide such as chlorides and bromides; hydroxide; and the like. Among them, in view of handleability, the transition metal ions are preferably added as a chloride. Further, the transition metal ions are preferably added as an anhydride. The adding amount is preferably 0.5 to 1.5, and more preferably 0.8 to 1.2 in mass ratio to the phthalocyanine complex, which is an organic semiconductor.

### <Method of Producing Thermoelectric Conversion Device (Third Embodiment)>

For example, the thermoelectric conversion device of the present invention can be produced by the following procedures:
1. the step of preparing a mixed solution containing the organic semiconductor;
2. the step of forming the organic semiconductor layer on the surfaces of the electrodes; and
3. the step of forming the thermoelectric conversion device.

### (Preparing Mixed Solution Containing Organic Semiconductor)

A mixed solution containing the organic semiconductor can be obtained by mixing and, if necessary, stirring the organic semiconductor, a halide of a transition metal, the transport medium for the charge carriers, and a solvent where the transport medium can dissolve. The solvent amount can be appropriately adjusted, so that the handleability (applicability) of the solution is excellent. No solvent may be added as long as there is no problem about the applicability. The solvent is not particularly limited, and for example, chloroform may be used.

Further, the mixed solution containing the organic semiconductor may further contain a carbonate compound such as lithium carbonate, sodium carbonate, and calcium carbonate. The mixed solution containing the foregoing carbonate compound can neutralize a hydrogen halide that may be generated when the components contain hydrated water.

### (Step of Forming Organic Semiconductor Layer on Surfaces of Electrodes)

The organic semiconductor layer can be formed on the surfaces of the electrodes by applying, to the surfaces of the positive electrode and the negative electrode, and drying the mixed solution formed in the above step. As a preferred mode, the mixed solution is applied to each of the surfaces of the positive electrode and the negative electrode to form organic semiconductor layers on the respective surfaces, and the resultant is adhered in the subsequent step.

An example of the mode of forming the two layers of the organic semiconductors is the mode of forming the first organic semiconductor layer on the surface of the positive electrode and the second organic semiconductor layer on the surface of the negative electrode.

According to these modes, the adhesiveness of the positive electrode and the negative electrode to the organic semiconductor layers, respectively, can be improved.

Alternatively, the device may be formed by forming the first organic semiconductor layer and the second organic semiconductor layer in order on the surface of the positive electrode, and laminating the resultant, so that the second organic semiconductor layer side thereof faces the surface of the negative electrode. Similarly, the device may be also formed by forming the second organic semiconductor layer and the first organic semiconductor layer in order on the surface of the negative electrode, and laminating the resultant, so that the first organic semiconductor layer side thereof faces the surface of the positive electrode. However, in this case, it is necessary to adjust the pressing force and the heating temperature so as to achieve the adhesiveness of the electrodes to the organic semiconductor layer when the electrodes are laminated.

### (Step of Forming Thermoelectric Conversion Device)

The thermoelectric conversion device is formed by laminating the organic semiconductor layer formed on the surface of the positive electrode and the organic semiconductor layer formed on the surface of the negative electrode, which are obtained in the above step, or by laminating the first organic semiconductor layer formed on the surface of the positive electrode and the second organic semiconductor layer formed on the surface of the negative electrode, which are obtained in the above step. Preferably, a pressing force of approximately 1,200 hPa to 1,500 hPa is applied to the positive electrode/organic semiconductor layer/organic semiconductor layer/negative electrode or the positive electrode/first organic semiconductor layer/second organic semiconductor layer/negative electrode, which are formed by the lamination, and preferably, this state is retained for 60 minutes to 120 minutes whereby the organic semiconductor layers can be adhered to each other.

The organic semiconductor layers can be united into one body more effectively by heating in addition when laminated. Preferably, heating may be performed at a temperature in the range of 50°C to 140°C.

### <Thermoelectric Conversion Method (Third Embodiment)>

According to the thermoelectric conversion method of the present invention, heat energy can be converted to electrical energy just by the step of disposing the aforementioned thermoelectric conversion device in the presence of a heat energy flow that realizes a certain thermal environment. That is, conventional methods based on the Seebeck effect require making a temperature difference between the positive electrode and the negative electrode, whereas the method of the present application requires no temperature difference but the thermoelectric conversion device is just disposed in a thermal environment at a certain temperature in the presence of a heat energy flow.

A thermal environment at a certain temperature in the presence of a heat energy flow may be any environment as long as being a thermal environment so as to give the thermoelectric conversion device a certain amount of heat energy, and preferably the atmosphere at 20°C (room temperature) or higher, more preferably the atmosphere at 25°C or higher, further preferably the atmosphere at 30°C or higher, particularly preferably the atmosphere at 35°C or higher, and most preferably the atmosphere at 40°C or higher, etc. can be applied. This is the phenomenon understandable by comparison with a certain photoirradiation environment in the presence of a light energy flow in solar cells, where electrons and holes excited by light energy move inside the device, and is a physically understandable phenomenon. When the light energy flow stops, the function of generating electromotive force in the solar cells stops, whereas a decrease in inflow of a heat energy flow in the thermoelectric conversion method of the present invention corresponds to the stop of the light energy flow in the solar cells, and is understandable by comparison with deterioration of the function of generating electromotive force. It is noted that the phenomenon of generating electromotive force does not suddenly become zero since the energy distributions of atoms and molecules that carry the heat energy flow are not instantly into zero states, but are gradually attenuating, which is different from the stop of photoirradiation.

Even an environment in a gaseous atmosphere other than the atmosphere, for example, an environment in an inert gas such as nitrogen can be considered to be an environment that can give the thermoelectric conversion device heat energy as long as the temperature is the same as the above. Further, the environment may be in an atmosphere excluding gas, for example, may be in a liquid such as water. In view of efficiently giving thermoelectric conversion device heat energy, it is considered to be preferable to dispose the thermoelectric conversion device in a watery atmosphere at a predetermined temperature. As a thermal environment in water, preferably water at 20°C (room temperature) or higher, more preferably water at 25°C or higher, further preferably water at 30°C or higher, particularly preferably water at 35°C or higher, and most preferably water at 40°C or higher, etc. can be applied.

Other than water, any organic solvent such as alcohols at a temperature equal to or higher than any of the aforementioned temperatures may be applied. That is, any environment where thermal vibration of atoms and molecules can be conducted may be applied.

### [Fourth Embodiment]

### <Thermoelectric Conversion Device (Fourth Embodiment)>

As shown in the schematic view of Fig. 36, a thermoelectric conversion device 4100 according to the present invention is provided with a positive electrode 410 and a negative electrode 420 that are made from materials having different conductivities, and an organic semiconductor layer between the positive electrode 410 and the negative electrode 420. The organic semiconductor layer contains materials that generate electrons and holes by thermal excitation, includes a first organic semiconductor layer 432 on the positive electrode side, and a second semiconductor layer 434 on the negative electrode side, and further includes a layer 440 made from a carbonaceous substance between the first organic semiconductor layer 432 and the second semiconductor layer 434.

### (Positive Electrode and Negative Electrode Made from Materials of Different Conductivities)

The thermoelectric conversion device of the present invention uses the positive electrode and the negative electrode, which are made from materials of different conductivities. Because of this, an internal electric field is generated in the inside between the electrodes, and the electrons and the holes, which are charge carriers generated by thermal excitation in the organic semiconductor layer, move to the negative electrode and the positive electrode, respectively, by the internal electric field, which causes electromotive force to be generated.

As the foregoing, the thermoelectric conversion device of the present invention generates electromotive force even when the positive electrode and the negative electrode are in the same temperature environment, and is based on a theory different from the conventional Seebeck effect.

Showing a model in Fig. 37, the thermoelectric conversion device of the present invention will be theoretically illustrated.

The most underlying phenomenon is that the two electrode materials of different conductivities generate an internal electric field in the inside between the electrodes. Direct joining of two different electrode materials is a known thermocouple technique, that is, a Seebeck device structure.

However, according to the present invention, the device provided with the negative electrode of a higher conductivity, the positive electrode of a lower conductivity, and the organic semiconductor layer containing materials that emit electrons and holes by thermal excitation and sandwiched between the electrodes is prepared without two different electrode materials joined whereby the present invention succeeded in generating a large internal electric field.

It was proved that the electromotive force obtained in the foregoing way is hundred thousand times to million times as great as the electromotive force by a thermocouple, and the structure of moving to polarize the charge carriers causes the heat flow having entered from the outside to easily move the electrons to the negative electrode and the holes to the positive electrode, which brings a method capable of generating a great electromotive force. present invention.

Described based on Fig. 37, the energy levels of the positive electrode and the negative electrode in the drawing are the Fermi levels. Organic semiconductors include the lowest unoccupied molecular orbital (LUMO) and the highest occupied molecular orbital (HOMO) in descending order of energy level. It is noted that when the energy level in organic semiconductors is discussed, it is permitted to compare the band gap between the LUMO and the HOMO with the energy level of any inorganic substance.

In the thermoelectric conversion device of the present invention, the organic semiconductors receive heat energy therearound, which leads to thermal excitation, and the electrons emitted from these organic semiconductors move. Specifically, charge separation created in the organic semiconductors generates carriers (electrons and holes), and these carriers move inside the device and around external circuits according to the energy levels of the substances. That is, the electrons in the LUMO of the second organic semiconductor layer obtain energy that is higher than the Fermi level of the negative electrode and move to the conduction band; and at the same time, the holes in the HOMO of the second organic semiconductor layer move to the HOMO of the first organic semiconductor layer, and further, obtain energy that is higher than the Fermi level of the positive electrode and move to the conduction band. Such movement of the carriers generates electromotive force.

In the present invention, preferably, the energy level of the HOMO of the first organic semiconductor layer is higher than the energy level of the HOMO of the second organic semiconductor layer. Therefore, the energy levels of the holes are stepwise towards the positive electrode, and the holes move smoothly. Because of this, a great electromotive force is obtained.

Further, preferably, the energy difference between the HOMO and the LUMO of the second organic semiconductor layer is bigger than the energy difference between the HOMO and the LUMO of the first organic semiconductor layer. The electrons having acquired a large amount of energy are positioned on the negative electrode side, where an internal electric field is larger. Therefore, the obtained electromotive force is great.

As described above, according to the thermoelectric conversion device of the present invention, electromotive force can be obtained even when the negative electrode and the positive electrode are present at the same temperature. In the electromotive force generating phenomenon by thermocouples, the temperature difference between the reference point in the measurement system, and the contact point with a heat flow is reflected. However, according to the present invention, the results equivalent to those when electromotive force and electricity generating amount measurements are performed under the condition where the device alone is brought into contact with a heat flow can be obtained even when measurement is performed under the conditions where all of copper wires, measuring instruments, and the device in the measurement system are put in the same temperature environment and a heat flow is provided. This means that in the thermoelectric conversion device of the present invention, the thermally excited electrons and holes function as devices having diode characteristics, showing behaviors equivalent to electrons and holes optically excited inside photocells generated by photoelectric conversion, and generate electromotive force. This is a novel point underlyingly different from the conventional Seebeck device.

In the materials of different conductivities, the electrode made from a material of a lower conductivity, which has a high hole density, is the positive electrode, and the electrode made from a material of a higher conductivity, which has a high electron density, is the positive electrode. Here, a higher conductivity and a lower conductivity are determined by comparing the material constituting the positive electrode, and the material constituting the negative electrode.

The bigger the difference between the positive electrode 410 and the negative electrode 420 in conductivity is, the larger the internal electric field generated between the electrodes is. Thus, the lower limit of the difference between the positive electrode 410 and the negative electrode 420 in conductivity is preferably at least 50 S/m, and more preferably at least 100 S/m. Too big a difference in conductivity however causes the electrodes themselves to begin to show a resistance function, which not only causes energy loss, but also leads to deteriorated performance such as a lowered speed of thermoelectric conversion.

The upper limit of this difference is not particularly limited, and in view of selectable materials, is normally preferably at most 10,000 S/m, and more preferably at most 1,000 S/m.

The conductivity of the negative electrode 420, which has a higher conductivity, is preferably 1×10⁷ to 1×10⁸ S/m. The conductivity of the positive electrode 410, which has a lower conductivity, is preferably 1×10³ to 1×10⁵ S/m.

Examples of the materials constituting the electrodes include metals, conductive organic substances, carbon materials such as amorphous carbon, ceramics, and amorphous metals. Examples of the material constituting the positive electrode 10 include tin doped indium oxide (ITO) that is an oxide of indium and tin, carbonaceous substances, and carbon black. Examples of the material constituting the negative electrode 20 include metallic materials such as aluminum, gold, silver, platinum, and copper.

In the thermoelectric conversion device of the present invention, it is important to generate an internal electric field between the electrodes. Various conductive materials may be selected as appropriate and applied as long as a desired internal electric field can be generated. For example, the same conductive material may be used for both the positive electrode and the negative electrode. As an example, pencils obtained by blending carbon and clay have different conductivities according to the blending ratio. An electrode obtained by penciling with a highly conductive pencil can be used as the negative electrode, and an electrode obtained by penciling with a low conductive pencil can be used as the positive electrode.

### (Organic Semiconductor Layer)

A layer made from any of various materials may be used as the organic semiconductor layer as long as provided with the functions of generating electrons and holes by thermal excitation, and transferring the generated electrons and holes to the electrodes, respectively. For example, examples of the materials that generate electrons and holes by thermal excitation include organic semiconductors.

Examples of organic semiconductors as used herein include organic charge transfer complexes such as a complex of phthalocyanine and any of various transition metals, and more specifically, include: magnetic metal-containing organic complex compounds such as iron phthalocyanine (FePc), nickel phthalocyanine (NiPc), manganese phthalocyanine (MnPc), cobalt phthalocyanine (CoPc), iron porphyrin complexes, nickel porphyrin complexes, manganese porphyrin complexes, and cobalt porphyrin complexes; and diamagnetic metal-containing organic complex compounds such as copper phthalocyanine (CuPc), zinc phthalocyanine (ZnPc), copper porphyrin complexes, and zinc porphyrin complexes.

The organic semiconductor layer preferably contains a medium that transfers the electrons and the holes emitted from the foregoing organic semiconductor by thermal excitation to the negative electrode and the positive electrode. For example, an emulsifier such as polyoxyethylene sorbitan monostearate may be used as such a transport medium for the charge carriers.

In the present invention, the organic semiconductor layer is formed of the two layers of the first organic semiconductor layer 432 on the positive electrode 410 side, and the second organic semiconductor layer 434 on the negative electrode 420 side. As described above, preferably, the energy level of the HOMO of the first organic semiconductor layer 432 is higher than the energy level of the HOMO of the second organic semiconductor layer 434 whereby a great electromotive force is obtained.

An example of combination of organic semiconductors as used herein that leads to such a feature is the combination of iron phthalocyanine as an organic semiconductor contained in the first organic semiconductor layer, and any of copper phthalocyanine, cobalt phthalocyanine, nickel phthalocyanine, and zinc phthalocyanine as an organic semiconductor contained in the second organic semiconductor layer.

### (Layer Formed from Carbonaceous Substance)

The present invention is further provided with the layer formed from a carbonaceous substance between the first organic semiconductor layer and the second semiconductor layer. In the organic semiconductor layers, polyoxyethylene sorbitan monostearate as described above functions as a thickener to hold the shape of the organic semiconductor layers themselves. However, the higher the temperature is, the lower the viscosity of polyoxyethylene sorbitan monostearate is, and the smaller the thickening effect is. Because of this, the components may flow between the first organic semiconductor and the second organic semiconductor. The present invention is provided with the layer formed from a carbonaceous substance between the first organic semiconductor layer and the second semiconductor layer whereby the flow of the components is suppressed and electromotive force can be maintained over the long term even under high temperature conditions.

The device of the present invention, which is provided with the layer formed from a carbonaceous substance layered between the organic semiconductors, suppresses the flowability in the organic semiconductor layers, and in addition, improves charge transport efficiency in circuits of a lower resistance at lower temperatures. As shown in the undermentioned examples, an apparent increase in electricity generating amount is found in a temperature environment of 60°C or lower. Concerning this effect, the increase in electricity generating amount can be understood assuming that the two devices of a "positive electrode/first organic semiconductor layer/layer formed from a carbonaceous substance" and a "layer formed from a carbonaceous substance/second organic semiconductor layer/negative electrode" are connected in series.

Examples of a carbonaceous substance forming the layer formed from a carbonaceous substance include graphite, graphene, and fullerene.

The device of the present invention may be also formed by sandwiching a Teflon filter having a pore of 10 nm to 100 nm between the layer formed from a carbonaceous substance, and the first organic semiconductor layer and/or the second organic semiconductor layer. According to this, diffusion of a carbonaceous substance as used herein, diffusion of the first organic semiconductor substance on the positive electrode side, and diffusion of the second organic semiconductor substance on the negative electrode side can be suppressed without preventing the charge carriers (ions, electrons, and holes) from moving.

### <Method of Producing Thermoelectric Conversion Device (Fourth Embodiment)>

For example, the thermoelectric conversion device of the present invention can be produced by the following procedures:
1. the step of preparing mixed solutions containing the organic semiconductors;
2. the step of forming the organic semiconductor layer on the surfaces of the electrodes; and
3. the step of forming the thermoelectric conversion device.

### (Preparing Mixed Solutions Containing Organic Semiconductors)

Mixed solutions containing the organic semiconductors can be each obtained by mixing and, if necessary, stirring the organic semiconductor, the transport medium for the charge carriers, and a solvent where the transport medium can dissolve. The solvent amount can be appropriately adjusted, so that the handleability (applicability) of the solutions is excellent. No solvent may be added as long as there is no problem about the applicability. The solvent is not particularly limited, and for example, chloroform may be used.

### (Step of Forming Organic Semiconductor Layer on Surfaces of Electrodes)

The organic semiconductor layer can be formed on the surfaces of the electrodes by applying, to the surfaces of the positive electrode and the negative electrode, and drying the mixed solutions formed in the above step. An example of a preferred mode is the following: the first organic semiconductor layer is formed on the surface of the positive electrode and the second organic semiconductor layer is formed on the surface of the negative electrode by applying the mixed solutions to the respective surfaces of the positive electrode and the negative electrode. According to this mode, the adhesiveness of the positive electrode and the negative electrode to the organic semiconductor layers, respectively, can be improved.

Alternatively, the device may be formed by forming the first organic semiconductor layer, the layer formed from a carbonaceous substance, and the second organic semiconductor layer in order on the surface of the positive electrode, and laminating the resultant, so that the second organic semiconductor layer side thereof faces the surface of the negative electrode. Similarly, the device may be also formed by forming the second organic semiconductor layer, the layer formed from a carbonaceous substance, and the first organic semiconductor layer in order on the surface of the negative electrode, and laminating the resultant, so that the first organic semiconductor layer side thereof faces the surface of the positive electrode. However, in this case, it is necessary to adjust the pressing force and the heating temperature so as to achieve the adhesiveness of the electrodes to the organic semiconductor layer when the electrodes are laminated.

### (Step of Forming Thermoelectric Conversion Device)

The thermoelectric conversion device of the present invention is formed by laminating the first organic semiconductor layer formed on the surface of the positive electrode and the second organic semiconductor layer formed on the surface of the negative electrode via the layer formed from a carbonaceous substance, which are obtained in the above step. That is, the thermoelectric conversion device of the present invention can be formed by: laminating the first organic semiconductor layer formed on the surface of the positive electrode, and the layer formed from a carbonaceous substance on one side thereof; and laminating the second organic semiconductor layer formed on the surface of the negative electrode, and the layer formed from a carbonaceous substance on the other side thereof.

Specifically, the thermoelectric conversion device of the present invention is formed by: scattering a carbonaceous substance such as a graphite powder over the first organic semiconductor layer on the positive electrode side as a top face, so that the carbonaceous substance preferably has a thickness of 1 µm to 20 µm, more preferably has a thickness of 5 µm to 15 µm; and laminating the carbonaceous substance and the second organic semiconductor layer on the negative electrode side.

As described above, the device can be formed by: layering a Teflon filter having a pore of 10 nm to 100 nm on the layer formed from a carbonaceous substance, which is formed on the first organic semiconductor layer; and laminating the second organic semiconductor layer on the negative electrode side and the Teflon filter. Alternatively, the device can be formed by: layering a Teflon filter on the first organic semiconductor layer; forming the layer formed from a carbonaceous substance on the Teflon filter; and further layering a Teflon filter on the layer formed from a carbonaceous substance, and then laminating the second organic semiconductor layer on the negative electrode side.

That is, the layer structure can be configured to be in any of the following modes:
positive electrode/first organic semiconductor layer/layer formed from a carbonaceous substance/Teflon filter/second organic semiconductor layer/negative electrode;
positive electrode/first organic semiconductor layer/Teflon filter/layer formed from a carbonaceous substance/second organic semiconductor layer/negative electrode; and
positive electrode/first organic semiconductor layer/Teflon filter/layer formed from a carbonaceous substance/Teflon filter/second organic semiconductor layer/negative electrode.

Taking any of these modes is preferable in view of suppressing diffusion of the carbonaceous substance in the middle layer, diffusion of the organic semiconductor substance on the positive electrode side, and diffusion of the organic semiconductor substance on the negative electrode side without preventing the charge carriers (ions, electrons, and holes) from moving.

Preferably, a pressing force of approximately 1,200 hPa to 1,500 hPa is applied to the positive electrode/first organic semiconductor layer/layer formed from a carbonaceous substance/second organic semiconductor layer/negative electrode, which is formed by the lamination, and preferably, this state is retained for 60 minutes to 120 minutes whereby the first organic semiconductor layer/layer formed from a carbonaceous substance/second organic semiconductor layer can be adhered.

The organic semiconductor layers can be united into one body more effectively by heating in addition when laminated. Preferably, heating may be performed at a temperature in the range of 50°C to 140°C.

### <Thermoelectric Conversion Method (Fourth Embodiment)>

According to the thermoelectric conversion method of the present invention, heat energy can be converted to electrical energy just by the step of disposing the aforementioned thermoelectric conversion device in the presence of a heat energy flow that realizes a certain thermal environment. That is, conventional methods based on the Seebeck effect require making a temperature difference between the positive electrode and the negative electrode, whereas the method of the present application requires no temperature difference but the thermoelectric conversion device is just disposed in a thermal environment at a certain temperature in the presence of a heat energy flow.

A thermal environment at a certain temperature in the presence of a heat energy flow may be any environment as long as being a thermal environment so as to give the thermoelectric conversion device a certain amount of heat energy, and preferably the atmosphere at 20°C (room temperature) or higher, more preferably the atmosphere at 25°C or higher, further preferably the atmosphere at 30°C or higher, particularly preferably the atmosphere at 35°C or higher, and most preferably the atmosphere at 40°C or higher, etc. can be applied. This is the phenomenon understandable by comparison with a certain photoirradiation environment in the presence of a light energy flow in solar cells, where electrons and holes excited by light energy move inside the device, and is a physically understandable phenomenon. When the light energy flow stops, the function of generating electromotive force in the solar cells stops, whereas a decrease in inflow of a heat energy flow in the thermoelectric conversion method of the present invention corresponds to the stop of the light energy flow in the solar cells, and is understandable by comparison with deterioration of the function of generating electromotive force. It is noted that the phenomenon of generating electromotive force does not suddenly become zero since the energy distributions of atoms and molecules that carry the heat energy flow are not instantly into zero states, but are gradually attenuating, which is different from the stop of photoirradiation.

Even an environment in a gaseous atmosphere other than the atmosphere, for example, an environment in an inert gas such as nitrogen can be considered to be an environment that can give the thermoelectric conversion device heat energy as long as the temperature is the same as the above. Further, the environment may be in an atmosphere excluding gas, for example, may be in a liquid such as water. In view of efficiently giving thermoelectric conversion device heat energy, it is considered to be preferable to dispose the thermoelectric conversion device in a watery atmosphere at a predetermined temperature. As a thermal environment in water, preferably water at 20°C (room temperature) or higher, more preferably water at 25°C or higher, further preferably water at 30°C or higher, particularly preferably water at 35°C or higher, and most preferably water at 40°C or higher, etc. can be applied.

Other than water, any organic solvent such as alcohols at a temperature equal to or higher than the aforementioned temperatures may be applied.

That is, any environment where thermal vibration of atoms and molecules can be conducted may be applied.

### Examples

Hereinafter examples of resin compositions in the present invention are described. The present invention is not limited to the following examples unless deviating from the gist thereof.

### [First Embodiment]

### <Materials Used herein>

The materials used in the following examples etc. were as follows.

### (Iron Phthalocyanine (FePc))

Phthalocyanine (hereinafter may be abbreviated to Pc) is a cyclic compound having a structure of four phthalic imides linked by nitrogen atoms that is similar to the structure of porphyrin. The central part of phthalocyanine can form a stable complex with any of various elements such as transition metals. Because of delocalization of π-conjugated systems in a molecule thereof, phthalocyanine has a planar structure, and presents an intense color. A molecule formed of a complex of this central part of phthalocyanine and an iron atom is iron phthalocyanine (FePc). Iron phthalocyanine is a dark purple powder represented by the molecular formula, C₃₂H₁₆N₈Fe, has a molecular weight of 568.38, and is insoluble in water. Like copper phthalocyanine (CuPc), iron phthalocyanine is used as an organic semiconductor. In the present invention, iron phthalocyanine was used as an organic semiconductor as a material that emitted electrons and holes (hole and electron emitting material) by thermal excitation. P0774 by Tokyo Chemical Industry Co., Ltd. was used as iron phthalocyanine.

The structural formula of iron phthalocyanine (FePc) is as follows. Fig. 3 shows the measured light absorption spectrum.

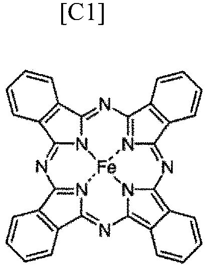

### (Zinc Phthalocyanine (ZnPc))

A molecule of a complex formed of the central part of phthalocyanine and a zinc atom is zinc phthalocyanine (ZnPc). Zinc phthalocyanine (ZnPc) is a powder having a color of a dark red to a dark purple to a dark blue and represented by the molecular formula, C₃₂H₁₆N₈Zn, has a molecular weight of 577.92, and is insoluble in water. Like copper phthalocyanine (CuPc), zinc phthalocyanine is used as an organic semiconductor. In the present invention, zinc phthalocyanine was used as an organic semiconductor as a material that emitted electrons and holes (hole and electron emitting material) by thermal excitation. P0767 by Tokyo Chemical Industry Co., Ltd. was used as zinc phthalocyanine.

The structural formula, and the measured light absorption spectrum of zinc phthalocyanine (ZnPc) are as follows. Fig. 4 shows the measured light absorption spectrum.

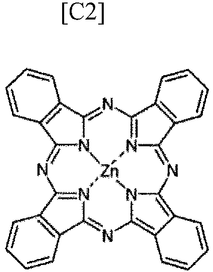

### (Tin Doped Indium Oxide (ITO) Glass)

A tin doped indium oxide (ITO) glass is a transparent conductive glass. A tin doped indium oxide (ITO) glass is obtained by forming a thin film of a tin doped indium oxide on a glass substrate that is an insulator, thereby having conductivity, and is used as a transparent electrode. In the present invention, TCO 1001 by Geomatec Co., Ltd. was used as an electrode substrate.

### (Chloroform)

Chloroform is an alkyl halide, and the IUPAC name thereof is trichloromethane. Chloroform is a colorless transparent liquid having a molecular weight of 119.38 and represented by the molecular formula, CHCl₃, and has a sweet taste and an intense sweet odor. Chloroform volatilizes readily, but is widely used as a solvent since many organic compounds are well soluble therein. In the present invention, 08402-55 by Nacalai Tesque, Inc. was used as an organic solvent.

### (Polyoxyethylene Sorbitan Monostearate)

Polyoxyethylene sorbitan monostearate is a pale yellow solid. The melting point of polyoxyethylene sorbitan monostearate is 20 to 24°C, and is stored as a vaseline-like solid at normal temperature. The principal uses of polyoxyethylene sorbitan monostearate are medical or cosmetic emulsifiers, solubilizers, color material solubilizers, and stabilizers for emulsion polymerization. In the present invention, polyoxyethylene sorbitan monostearate was used for adjusting the viscosity of a chloroform suspension of a material that emitted electrons and holes (hole and electron emitting material, or organic semiconductor) by thermal excitation, and as a transport medium for the charge carriers that were emitted from the organic semiconductor to be dispersed. As polyoxyethylene sorbitan monostearate, 35702-85 by Nacalai Tesque, Inc. was used.

### (Graphite)

Graphite is a dark gray-black powder, which is also called black lead, and is substantially insoluble in water. Graphite has conductivity and lubricity, and the principal uses thereof are synthetic materials, functional materials, synthetic resin additives, lubricants, release agents, etc. In the present invention, 070-01325 by FUJIFILM Wako Pure Chemical Corporation was used as a charge transport layer.

### <Preparing Mixed Solutions Containing Organic Semiconductors>

A FePc solution was prepared by mixing 0.5 g of a FePc powder, 3 mL of chloroform, and 1 mL of polyoxyethylene sorbitan monostearate in a vial bottle. A ZnPc solution was prepared by mixing 1.0 g of a ZnPc powder, 3 mL of chloroform, and 1 mL of polyoxyethylene sorbitan monostearate in a vial bottle. The solutions were each stirred with a vortex mixer, and thereafter, kept at 40°C or higher, so that polyoxyethylene sorbitan monostearate in the solutions did not solidify.

### <Forming Organic Semiconductor Layers>

Within 10 mm × 15 mm center areas of a substrate of the ITO glass and an Al substrate, 60 µL of the respective prepared mixed solutions were dropped. After air-drying, the substrates were each heated in an electric furnace at 140°C for 2 hours. For the electric furnace, an economic long-type electric furnace with program features, ROP-002P by AS ONE Corporation was used.

By this step, an ITO substrate/organic semiconductor layer (FePc), an ITO substrate/organic semiconductor layer (ZnPc), an Al substrate/organic semiconductor layer (FePc), and an Al substrate/organic semiconductor layer (ZnPc) were prepared.

### <Example 1-1>

A thermoelectric conversion device made of an ITO substrate/organic semiconductor layer (FePc)/organic semiconductor layer (FePc)/Al substrate was prepared by laminating the prepared ITO substrate/organic semiconductor layer (FePc) and Al substrate/organic semiconductor layer (FePc) so as to layer the organic semiconductor layers. The prepared thermoelectric conversion device was sealed with a silicon-based resin, so that the organic semiconductor layers did not protrude when heated in the subsequent thermoelectric conversion measurement.

### <Example 1-2>

A thermoelectric conversion device made of an ITO substrate/organic semiconductor layer (ZnPc)/organic semiconductor layer (ZnPc)/Al substrate was prepared by laminating the prepared ITO substrate/organic semiconductor layer (ZnPc) and Al substrate/organic semiconductor layer (ZnPc) so as to layer the organic semiconductor layers. The prepared thermoelectric conversion device was sealed with a silicon-based resin, so that the organic semiconductor layers did not protrude when heated in the subsequent thermoelectric conversion measurement.

### <Comparative Example 1-1>

A device made of an Al substrate/organic semiconductor layer (FePc)/organic semiconductor layer (FePc)/Al substrate was prepared by laminating the two prepared Al substrate/organic semiconductor layers (FePc) so as to layer the organic semiconductor layers. The prepared device was sealed with a silicon-based resin, so that the organic semiconductor layers did not protrude when heated in the subsequent thermoelectric conversion measurement.

### <Comparative Example 1-2>

A device made of an ITO substrate/organic semiconductor layer (ZnPc)/organic semiconductor layer (ZnPc)/ITO substrate was prepared by laminating the two prepared ITO substrate/organic semiconductor layers (ZnPc) so as to layer the organic semiconductor layers. The prepared device was sealed with a silicon-based resin, so that the organic semiconductor layers did not protrude when heated in the subsequent thermoelectric conversion measurement.

### <Comparative Example 1-3>

In comparative example 1-3, a device was prepared by sandwiching phthalocyanine alone, which includes no metal, between electrodes, and thermoelectric conversion was measured.

In a vial bottle, 0.5 g of a phthalocyanine (Pc) powder, 3 mL of chloroform, and 1 mL of polyoxyethylene sorbitan monostearate were mixed and prepared. Within a 10 mm × 15 mm center area of each of a substrate of the ITO glass and an Al substrate, 60 µL of the resultant was dropped. After air-drying, the substrates were each heated in an electric furnace at 140°C for 2 hours. For the electric furnace, an economic long-type electric furnace with program features, ROP-002P by AS ONE Corporation was used.

By this step, an ITO substrate/phthalocyanine layer (Pc), and an Al substrate/phthalocyanine layer (Pc) were prepared.

A device made of an ITO substrate/phthalocyanine layer (Pc)/phthalocyanine layer (Pc)/Al substrate was prepared by laminating the prepared ITO substrate/phthalocyanine layer (Pc) and Al substrate/phthalocyanine layer (Pc) so as to layer the phthalocyanine layers. The prepared device was sealed with a silicon-based resin, so that the phthalocyanine layers did not protrude when heated in the subsequent thermoelectric conversion measurement.

### <Comparative Example 1-4>

In comparative example 1-4, a device was prepared by sandwiching phthalonitrile, which was a component of phthalocyanine and included no metal, between electrodes, and thermoelectric conversion was measured.

In a vial bottle, 0.5 g of a phthalonitrile (PN) powder, 3 mL of chloroform, and 1 mL of polyoxyethylene sorbitan monostearate were mixed and prepared. Within a 10 mm × 15 mm center area of each of a substrate of the ITO glass and an Al substrate, 60 µL of the resultant was dropped. After air-drying, the substrates were each heated in an electric furnace at 140°C for 2 hours. For the electric furnace, an economic long-type electric furnace with program features, ROP-002P by AS ONE Corporation was used.

By this step, an ITO substrate/phthalonitrile layer (PN), and an Al substrate/phthalonitrile layer (PN) were prepared.

A device made of an ITO substrate/phthalonitrile layer (PN)/phthalonitrile layer (PN)/Al substrate was prepared by laminating the prepared ITO substrate/phthalonitrile layer (PN) and Al substrate/phthalonitrile layer (PN) so as to layer the phthalonitrile layers. The prepared device was sealed with a silicon-based resin, so that the phthalonitrile layers did not protrude when heated in the subsequent thermoelectric conversion measurement.

### <Measuring Electrical Energy in Thermoelectric Conversion>

A measuring circuit as shown in Fig. 5 was assembled for measuring electrical energy that could be taken out of heat energy in a thermal equilibrium state in a certain thermal environment at a specific temperature T (K) concerning the devices prepared in the foregoing examples and comparative examples. Here, a measurement system was configured by connecting two units each constituted of a digital multimeter and a PC so as to be capable of observing changes over time in measurement value of each of the current and the voltage when the current and the voltage were measured. The circuit was designed in a state of incorporating a variable resistance, and the resistance was set to 110 Ω. The temperature of the device and therearound was set to 20°C (room temperature).

Fig. 6(a) shows the measurement results of the voltage of the device of comparative example 1-1, and Fig. 6(b) shows the measurement results of the current of the device of comparative example 1-1.

Fig. 7(a) shows the measurement results of the voltage of the device of comparative example 1-2, and Fig. 7(b) shows the measurement results of the current of the device of comparative example 1-2.

Fig. 8(a) shows the measurement results of the voltage of the device of example 1-1, and Fig. 8(b) shows the measurement results of the current of the device of example 1-1.

Fig. 9(a) shows the measurement results of the voltage of the device of example 1-2, and Fig. 9(b) shows the measurement results of the current of the device of example 1-2.

Fig. 10 shows the measurement results of the current and the voltage of the device of comparative example 1-3.

Fig. 11 shows the measurement results of the current and the voltage of the device of comparative example 1-4.

The foregoing results proved that in examples 1-1 and 1-2, the voltages and the currents of the devices were each fixed, and electric power was obtained.

In contrast, it was proved that in comparative examples 1-1 and 1-2, the voltages of the devices attenuated, the currents were zero, that is, did not flow, and electric power was not obtained. In short, it was shown that it was necessary to make the positive electrode and the negative electrode from materials of different conductivities to create an internal electric field between the electrodes in order to generate electromotive force.

It was also proved that in comparative examples 3 and 4, the voltages of the devices attenuated, the currents were zero, that is, did not flow, and electric power was not obtained. In short, it was shown that an organic semiconductor layer provided with a material that generated electrons and holes by thermal excitation was necessary between predetermined electrodes in order to generate electromotive force.

It was also shown that using the thermoelectric conversion device of the present invention allowed heat energy to be converted to electrical energy in a certain thermal environment in the presence of a heat energy flow.

### [Second Embodiment]

### <Materials Used herein>

The materials used in the following examples etc. were as follows.

### (Iron Phthalocyanine (FePc))

Phthalocyanine (hereinafter may be abbreviated to Pc) is a cyclic compound having a structure of four phthalic imides linked by nitrogen atoms that is similar to the structure of porphyrin. The central part of phthalocyanine can form a stable complex with any of various elements such as transition metals. Because of delocalization of π-conjugated systems in a molecule thereof, phthalocyanine has a planar structure, and presents an intense color. A molecule formed of a complex of this central part of phthalocyanine and an iron atom is iron phthalocyanine (FePc). Iron phthalocyanine is a dark purple powder represented by the molecular formula, C₃₂H₁₆N₈Fe, has a molecular weight of 568.38, and is insoluble in water. Like copper phthalocyanine (CuPc), iron phthalocyanine is used as an organic semiconductor. In the present invention, iron phthalocyanine was used as an organic semiconductor as a material that emitted electrons and holes (hole and electron emitting material) by thermal excitation. P0774 by Tokyo Chemical Industry Co., Ltd. was used as iron phthalocyanine.

The structural formula of iron phthalocyanine (FePc) is as follows. Fig. 3 shows the measured light absorption spectrum.

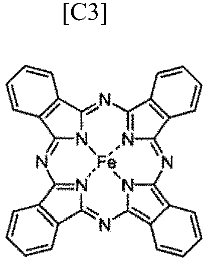

### (Zinc Phthalocyanine (ZnPc))

A molecule of a complex formed of the central part of phthalocyanine and a zinc atom is zinc phthalocyanine (ZnPc). Zinc phthalocyanine (ZnPc) is a powder having a color of a dark red to a dark purple to a dark blue and represented by the molecular formula, C₃₂H₁₆N₈Zn, has a molecular weight of 577.92, and is insoluble in water. Like copper phthalocyanine (CuPc), zinc phthalocyanine is used as an organic semiconductor. In the present invention, zinc phthalocyanine was used as an organic semiconductor as a material that emitted electrons and holes (hole and electron emitting material) by thermal excitation. P0767 by Tokyo Chemical Industry Co., Ltd. was used as zinc phthalocyanine.

The structural formula, and the measured light absorption spectrum of zinc phthalocyanine (ZnPc) are as follows. Fig. 4 shows the measured light absorption spectrum.

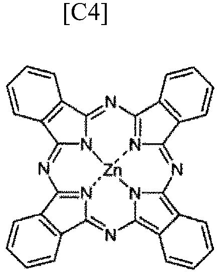

### (Tin Doped Indium Oxide (ITO) Glass)

A tin doped indium oxide (ITO) glass is a transparent conductive glass. A tin doped indium oxide (ITO) glass is obtained by forming a thin film of a tin doped indium oxide on a glass substrate that is an insulator, thereby having conductivity, and is used as a transparent electrode. In the present invention, TCO 1001 by Geomatec Co., Ltd. was used as an electrode substrate.

### (Chloroform)

Chloroform is an alkyl halide, and the IUPAC name thereof is trichloromethane. Chloroform is a colorless transparent liquid having a molecular weight of 119.38 and represented by the molecular formula, CHCl₃, and has a sweet taste and an intense sweet odor. Chloroform volatilizes readily, but is widely used as a solvent since many organic compounds are well soluble therein. In the present invention, 08402-55 by Nacalai Tesque, Inc. was used as an organic solvent.

### (Polyoxyethylene Sorbitan Monostearate)

Polyoxyethylene sorbitan monostearate is a pale yellow solid. The melting point of polyoxyethylene sorbitan monostearate is 20 to 24°C, and is stored as a vaseline-like solid at normal temperature. The principal uses of polyoxyethylene sorbitan monostearate are medical or cosmetic emulsifiers, solubilizers, color material solubilizers, and stabilizers for emulsion polymerization. In the present invention, polyoxyethylene sorbitan monostearate was used for adjusting the viscosity of a chloroform suspension of a material that emitted electrons and holes (hole and electron emitting material, or organic semiconductor) by thermal excitation, and as a transport medium for the charge carriers that were emitted from the organic semiconductor to be dispersed. As polyoxyethylene sorbitan monostearate, 35702-85 by Nacalai Tesque, Inc. was used.

### (Graphite)

Graphite is a dark gray-black powder, which is also called black lead, and is substantially insoluble in water. Graphite has conductivity and lubricity, and the principal uses thereof are synthetic materials, functional materials, synthetic resin additives, lubricants, release agents, etc. In the present invention, 070-01325 by FUJIFILM Wako Pure Chemical Corporation was used as a charge transport layer.

### <Preparing Mixed Solutions Containing Organic Semiconductors>

A FePc solution was prepared by mixing 0.5 g of a FePc powder, 3 mL of chloroform, and 1 mL of polyoxyethylene sorbitan monostearate in a vial bottle. A ZnPc solution was prepared by mixing 1.0 g of a ZnPc powder, 3 mL of chloroform, and 1 mL of polyoxyethylene sorbitan monostearate in a vial bottle. The solutions were each stirred with a vortex mixer, and thereafter, kept at 40°C or higher, so that polyoxyethylene sorbitan monostearate in the solutions did not solidify.

### <Forming Organic Semiconductor Layers>

Within 10 mm × 15 mm center areas of a substrate of the ITO glass and an Al substrate, 60 µL of the respective prepared mixed solutions were dropped. After air-drying, the substrates were each heated in an electric furnace at 140°C for 2 hours. For the electric furnace, an economic long-type electric furnace with program features, ROP-002P by AS ONE Corporation was used.

By this step, an ITO substrate/organic semiconductor layer (FePc), an ITO substrate/organic semiconductor layer (ZnPc), an Al substrate/organic semiconductor layer (FePc), and an Al substrate/organic semiconductor layer (ZnPc) were prepared.

### <Example 2-1>

A thermoelectric conversion device made of an ITO substrate/organic semiconductor layer (FePc)/organic semiconductor layer (ZnPc)/Al substrate was prepared by laminating the prepared ITO substrate/organic semiconductor layer (FePc) and Al substrate/organic semiconductor layer (ZnPc) so as to layer the organic semiconductor layers. The prepared thermoelectric conversion device was sealed with a silicon-based resin, so that the organic semiconductor layers did not protrude when heated in the subsequent thermoelectric conversion measurement.

### <Comparative Example 2-1>

A device made of an Al substrate/organic semiconductor layer (FePc)/organic semiconductor layer (FePc)/Al substrate was prepared by laminating the two prepared Al substrate/organic semiconductor layers (FePc) so as to layer the organic semiconductor layers. The prepared device was sealed with a silicon-based resin, so that the organic semiconductor layers did not protrude when heated in the subsequent thermoelectric conversion measurement.

### <Comparative Example 2-2>

A device made of an ITO substrate/organic semiconductor layer (ZnPc)/organic semiconductor layer (ZnPc)/ITO substrate was prepared by laminating the two prepared ITO substrate/organic semiconductor layers (ZnPc) so as to layer the organic semiconductor layers. The prepared device was sealed with a silicon-based resin, so that the organic semiconductor layers did not protrude when heated in the subsequent thermoelectric conversion measurement.

### <Comparative Example 2-3>

In comparative example 3, a device was prepared by sandwiching phthalocyanine alone, which includes no metal, between electrodes, and thermoelectric conversion was measured.

In a vial bottle, 0.5 g of a phthalocyanine (Pc) powder, 3 mL of chloroform, and 1 mL of polyoxyethylene sorbitan monostearate were mixed and prepared. Within a 10 mm × 15 mm center area of each of a substrate of the ITO glass and an Al substrate, 60 µL of the resultant was dropped. After air-drying, the substrates were each heated in an electric furnace at 140°C for 2 hours. For the electric furnace, an economic long-type electric furnace with program features, ROP-002P by AS ONE Corporation was used.

By this step, an ITO substrate/phthalocyanine layer (Pc), and an Al substrate/phthalocyanine layer (Pc) were prepared.

A device made of an ITO substrate/phthalocyanine layer (Pc)/phthalocyanine layer (Pc)/Al substrate was prepared by laminating the prepared ITO substrate/phthalocyanine layer (Pc) and Al substrate/phthalocyanine layer (Pc) so as to layer the phthalocyanine layers. The prepared device was sealed with a silicon-based resin, so that the phthalocyanine layers did not protrude when heated in the subsequent thermoelectric conversion measurement.

### <Comparative Example 2-4>

In comparative example 2-4, a device was prepared by sandwiching phthalonitrile, which was a component of phthalocyanine and included no metal, between electrodes, and thermoelectric conversion was measured.

In a vial bottle, 0.5 g of a phthalonitrile (PN) powder, 3 mL of chloroform, and 1 mL of polyoxyethylene sorbitan monostearate were mixed and prepared. Within a 10 mm × 15 mm center area of each of a substrate of the ITO glass and an Al substrate, 60 µL of the resultant was dropped. After air-drying, the substrates were each heated in an electric furnace at 140°C for 2 hours. For the electric furnace, an economic long-type electric furnace with program features, ROP-002P by AS ONE Corporation was used.

By this step, an ITO substrate/phthalonitrile layer (PN), and an Al substrate/phthalonitrile layer (PN) were prepared.

A device made of an ITO substrate/phthalonitrile layer (PN)/phthalonitrile layer (PN)/Al substrate was prepared by laminating the prepared ITO substrate/phthalonitrile layer (PN) and Al substrate/phthalonitrile layer (PN) so as to layer the phthalonitrile layers. The prepared device was sealed with a silicon-based resin, so that the phthalonitrile layers did not protrude when heated in the subsequent thermoelectric conversion measurement.

### <Comparative Example 2-5>

A thermoelectric conversion device made of an ITO substrate/organic semiconductor layer (ZnPc)/organic semiconductor layer (FePc)/Al substrate was prepared by laminating the prepared ITO substrate/organic semiconductor layer (ZnPc) and Al substrate/organic semiconductor layer (FePc) so as to layer the organic semiconductor layers. The prepared thermoelectric conversion device was sealed with a silicon-based resin, so that the organic semiconductor layers did not protrude when heated in the subsequent thermoelectric conversion measurement.

### <Measuring Electrical Energy in Thermoelectric Conversion>

A measuring circuit as shown in Fig. 16 was assembled for measuring electrical energy that could be taken out of heat energy in a thermal equilibrium state in a certain thermal environment at a specific temperature T (K) concerning the devices prepared in the foregoing examples and comparative examples. Here, a measurement system was configured by connecting two units each constituted of a digital multimeter and a PC so as to be capable of observing changes over time in measurement value of each of the current and the voltage when the current and the voltage were measured. The circuit was designed in a state of incorporating a variable resistance. The temperature of the device and therearound was set to 20°C (room temperature).

In comparative examples 2-1 to 2-4, the resistance was set to 110 Ω. In example 2-1 and comparative example 2-5, the measurement was performed as the resistance was changed to 110 Ω, 10 kΩ, 100 kΩ and 500 kΩ.

Fig. 17(a) shows the measurement results of the voltage of the device of comparative example 2-1, and Fig. 17(b) shows the measurement results of the current of the device of comparative example 2-1.

Fig. 18(a) shows the measurement results of the voltage of the device of comparative example 2-2, and Fig. 18(b) shows the measurement results of the current of the device of comparative example 2-2.

Fig. 19 shows the measurement results of the current and the voltage of the device of comparative example 2-3.

Fig. 20 shows the measurement results of the current and the voltage of the device of comparative example 2-4.

Fig. 21(a) shows the current values to the temperature in example 2-1, Fig. 21(b) shows the voltage values to the temperature in example 2-1, and Fig. 21(c) shows the electric power values to the temperature in example 2-1.

Fig. 22(a) shows the current values to the temperature in comparative example 2-5, Fig. 22(b) shows the voltage values to the temperature in comparative example 2-5, and Fig. 22(c) shows the electric power values to the temperature in comparative example 2-5.

Fig. 23(a) shows the obtained electric power to the temperature when the variable resistance was 10 kΩ in each of example 2-1 and comparative example 2-5, and Fig. 23(b) shows the obtained electric power values to the temperature when the variable resistance was 100 kΩ in each of example 2-1 and comparative example 2-5.

The foregoing results proved that in comparative examples 2-1 and 2-2, the voltages of the devices attenuated, the currents were zero, that is, did not flow, and electric power was not obtained. In short, it was shown that it was necessary to make the positive electrode and the negative electrode from materials of different conductivities to create an internal electric field between the electrodes in order to generate electromotive force.

It was also proved that in comparative examples 2-3 and 2-4, the voltages of the devices attenuated, the currents were zero, that is, did not flow, and electric power was not obtained. In short, it was shown that an organic semiconductor layer provided with a material that generated electrons and holes by thermal excitation was necessary between predetermined electrodes in order to generate electromotive force.

In contrast, it was confirmed that as shown in Figs. 21(a) and 21(b), the measurement values of the current value and the voltage value in example 2-1 increased depending on the temperature, and when the resistance was lower, were at the maximum points at 120°C or 140°C and started decreasing at a temperature higher than 120°C or 140°C. It was also confirmed that when the resistance was higher, these measurement values were at the maximum points at 100°C or 120°C and started decreasing at a temperature higher than 100°C or 120°C.

Based on Fig. 21(c), the electricity generating amount was the largest at 120°C when the resistance was 10 kΩ, and was calculated as 11.868 µW. It was also proved that, at 20°C to 80°C, a more electric power could be taken out in the measurement when the resistance was 100 kΩ than in the measurement when the resistance was 10 kΩ.

In comparative example 2-5, based on Figs. 22(a) and 22(b), changes in measurement value approximately the same as those of the ITO/FePc/ZnPc/Al-type device in example 2-1 were observed. However, both the current and the voltage values were relatively low at any temperatures. Based on Fig. 22(c), the electricity generating amount was the largest at 140°C when the resistance was 10 kΩ, and was calculated as 5.244 µW. It was also proved that: at 100°C or lower, a more electric power could be taken out in the measurement when the resistance was 100 kΩ than in the measurement when the resistance was 10 kΩ; and at 40°C or lower, a more electric power could be taken out in the measurement when the resistance was 500 kΩ. That is, it was considered that as the temperature was lower, a circuit with a higher resistance generates a more electric power.

Figs. 23(a) and 23(b) show the comparison of electric power between the thermoelectric conversion device of example 2-1 and that of comparative example 5 when the resistances were 10 kΩ and 100 kΩ, respectively, where especially a large electric power was calculated. This proved that the difference in electricity generating amount was a few times as large when the temperature was higher. As described, the comparison in current value between example 1 and comparative example 5 proved that the thermoelectric conversion device of the present invention allowed electric power to be more efficiently obtained.

### <Example 2-2>

Performance changes when a plurality of the thermoelectric conversion devices of example 2-1 were connected were examined.

Fig. 24 shows the current value changes and the voltage value changes when a plurality of the thermoelectric conversion devices of example 2-1 were connected. Both the current and the voltage measurement values linearly increased in proportion to the number of the devices as the number of the devices were increased to be 3, 4, 6 and 8 in the circuit with the resistance of 500 kΩ at room temperature (21°C). Thus, it was considered to be confirmed that the devices each functioned as a cell.

### [Third Embodiment]

### <Materials Used herein>

The materials used in the following examples etc. were as follows.

### (Iron Phthalocyanine (FePc))

Phthalocyanine (hereinafter may be abbreviated to Pc) is a cyclic compound having a structure of four phthalic imides linked by nitrogen atoms that is similar to the structure of porphyrin. The central part of phthalocyanine can form a stable complex with any of various elements such as transition metals. Because of delocalization of π-conjugated systems in a molecule thereof, phthalocyanine has a planar structure, and presents an intense color. A molecule formed of a complex of this central part of phthalocyanine and an iron atom is iron phthalocyanine (FePc). Iron phthalocyanine is a dark purple powder represented by the molecular formula, C₃₂H₁₆N₈Fe, has a molecular weight of 568.38, and is insoluble in water. Like copper phthalocyanine (CuPc), iron phthalocyanine is used as an organic semiconductor. In the present invention, iron phthalocyanine was used as an organic semiconductor as a material that emitted electrons and holes (hole and electron emitting material) by thermal excitation. P0774 by Tokyo Chemical Industry Co., Ltd. was used as iron phthalocyanine.

The structural formula of iron phthalocyanine (FePc) is as follows. Fig. 4 shows the measured light absorption spectrum.

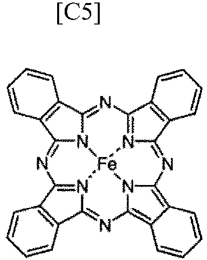

### (Zinc Phthalocyanine (ZnPc))

A molecule of a complex formed of the central part of phthalocyanine and a zinc atom is zinc phthalocyanine (ZnPc). Zinc phthalocyanine (ZnPc) is a powder having a color of a dark red to a dark purple to a dark blue and represented by the molecular formula, C₃₂H₁₆N₈Zn, has a molecular weight of 577.92, and is insoluble in water. Like copper phthalocyanine (CuPc), zinc phthalocyanine was used as an organic semiconductor. In the present invention, zinc phthalocyanine is used as an organic semiconductor as a material that emitted electrons and holes (hole and electron emitting material) by thermal excitation. P0767 by Tokyo Chemical Industry Co., Ltd. was used as zinc phthalocyanine.

The structural formula, and the measured light absorption spectrum of zinc phthalocyanine (ZnPc) are as follows. Fig. 5 shows the measured light absorption spectrum.

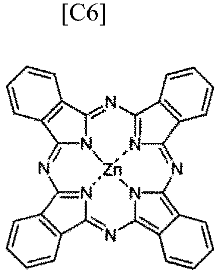

### (Tin Doped Indium Oxide (ITO) Glass)

A tin doped indium oxide (ITO) glass is a transparent conductive glass. A tin doped indium oxide (ITO) glass is obtained by forming a thin film of a tin doped indium oxide on a glass substrate that is an insulator, thereby having conductivity, and is used as a transparent electrode. In the present invention, TCO 1001 by Geomatec Co., Ltd. was used as an electrode substrate.

### (Chloroform)

Chloroform is an alkyl halide, and the IUPAC name thereof is trichloromethane. Chloroform is a colorless transparent liquid having a molecular weight of 119.38 and represented by the molecular formula, CHCl₃, and has a sweet taste and an intense sweet odor. Chloroform volatilizes readily, but is widely used as a solvent since many organic compounds are well soluble therein. In the present invention, 08402-55 by Nacalai Tesque, Inc. was used as an organic solvent.

### (Polyoxyethylene Sorbitan Monostearate)

Polyoxyethylene sorbitan monostearate is a pale yellow solid. The melting point of polyoxyethylene sorbitan monostearate is 20 to 24°C, and is stored as a vaseline-like solid at normal temperature. The principal uses of polyoxyethylene sorbitan monostearate are medical or cosmetic emulsifiers, solubilizers, color material solubilizers, and stabilizers for emulsion polymerization. In the present invention, polyoxyethylene sorbitan monostearate was used for adjusting the viscosity of a chloroform suspension of a material that emitted electrons and holes (hole and electron emitting material, or organic semiconductor) by thermal excitation, and as a transport medium for the charge carriers that were emitted from the organic semiconductor to be dispersed. As polyoxyethylene sorbitan monostearate, 35702-85 by Nacalai Tesque, Inc. was used.

### (Graphite)

Graphite is a dark gray-black powder, which is also called black lead, and is substantially insoluble in water. Graphite has conductivity and lubricity, and the principal uses thereof are synthetic materials, functional materials, synthetic resin additives, lubricants, release agents, etc. In the present invention, 070-01325 by FUJIFILM Wako Pure Chemical Corporation was used as a charge transport layer.

### <Preparing Mixed Solutions Containing Organic Semiconductors>

A FePc solution was prepared by mixing 0.5 g of a FePc powder, 3 mL of chloroform, and 1 mL of polyoxyethylene sorbitan monostearate in a vial bottle. A ZnPc solution was prepared by mixing 1.0 g of a ZnPc powder, 3 mL of chloroform, and 1 mL of polyoxyethylene sorbitan monostearate in a vial bottle. The solutions were each stirred with a vortex mixer, and thereafter, kept at 40°C or higher, so that polyoxyethylene sorbitan monostearate in the solutions did not solidify.

### <Forming Organic Semiconductor Layers>

Within 10 mm × 15 mm center areas of a substrate of the ITO glass and an Al substrate, 60 µL of the respective prepared mixed solutions were dropped. After air-drying, the substrates were each heated in an electric furnace at 140°C for 2 hours. For the electric furnace, an economic long-type electric furnace with program features, ROP-002P by AS ONE Corporation was used.

By this step, an ITO substrate/organic semiconductor layer (FePc), an ITO substrate/organic semiconductor layer (ZnPc), an Al substrate/organic semiconductor layer (FePc), and an Al substrate/organic semiconductor layer (ZnPc) were prepared.

### <Example 3-1>

### (Preparing Mixed Solutions Containing Fe Ions and Organic Semiconductors)

With 0.5 g of a FePc powder, 0.5 g of iron chloride (III) (FeCl₃), which was an equivalent weight, and 0.1 g of 10 mass% lithium carbonate were mixed, and 6 mL of chloroform, and 2 mL of polyoxyethylene sorbitan monostearate were mixed in a 30 mL beaker. An agent was prepared by degassing the resultant in a vacuum dryer during heating to 50°C to remove water molecules, and was used as a mixed solution (A).

With 0.5 g of the ZnPc powder, 0.5 g of iron chloride (II) (FeCl₂), which was an equivalent weight, and 0.1 g of 10 mass% lithium carbonate were mixed, and 6 mL of chloroform, and 2 mL of polyoxyethylene sorbitan monostearate were mixed in a 30 mL beaker. An agent was prepared by degassing the resultant in a vacuum dryer during heating to 50°C to remove water molecules, and was used as a mixed solution (B).

### (Forming Organic Semiconductor Layers Containing Fe Ions, and Thermoelectric Conversion Device)

Next, 0.1 g of the mixed solution (A) was layered on a substrate of the ITO glass, 0.1 g of the mixed solution (B) was layered on an Al substrate, and both were stacked to form a device. The area of the device was set to 10 cm². Sealing with a silicon resin was performed, so that the compounds inside did not leak.

### (Measuring Electrical Energy in Thermoelectric Conversion)

In order to measure the electricity generation performance, the following measurement was performed after 24 hours had passed since the sealing.

While two digital multimeters of measuring instruments, all the leading wires forming a circuit, and the device were put in the same large tray (50 cm × 30 cm × 20 cm), the operation of rising the temperature to 50°C was brought into and ceased repeatedly. The circuit load during the measurement was 110 Ω.

As a result of this, the results as in Fig. 30 were obtained.

The current value reached 1,800 µA, decreased in the time period when the inflow of the heat flow was stopped, and increased in the temperature rising process by the inflow of the heat flow again.

This device performance evaluation proved that the generated electrical energy exceeded 1 mW. This electricity generation performance showed a greater degree of thermoelectric conversion characteristics than that of the conventionally known thermoelectric device.

### <Comparative Example 3-1>

A device made of an Al substrate/organic semiconductor layer (FePc)/organic semiconductor layer (FePc)/Al substrate was prepared by laminating the two prepared Al substrate/organic semiconductor layers (FePc) so as to layer the organic semiconductor layers. The prepared device was sealed with a silicon-based resin, so that the organic semiconductor layers did not protrude when heated in the subsequent thermoelectric conversion measurement.

### <Comparative Example 3-2>

A device made of an ITO substrate/organic semiconductor layer (ZnPc)/organic semiconductor layer (ZnPc)/ITO substrate was prepared by laminating the two prepared ITO substrate/organic semiconductor layers (ZnPc) so as to layer the organic semiconductor layers. The prepared device was sealed with a silicon-based resin, so that the organic semiconductor layers did not protrude when heated in the subsequent thermoelectric conversion measurement.

### <Comparative Example 3-3>

In comparative example 3-3, a device was prepared by sandwiching phthalocyanine alone, which includes no metal, between electrodes, and thermoelectric conversion was measured.

In a vial bottle, 0.5 g of a phthalocyanine (Pc) powder, 3 mL of chloroform, and 1 mL of polyoxyethylene sorbitan monostearate were mixed and prepared. Within a 10 mm × 15 mm center area of each of a substrate of the ITO glass and an Al substrate, 60 µL of the resultant was dropped. After air-drying, the substrates were each heated in an electric furnace at 140°C for 2 hours. For the electric furnace, an economic long-type electric furnace with program features, ROP-002P by AS ONE Corporation was used.

By this step, an ITO substrate/phthalocyanine layer (Pc), and an Al substrate/phthalocyanine layer (Pc) were prepared.

A device made of an ITO substrate/phthalocyanine layer (Pc)/phthalocyanine layer (Pc)/Al substrate was prepared by laminating the prepared ITO substrate/phthalocyanine layer (Pc) and Al substrate/phthalocyanine layer (Pc) so as to layer the phthalocyanine layers. The prepared device was sealed with a silicon-based resin, so that the phthalocyanine layers did not protrude when heated in the subsequent thermoelectric conversion measurement.

### <Comparative Example 3-4>

In comparative example 3-4, a device was prepared by sandwiching phthalonitrile, which was a component of phthalocyanine and included no metal, between electrodes, and thermoelectric conversion was measured.

In a vial bottle, 0.5 g of a phthalonitrile (PN) powder, 3 mL of chloroform, and 1 mL of polyoxyethylene sorbitan monostearate were mixed and prepared. Within a 10 mm × 15 mm center area of each of a substrate of the ITO glass and an Al substrate, 60 µL of the resultant was dropped. After air-drying, the substrates were each heated in an electric furnace at 140°C for 2 hours. For the electric furnace, an economic long-type electric furnace with program features, ROP-002P by AS ONE Corporation was used.

By this step, an ITO substrate/phthalonitrile layer (PN), and an Al substrate/phthalonitrile layer (PN) were prepared.

A device made of an ITO substrate/phthalonitrile layer (PN)/phthalonitrile layer (PN)/Al substrate was prepared by laminating the prepared ITO substrate/phthalonitrile layer (PN) and Al substrate/phthalonitrile layer (PN) so as to layer the phthalonitrile layers. The prepared device was sealed with a silicon-based resin, so that the phthalonitrile layers did not protrude when heated in the subsequent thermoelectric conversion measurement.

### <Measuring Electrical Energy in Thermoelectric Conversion>

A measuring circuit as shown in Fig. 7 was assembled for measuring electrical energy that could be taken out of heat energy in a thermal equilibrium state in a certain thermal environment at a specific temperature T (K) concerning the devices prepared in comparative examples 3-1 to 3-4. Here, a measurement system was configured by connecting two units each constituted of a digital multimeter and a PC so as to be capable of observing changes over time in measurement value of each of the current and the voltage when the current and the voltage were measured. The circuit was designed in a state of incorporating a variable resistance. The temperature of the device and therearound was set to 20°C (room temperature).

In comparative examples 3-1 to 3-4, the resistance was set to 110 Ω.

Fig. 32(a) shows the measurement results of the voltage of the device of comparative example 3-1, and Fig. 32(b) shows the measurement results of the current of the device of comparative example 3-1.

Fig. 33(a) shows the measurement results of the voltage of the device of comparative example 3-2, and Fig. 33(b) shows the measurement results of the current of the device of comparative example 3-2.

Fig. 34 shows the measurement results of the current and the voltage of the device of comparative example 3-3.

Fig. 35 shows the measurement results of the current and the voltage of the device of comparative example 3-4.

The foregoing results proved that in comparative examples 3-1 and 3-2, the voltages of the devices attenuated, the currents were zero, that is, did not flow, and electric power was not obtained. In short, it was shown that it was necessary to make the positive electrode and the negative electrode from materials of different conductivities to create an internal electric field between the electrodes in order to generate electromotive force.

It was also proved that in comparative examples 3-3 and 3-4, the voltages of the devices attenuated, the currents were zero, that is, did not flow, and electric power was not obtained. In short, it was shown that an organic semiconductor layer provided with a material that generated electrons and holes by thermal excitation was necessary between predetermined electrodes in order to generate electromotive force.

### [Fourth Embodiment]

### <Materials Used herein>

The materials used in the following examples etc. were as follows.

### (Iron Phthalocyanine (FePc))

Phthalocyanine (hereinafter may be abbreviated to Pc) is a cyclic compound having a structure of four phthalic imides linked by nitrogen atoms that is similar to the structure of porphyrin. The central part of phthalocyanine can form a stable complex with any of various elements such as transition metals. Because of delocalization of π-conjugated systems in a molecule thereof, phthalocyanine has a planar structure, and presents an intense color. A molecule formed of a complex of this central part of phthalocyanine and an iron atom is iron phthalocyanine (FePc). Iron phthalocyanine is a dark purple powder represented by the molecular formula, C₃₂H₁₆N₈Fe, has a molecular weight of 568.38, and is insoluble in water. Like copper phthalocyanine (CuPc), iron phthalocyanine is used as an organic semiconductor. In the present invention, iron phthalocyanine was used as an organic semiconductor as a material that emitted electrons and holes (hole and electron emitting material) by thermal excitation. P0774 by Tokyo Chemical Industry Co., Ltd. was used as iron phthalocyanine.

The structural formula of iron phthalocyanine (FePc) is as follows. Fig. 3 shows the measured light absorption spectrum.

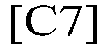

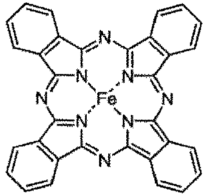

### (Zinc Phthalocyanine (ZnPc))

A molecule of a complex formed of the central part of phthalocyanine and a zinc atom is zinc phthalocyanine (ZnPc). Zinc phthalocyanine (ZnPc) is a powder having a color of a dark red to a dark purple to a dark blue and represented by the molecular formula, C₃₂H₁₆N₈Zn, has a molecular weight of 577.92, and is insoluble in water. Like copper phthalocyanine (CuPc), zinc phthalocyanine is used as an organic semiconductor. In the present invention, zinc phthalocyanine was used as an organic semiconductor as a material that emitted electrons and holes (hole and electron emitting material) by thermal excitation. P0767 by Tokyo Chemical Industry Co., Ltd. was used as zinc phthalocyanine.

The structural formula, and the measured light absorption spectrum of zinc phthalocyanine (ZnPc) are as follows. Fig. 4 shows the measured light absorption spectrum.

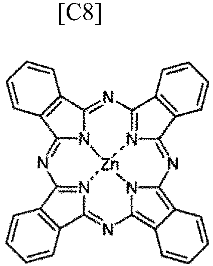

### (Tin Doped Indium Oxide (ITO) Glass)

A tin doped indium oxide (ITO) glass is a transparent conductive glass. A tin doped indium oxide (ITO) glass is obtained by forming a thin film of a tin doped indium oxide on a glass substrate that is an insulator, thereby having conductivity, and is used as a transparent electrode. In the present invention, TCO 1001 by Geomatec Co., Ltd. was used as an electrode substrate.

### (Chloroform)

Chloroform is an alkyl halide, and the IUPAC name thereof is trichloromethane. Chloroform is a colorless transparent liquid having a molecular weight of 119.38 and represented by the molecular formula, CHCl₃, and has a sweet taste and an intense sweet odor. Chloroform volatilizes readily, but is widely used as a solvent since many organic compounds are well soluble therein. In the present invention, 08402-55 by Nacalai Tesque, Inc. was used as an organic solvent.

### (Polyoxyethylene Sorbitan Monostearate)

Polyoxyethylene sorbitan monostearate is a pale yellow solid. The melting point of polyoxyethylene sorbitan monostearate is 20 to 24°C, and is stored as a vaseline-like solid at normal temperature. The principal uses of polyoxyethylene sorbitan monostearate are medical or cosmetic emulsifiers, solubilizers, color material solubilizers, and stabilizers for emulsion polymerization. In the present invention, polyoxyethylene sorbitan monostearate was used for adjusting the viscosity of a chloroform suspension of a material that emitted electrons and holes (hole and electron emitting material, or organic semiconductor) by thermal excitation, and as a transport medium for the charge carriers that were emitted from the organic semiconductor to be dispersed. As polyoxyethylene sorbitan monostearate, 35702-85 by Nacalai Tesque, Inc. was used.

### (Graphite)

Graphite is a dark gray-black powder, which is also called black lead, and is substantially insoluble in water. Graphite has conductivity and lubricity, and the principal uses thereof are synthetic materials, functional materials, synthetic resin additives, lubricants, release agents, etc. In the present invention, 070-01325 by FUJIFILM Wako Pure Chemical Corporation was used as a charge transport layer.

### <Preparing Mixed Solutions Containing Organic Semiconductors>

A FePc solution was prepared by mixing 0.5 g of a FePc powder, 3 mL of chloroform, and 1 mL of polyoxyethylene sorbitan monostearate in a vial bottle. A ZnPc solution was prepared by mixing 1.0 g of a ZnPc powder, 3 mL of chloroform, and 1 mL of polyoxyethylene sorbitan monostearate in a vial bottle. The solutions were each stirred with a vortex mixer, and thereafter, kept at 40°C or higher, so that polyoxyethylene sorbitan monostearate in the solutions did not solidify.

### <Forming Organic Semiconductor Layers>

Within 10 mm × 15 mm center areas of a substrate of the ITO glass and an Al substrate, 60 µL of the respective prepared mixed solutions were dropped. After air-drying, the substrates were each heated in an electric furnace at 140°C for 2 hours. For the electric furnace, an economic long-type electric furnace with program features, ROP-002P by AS ONE Corporation was used.

By this step, an ITO substrate/organic semiconductor layer (FePc), an ITO substrate/organic semiconductor layer (ZnPc), an Al substrate/organic semiconductor layer (FePc), and an Al substrate/organic semiconductor layer (ZnPc) were prepared.

### <Example 4-1>

A thermoelectric conversion device made of an ITO substrate/organic semiconductor layer (FePc)/graphite layer/organic semiconductor layer (ZnPc)/Al substrate was prepared by: layering 0.08 g of graphite on the above-prepared ITO substrate/organic semiconductor layer (FePc) on the side of the organic semiconductor layer (FePc) of 10 mm × 15 mm in size to form a graphite layer; and laminating the graphite layer and the organic semiconductor layer (ZnPc) of the Al substrate/organic semiconductor layer (ZnPc). The prepared thermoelectric conversion device was sealed with a silicon-based resin, so that the organic semiconductor layers did not protrude when heated in the subsequent thermoelectric conversion measurement.

### <Comparative Example 4-1>

A device made of an Al substrate/organic semiconductor layer (FePc)/organic semiconductor layer (FePc)/Al substrate was prepared by laminating the two prepared Al substrate/organic semiconductor layers (FePc) so as to layer the organic semiconductor layers. The prepared device was sealed with a silicon-based resin, so that the organic semiconductor layers did not protrude when heated in the subsequent thermoelectric conversion measurement.

### <Comparative Example 4-2>

A device made of an ITO substrate/organic semiconductor layer (ZnPc)/organic semiconductor layer (ZnPc)/ITO substrate was prepared by laminating the two prepared ITO substrate/organic semiconductor layers (ZnPc) so as to layer the organic semiconductor layers. The prepared device was sealed with a silicon-based resin, so that the organic semiconductor layers did not protrude when heated in the subsequent thermoelectric conversion measurement.

### <Comparative Example 4-3>

In comparative example 4-3, a device was prepared by sandwiching phthalocyanine alone, which includes no metal, between electrodes, and thermoelectric conversion was measured.

In a vial bottle, 0.5 g of a phthalocyanine (Pc) powder, 3 mL of chloroform, and 1 mL of polyoxyethylene sorbitan monostearate were mixed and prepared. Within a 10 mm × 15 mm center area of each of a substrate of the ITO glass and an Al substrate, 60 µL of the resultant was dropped. After air-drying, the substrates were each heated in an electric furnace at 140°C for 2 hours. For the electric furnace, an economic long-type electric furnace with program features, ROP-002P by AS ONE Corporation was used.

By this step, an ITO substrate/phthalocyanine layer (Pc), and an Al substrate/phthalocyanine layer (Pc) were prepared.

A device made of an ITO substrate/phthalocyanine layer (Pc)/phthalocyanine layer (Pc)/Al substrate was prepared by laminating the prepared ITO substrate/phthalocyanine layer (Pc) and Al substrate/phthalocyanine layer (Pc) so as to layer the phthalocyanine layers. The prepared device was sealed with a silicon-based resin, so that the phthalocyanine layers did not protrude when heated in the subsequent thermoelectric conversion measurement.

### <Comparative Example 4-4>

In comparative example 4-4, a device was prepared by sandwiching phthalonitrile, which was a component of phthalocyanine and included no metal, between electrodes, and thermoelectric conversion was measured.

In a vial bottle, 0.5 g of a phthalonitrile (PN) powder, 3 mL of chloroform, and 1 mL of polyoxyethylene sorbitan monostearate were mixed and prepared. Within a 10 mm × 15 mm center area of each of a substrate of the ITO glass and an Al substrate, 60 µL of the resultant was dropped. After air-drying, the substrates were each heated in an electric furnace at 140°C for 2 hours. For the electric furnace, an economic long-type electric furnace with program features, ROP-002P by AS ONE Corporation was used.

By this step, an ITO substrate/phthalonitrile layer (PN), and an Al substrate/phthalonitrile layer (PN) were prepared.

A device made of an ITO substrate/phthalonitrile layer (PN)/phthalonitrile layer (PN)/Al substrate was prepared by laminating the prepared ITO substrate/phthalonitrile layer (PN) and Al substrate/phthalonitrile layer (PN) so as to layer the phthalonitrile layers. The prepared device was sealed with a silicon-based resin, so that the phthalonitrile layers did not protrude when heated in the subsequent thermoelectric conversion measurement.

### <Measuring Electrical Energy in Thermoelectric Conversion>

A measuring circuit as shown in Fig. 5 was assembled for measuring electrical energy that could be taken out of heat energy in a thermal equilibrium state in a certain thermal environment at a specific temperature T (K) concerning the devices prepared in the foregoing examples and comparative examples. Here, a measurement system was configured by connecting two units each constituted of a digital multimeter and a PC so as to be capable of observing changes over time in measurement value of each of the current and the voltage when the current and the voltage were measured. The circuit was designed in a state of incorporating a variable resistance. The temperature of the device and therearound was set to 20°C (room temperature).

In comparative examples 4-1 to 4-4, the resistance was set to 110 Ω. In example 4-1, the measurement was performed as the resistance was changed to 110 Ω, 10 kΩ, 100 kΩ and 500 kΩ.

Fig. 41(a) shows the measurement results of the voltage of the device of comparative example 4-1, and Fig. 41(b) shows the measurement results of the current of the device of comparative example 4-1.

Fig. 42(a) shows the measurement results of the voltage of the device of comparative example 4-2, and Fig. 42(b) shows the measurement results of the current of the device of comparative example 4-2.

Fig. 43 shows the measurement results of the current and the voltage of the device of comparative example 4-3.

Fig. 44 shows the measurement results of the current and the voltage of the device of comparative example 4-4.

Fig. 45(a) shows the current values to the temperature in example 4-1, Fig. 45(b) shows the voltage values to the temperature in example 4-1, and Fig. 45(c) shows the electric power values to the temperature in example 4-1.

The foregoing results proved that in comparative examples 4-1 and 4-2, the voltages of the devices attenuated, the currents were zero, that is, did not flow, and electric power was not obtained. In short, it was shown that it was necessary to make the positive electrode and the negative electrode from materials of different conductivities to create an internal electric field between the electrodes in order to generate electromotive force.

It was also proved that in comparative examples 4-3 and 4-4, the voltages of the devices attenuated, the currents were zero, that is, did not flow, and electric power was not obtained. In short, it was shown that an organic semiconductor layer provided with a material that generated electrons and holes by thermal excitation was necessary between predetermined electrodes in order to generate electromotive force.

In contrast, it was confirmed that in example 4-1, as shown in Figs. 45(a) and 45(b), when the resistance was lower, the measurement values increased depending on the temperature (110 Ω), but when the resistance was higher, reached the peaks at a temperature of 100°C to 120°C, and dropped at 140°C.

Based on Fig. 45(c), the electricity generating amount was the largest at 120°C when the resistance was 10 kΩ, and was calculated as 7.156 µW. It was also proved that at 60°C or lower, a more electric power could be taken out in the measurement when the resistance was 100 kΩ than in the measurement when the resistance was 10 kΩ.

Improvement in performance of circuits of a smaller resistance was observed at around 20°C to 60°C by graphite insertion, which can be understood as follows as a phenomenon as shown in Fig. 46.

When inserted into a middle layer to form ITO/FePc/Gr/ZnPc/Al, Gr even functions as an electrode since having conductivity although the electric conductivity of Gr (σ ≈ 105 S/m) is lower than that of Al (σ ≈ 108 S/m).

Generally, the electrical resistances of substances change according to temperatures. The resistances of metal conductors increase following a temperature rise, whereas the resistances of semiconductors and carbon decrease. Therefore, assuming that Gr has characteristics equivalent to an electrode, and is capable of functioning as a double-body series device of an ITO/FePc/Gr-type device and a Gr/ZnPc/Al-type device, the performance improvement at 20°C is understandable.

Further, Gr is a carbon atom aggregate, and successively realizes charge transfer in organic semiconductors, ZnPc and FePc via an empty p orbital. Following a temperature rise, the resistance of Gr is decreasing, the energy band gap is getting smaller, and the obtained potential energy is relatively getting smaller. It is considered that because of this, the power is small in a high temperature range of 60°C or higher.

### [Common Matters to First to Fourth Embodiments]

### <Experimental Data for Proving Theoretical Framework of Present Invention>

### (Proof that Thermoelectric Conversion Method of Present Invention is not Phenomenon by Ionization Energy)

As shown in Fig. 47, the electromotive force when a variable resistance was 500 kΩ was measured as follows: an electric conductor formed by fixing platinum foil to an aluminum flat plate having a thickness of 0.3 mm was prepared as one electrode, and an electric conductor formed by fixing a carbon electrode to a glass flat plate with double-sided tape was prepared as the other electrode; a conversion substance formed by vacuum-drying a mixed solution containing iron phthalocyanine, which was an organic semiconductor, and ferrous chloride was layered as the thermoelectric conversion substance of the present invention; and the platinum electrode was connected to the negative electrode of a voltmeter, and the carbon black carbon electrode was connected to the positive electrode of the voltmeter.

As a result, changes in positive value were obtained as shown in Fig. 48. This means that the platinum electrode operated as a negative electrode, and proved that the foregoing result did not conform to the following generally known rule: "in the phenomenon by ionization energy, platinum, which has the smallest ionization energy, operates as a positive electrode". Thus, it was proved that the thermoelectric conversion method of the present invention is not a phenomenon by ionization energy.

### (Proof that Thermoelectric Conversion Method of Present Invention is not Phenomenon Following Chemical Reaction)

As shown in Fig. 49, the electromotive force when a variable resistance was 500 kΩ was measured as follows: an electric conductor formed by fixing, to a glass flat plate having a thickness of 1.1 mm with double-sided tape, a carbon electrode of a high resistance taking a value of 2 kΩ that was obtained by penciling on a piece of paper with a pencil of HB was prepared as one electrode, and an electric conductor formed by fixing, to a glass flat plate with double-sided tape, a carbon electrode of a low resistance of 4 kΩ that was obtained by penciling on a piece of paper with a pencil of 8B was prepared as the other electrode; a conversion substance formed by vacuum-drying a mixed solution containing iron phthalocyanine, which was an organic semiconductor, and ferrous chloride was layered as the thermoelectric conversion substance of the present invention; and the carbon electrode of a low resistance was connected to the negative electrode of a voltmeter, and the carbon electrode of a high resistance was connected to the positive electrode of the voltmeter.

As a result, changes in positive value were obtained as in Fig. 50. This means that the carbon electrode of a low resistance operated as a negative electrode, and proved that the operation between the carbon-carbon electrodes, which were not chemically reactive, was by the physical principle proposed in the present invention. Thus, this also proved that the thermoelectric conversion method of the present invention is not a phenomenon by chemical reaction based on ionization energy etc.

Table 1 shows the results of the foregoing two proofs. Here, the thermoelectric conversion device of the present invention may be referred to as a thermovoltaic cell as a term meaning the thermoelectric conversion device of the present invention. In the table, this is expressed as "TV cell", and hereinafter "TV cell" is an abbreviation of the thermoelectric conversion device of the present invention.

### Table 1

**(Table 1)**

| Structure of TV cell | electrode operated as a positive electrode | electrode operated as a negative electrode |
|---|---|---|
| platinum electrode/ conversion substance/ carbon electrode | carbon electrode | platinum electrode |
| carbon electrode (high resistance)/ conversion substance/ carbon electrode (low resistance) | carbon electrode (high resistance) | carbon electrode (low resistance) |

### (Thinning of Negative Electrode of Device, and Charge Transfer Phenomenon based on Correlation between Area and Electricity Generating Amount)

Fig. 51 shows a design of the device of the fourth embodiment when aluminum foil was used for aluminum of the negative electrode for preparing the device, and the width (W) of the device was changed to 3 mm, 6 mm, 9 mm, 12 mm and 15 mm. The widths were compared, and it was examined whether there was a difference in current characteristic therebetween.

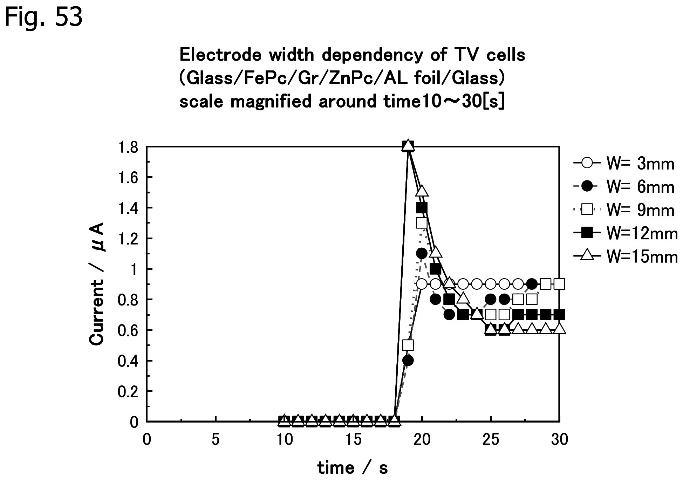

As a result, the current characteristics as shown in Fig. 52 were obtained. The results were enlarged in Fig. 53 and compared for checking the changes immediately after circuit connection in detail. The results proved that: the larger the value of W was, the larger the value of the current flowing immediately after circuit connection was; and sequentially, the current values attenuated to approach 9 µA. This proved that thinning the negative electrode to reduce the area thereof made a difference in number of electrons moving from the conversion substance to the negative electrode. This means that excitons were generated and charge separation occurred by thermal excitation in the device of the present invention before circuit connection.

### <Experimental Data Showing Electricity Generating Effect >

### (Series Connection Effect by Stacking Devices)

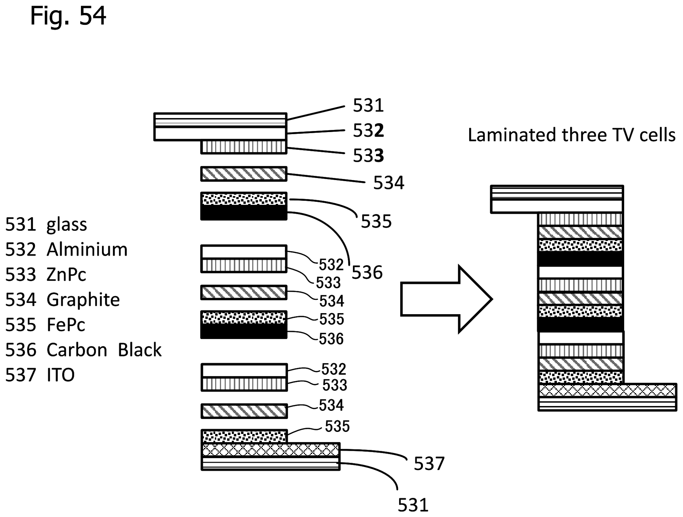

Fig. 54 shows that the use of an electrode of carbon such as carbon black as the positive electrode when the device of the fourth embodiment was prepared allowed the devices to be sequentially connected in series without using any leading wire. The three devices could be connected.

The voltage and the current measurement values of a device obtained in this manner were as shown in Fig. 55 when a variable resistance of 500 kΩ was used.

Next, Fig. 56 illustrates a case where four devices were connected in the same manner. The results were as in Fig. 57. The results in Figs. 55 and 57 proved that the measurement values were in proportion to the number of the stacked devices.

### (Scaleup of Electricity Generating Amount by Series and Parallel Connection of Electric Power Generating Devices)

Fig. 58 shows the current changes when five devices obtained by forming the thermoelectric conversion devices of the third embodiment shown below were connected in series, and Fig. 59 shows the same when these devices were connected in parallel.

For forming these devices, the devices were each prepared by: applying, to a substrate, and sealing a thermovoltaic cell (expressed as "TV cell" in the drawings as a term meaning the thermoelectric conversion device of the present invention, and hereinafter "TV cell" is an abbreviation of the thermoelectric conversion device of the present invention) that was a device made of a positive electrode/ITO substrate/organic semiconductor layer (FePc) with a transitional element (FeCl₂ and nH₂O) added/Al substrate negative electrode so as to have a size of 10 mm × 10 mm × 0.03 mm (thickness). The positive electrodes of the three devices that were not at both the ends were each layered on the negative electrodes of the devices adjacent thereto, thereby conductively connected, so that series connection was configured. For configuring parallel connection, the positive electrodes were collected together and connected to a circuit with a code of leading wire having crocodile clips at both the ends thereof, and the negative electrodes were collected together and connected in the same manner, so that parallel connection was configured. The prepared devices were sealed with a silicon-based resin, so that the organic semiconductor layers did not protrude when heated in the subsequent thermoelectric conversion measurement. It was proved that: in the series connection, the electromotive force was 4.4 to 5.6 V, which was approximately five times as much as the electromotive force in the case of the single device, which was approximately 1 V; and in the parallel connection, the electromotive force took the same value as that of the single device, but the current value showed a scaleup, that is, 10,000 µA, which was five times as much as that of the single device.

### (Inflow of Heat Flow Flux and Temperature Change, and Electricity Generating Amount Change)

It can be confirmed that the thermoelectric conversion device of the present invention operates in an environment of no temperature difference.

Fig. 60 shows the results of the following measurement: the temperature in an electric furnace (ROP-002P by As One Corporation) was changed using a program, a device was disposed in the furnace, and the current was measured with an ammeter and a voltmeter.

The device used here was formed by applying, to a substrate, a TV cell made of a positive electrode/ITO substrate/organic semiconductor layer (FePc) with a transitional element (FeCl₂ and nH₂O) added/Al substrate negative electrode so as to have a size of 10 mm × 10 mm × 0.03 mm (thickness). This one prepared device was disposed in the electric furnace. Connection was made to an external measurement circuit via a thin leading wire from the electric furnace.

The results of this measurement proved that the current increased over the long term following temperature changes, and decreased as the temperature in the furnace dropped.

Fig. 61 shows the case where a device that generated a larger current was used. Here, one device formed by applying, to a substrate, a TV cell made of a positive electrode/ITO substrate/first organic semiconductor layer (FePc) with a transitional element (FeCl₃, anhydrous) added/second organic semiconductor layer (ZnPc) with a transitional element (FeCl₂ and nH₂O) added/Al substrate negative electrode so as to have a size of 10 mm × 10 mm × 0.03 mm (thickness) was prepared and disposed in the electric furnace. Connection was made to an external measurement circuit via a thin leading wire from the electric furnace.

Fig. 62 shows the case where one device formed by applying, to a substrate, a TV cell made of a positive electrode/ITO substrate/first organic semiconductor layer (FePc) with a transitional element (FeCl₃, anhydrous) added/second organic semiconductor layer (ZnPc) with a transitional element (FeCl₂ and nH₂O) added/Al substrate negative electrode so as to have a size of 10 mm × 10 mm × 0.03 mm (thickness) was prepared and disposed in the electric furnace, connection was made to an external measurement circuit via a thin leading wire from the electric furnace, and thereafter the current generated from the device was measured under the conditions where temperature change was programed, so that there were the time period when the temperature gradually rose step by step, and the time period when the temperature suddenly rose. The time since the heat flow flux generated when the temperature in the electric furnace was being increased step by step had been produced until the heat flow flux spread over the device could be confirmed as a time lag. This characteristic proved that the electricity generating amount was increasing in an environment where the temperature was gradually increasing over the long term.

### (Continuation of State where Electricity Generating Amount was Close to Maximum Value)

The measurement when the electricity generating amount of the thermoelectric conversion device of the present invention approaches the upper limit was tried. One device formed by applying, to a substrate, a TV cell made of a positive electrode/ITO substrate/first organic semiconductor layer (FePc) with a transitional element (FeCl₃, anhydrous) added/second organic semiconductor layer (ZnPc) with a transitional element (FeCl₂ and nH₂O) added/Al substrate negative electrode so as to have a size of 10 mm × 10 mm × 0.03 mm (thickness) was prepared, and continuously irradiated with a heat flow flux by the use of a dryer of 1200 W. Fig. 63 shows the results when the heat flow flux irradiation was begun at ON, and was ceased at OFF. Fig. 63 shows that the current increased during the period from 50 s, when the heat flow flux irradiation was ON, to approximately 120 s, but thereafter took the maximum value without increasing, and continuous heat flow flux irradiation kept the electricity generating amount a certain value even the electricity generating amount took the maximum value or therearound. After 225 s, when the heat flow flux irradiation was stopped (OFF), the current value attenuated as time passed.

### (Scaleup)

In the power system of a device prepared by applying 50 mg of the thermoelectric conversion substance of the third embodiment in an application area of 1 cm² (formed by applying, to a substrate, a TV cell made of a positive electrode/ITO substrate/organic semiconductor layer (FePc) with a transitional element (FeCl₃, anhydrous) added/Al substrate negative electrode so as to have a size of 10 mm × 10 mm × 0.03 mm (thickness)) at a resistance value of 110 Ω, the current value reached 2 mA when heat flow flux irradiation was performed for 50 s. Electricity generation when the fourteen foregoing devices were connected in parallel and heat flow flux irradiation was performed for 50 s as in the same manner was examined. As a result, as shown in Fig. 64, the output of 28 mA was measured. According to this, scaleup of the thermoelectric conversion device of the present invention as a thermal excitation-type diode was enabled in the same manner as solar cells of photo excitation-type diodes.

### (Electricity Generating Effect at around Room Temperature)

Fig. 65 show that a blue light-emitting diode lit up at room temperature of 20°C when six devices were connected in series: the six devices were each formed by applying 50 mg of the thermoelectric conversion substance of the third embodiment in an application area of 1 cm² (formed by applying, to a substrate, a TV cell made of a positive electrode/ITO substrate/first organic semiconductor layer (FePc) with a transitional element (FeCl₃, anhydrous) added/second organic semiconductor layer (ZnPc) with a transitional element (FeCl₂ and nH₂O) added/Al substrate negative electrode so as to have a size of 10 mm × 10 mm × 0.03 mm (thickness)). When this devices were irradiated with a heat flow flux, the blue light-emitting diode increased brightness thereof, and emitted light as shining.

### <Experiment Data Showing Durability>

### (Device Sealing Ranks and Durability)

As the simplest structure of the device of the present invention, the thermoelectric conversion substance was inserted between the electrodes while the space between the electrodes was kept to be approximately 15 to 30 µm with resin-containing double-sided tape between the electrodes. Fig. 66 is a schematic view of resin and a tape frame necessary for forming the device.

It is important to prevent the pressure between the thermoelectric conversion substance and the electrodes from dropping. Use of a fibrous substance such as paper that is used when a device is formed using carbon-carbon electrodes causes the pressure to drop because the substance is infiltrated into the spaces in the fiber. Double-sided tape as a spacer for maintaining the space between the electrodes may bring the same problem since also containing fiber as a base material.

### (Relationship between Device Sealing and Durability: Open End Voltage Values after Heat Flow Flux Application (Daily Changes))

Fig. 67 shows the daily changes recorded using three types of devices of different sealing ranks for 100 days, and measuring the open end voltages thereof every day after a heat flow flux was applied.

The prepared three devices had the following structures, and were compared:
"(Device A): fixed with paper base material-containing double-sided tape between the electrodes": a device formed by: applying, to a substrate, a TV cell made of a positive electrode/ITO substrate/organic semiconductor layer (FePc) with a transitional element (FeCl₃, anhydrous) added/Al substrate negative electrode so as to have a size of 10 mm × 10 mm × 0.03 mm (thickness); and adhering and laminating double-sided tape containing paper as a base material (NW10S manufactured by Nichiban Co., Ltd.) that had been cut to have a width of 2 mm as a spacer between the electrodes and for adhesion without any sealing with resin or the like therearound;
"(Device B): fixed with silicon resin between the electrodes": a device formed by: applying, to a substrate, a TV cell made of a positive electrode/ITO substrate/organic semiconductor layer (FePc) with a transitional element (FeCl₃, anhydrous) added/Al substrate negative electrode so as to have a size of 10 mm × 10 mm × 0.03 mm (thickness); adhering and laminating double-sided tape containing paper as a base material (NW10S manufactured by Nichiban Co., Ltd.) that had been cut to have a width of 2 mm as a spacer between the electrodes and for adhesion; and thereafter sealing the resultant with silicon resin therearound; and
"(Device C): fixed with nonwoven fabric base material-containing double-sided tape between the electrodes, and thereafter fixed with resin for glass-to-metal fixing therearound": a device formed by: applying, to a substrate, a TV cell made of a positive electrode/ITO substrate/thermoelectric conversion substance obtained by adding a transitional element (FeCl₃, anhydrous) to an organic semiconductor layer (FePc), and thereafter removing solvent molecules by vacuum drying for three weeks/Al substrate negative electrode so as to have a size of 10 mm × 10 mm × 0.03 mm (thickness); adhering and laminating double-sided tape including nonwoven fabric as a base material (MKRC-30 manufactured by Moritoku Co., Ltd.) that had been cut to have a width of 2 mm as a spacer between the electrodes and for adhesion; and thereafter sealing the resultant with an epoxy adhesive curable as glass (Araldite 2011 adhesive with cartridges by Huntsman International LLC in Germany).

As a result, the daily changes as in Fig. 67 were obtained. Device A was the most inferior in durability, and since having been just fixed with the double-sided tape of a paper base material, the electrodes soon deteriorated. This was considered to be because of responsiveness to water vapor etc. in the atmosphere etc. Next, the device fixed with silicon resin between the electrodes (Device B) had improved durability more than device A, however, the performance thereof deteriorated by half due to the daily changes. This was considered to be because the resin was a soft substance, so that the fixing between the electrodes loosed and the pressure between the conversion substance and the electrodes dropped. Like this, desirably, the substance used as a thermoelectric conversion substance was not in contact with the outside of the device but adhered to be fixed to the electrodes. It was proved that when Device C, which was formed by: fixing the device with a thin double-sided tape, thereafter removing the air bubbles remaining in the space between the electrodes; and thereafter completely fixing the device therearound using a resin with which both glass and metal could be simultaneously fixed, and which had high durability to thermal expansion and contraction (Araldite 2011 adhesive with cartridges by Huntsman International LLC in Germany) was used, stable performance could be maintained in the daily changes for 100 days without filtration, deformation, deterioration, or the like of the contents over the long term.

### [Industrial Applicability]

Using the thermoelectric conversion device of the present invention allows heat energy to be converted into electrical energy even in a thermal environment at a certain temperature in the presence of a heat energy flow, and thus, can contribute to achievement in effective use of low-temperature waste heat, geothermal heat, ocean heat, and atmospheric heat in the temperate climate which are from the human living environment regardless of seasons, places, and latitudes. Further, as a familiar example, in a summer heat wave with recent warming, heat stored in each home, for example, heat stored in attics, and the like can be effectively used as auxiliary electric power sources for air conditioners in summer, for electric vehicles that require charging, and especially for photovoltaic electric power generation.

## Claims

1. A thermoelectric conversion device comprising:
a positive electrode;
a negative electrode, the positive electrode and the negative electrode being made from materials having different conductivities; and
an organic semiconductor layer between the positive electrode and the negative electrode, the organic semiconductor layer containing a material that generates electrons and holes by thermal excitation.

2. The thermoelectric conversion device according to claim 1, wherein
the materials having different conductivities are a material of a higher conductivity that constitutes the negative electrode and a material of a lower conductivity that constitutes the positive electrode, and difference in conductivity between the material of a higher conductivity and the material of a lower conductivity is 50 S/m to 10,000 S/m.

3. The thermoelectric conversion device according to claim 1 or 2, wherein
the positive electrode is made from indium tin oxide or a carbon material, and the negative electrode is made from a metallic material.

4. The thermoelectric conversion device according to claim 1 or 2, wherein
the material that generates electrons and holes by thermal excitation is a viscous liquid containing a material that generates electrons and holes by thermal excitation.

5. The thermoelectric conversion device according to claim 4, wherein
the viscous liquid is a viscous liquid capable of transporting ions as charge carriers.

6. The thermoelectric conversion device according to claim 1 or 2, wherein
the material that generates electrons and holes by thermal excitation is iron phthalocyanine or zinc phthalocyanine.

7. A thermoelectric conversion method comprising:
disposing the thermoelectric conversion device according to claim 1 or 2 in a thermal environment.

8. A thermoelectric conversion device comprising:
a positive electrode;
a negative electrode, the positive electrode and the negative electrode being made from materials having different conductivities; and
an organic semiconductor layer between the positive electrode and the negative electrode, the organic semiconductor layer containing materials that generate electrons and holes by thermal excitation, the organic semiconductor layer including a first organic semiconductor layer on a side of the positive electrode, and a second semiconductor layer on a side of the negative electrode, and
the first organic semiconductor layer is higher than the second semiconductor layer in HOMO energy level.

9. The thermoelectric conversion device according to claim 8, wherein
the materials having different conductivities are a material of a higher conductivity that constitutes the negative electrode and a material of a lower conductivity that constitutes the positive electrode, and difference in conductivity between the material of a higher conductivity and the material of a lower conductivity is 50 S/m to 10,000 S/m.

10. The thermoelectric conversion device according to claim 8 or 9, wherein
the positive electrode is made from indium tin oxide or a carbon material, and the negative electrode is made from a metallic material.

11. The thermoelectric conversion device according to claim 8 or 9, wherein
the materials that generate electrons and holes by thermal excitation are viscous liquids containing materials that generate electrons and holes by thermal excitation.

12. The thermoelectric conversion device according to claim 11, wherein
the viscous liquids are viscous liquids capable of transporting ions as charge carriers.

13. The thermoelectric conversion device according to claim 8 or 9, wherein
the materials that generate electrons and holes by thermal excitation are iron phthalocyanine or zinc phthalocyanine.

14. The thermoelectric conversion device according to claim 8 or 9, wherein
the materials that generate electrons and holes by thermal excitation are iron phthalocyanine contained in the first organic semiconductor layer, and zinc phthalocyanine contained in the second organic semiconductor layer.

15. A thermoelectric conversion method comprising:
disposing the thermoelectric conversion device according to claim 8 or 9 in a thermal environment.

16. A thermoelectric conversion device comprising:
a positive electrode;
a negative electrode, the positive electrode and the negative electrode being made from materials having different conductivities; and
an organic semiconductor layer between the positive electrode and the negative electrode, the organic semiconductor layer containing a material that generates electrons and holes by thermal excitation, the organic semiconductor layer further containing ions of a transition metal.

17. The thermoelectric conversion device according to claim 16, wherein
the materials having different conductivities are a material of a higher conductivity that constitutes the negative electrode and a material of a lower conductivity that constitutes the positive electrode, and difference in conductivity between the material of a higher conductivity and the material of a lower conductivity is 50 S/m to 10,000 S/m.

18. The thermoelectric conversion device according to claim 16 or 17, wherein
the positive electrode is made from indium tin oxide or a carbon material, and the negative electrode is made from a metallic material.

19. The thermoelectric conversion device according to claim 16 or 17, wherein
the material that generates electrons and holes by thermal excitation is a viscous liquid containing a material that generates electrons and holes by thermal excitation.

20. The thermoelectric conversion device according to claim 19, wherein
the viscous liquid is a viscous liquid capable of transporting ions as charge carriers.

21. The thermoelectric conversion device according to claim 16 or 17, wherein
the material that generates electrons and holes by thermal excitation is iron phthalocyanine or zinc phthalocyanine.

22. The thermoelectric conversion device according to claim 16 or 17, wherein
the ions of a transition metal are at least one kind selected from iron ions, manganese ions, copper ions, cobalt ions, and nickel ions.

23. A thermoelectric conversion method comprising:
disposing the thermoelectric conversion device according to claim 16 or 17 in a thermal environment.

24. A thermoelectric conversion device comprising:
a positive electrode;
a negative electrode, the positive electrode and the negative electrode being made from materials having different conductivities;
an organic semiconductor layer between the positive electrode and the negative electrode, the organic semiconductor layer containing materials that generate electrons and holes by thermal excitation, the organic semiconductor layer including a first organic semiconductor layer on a side of the positive electrode, and a second semiconductor layer on a side of the negative electrode; and
a layer between the first organic semiconductor layer and the second semiconductor layer, the layer being made from a carbonaceous substance.

25. The thermoelectric conversion device according to claim 24, wherein
the materials having different conductivities are a material of a higher conductivity that constitutes the negative electrode and a material of a lower conductivity that constitutes the positive electrode, and difference in conductivity between the material of a higher conductivity and the material of a lower conductivity is 50 S/m to 10,000 S/m.

26. The thermoelectric conversion device according to claim 24 or 25, wherein
the positive electrode is made from indium tin oxide or a carbon material, and the negative electrode is made from a metallic material.

27. The thermoelectric conversion device according to claim 24 or 25, wherein
the materials that generate electrons and holes by thermal excitation are viscous liquids containing materials that generate electrons and holes by thermal excitation.

28. The thermoelectric conversion device according to claim 27, wherein
the viscous liquids are viscous liquids capable of transporting ions as charge carriers.

29. The thermoelectric conversion device according to claim 24 or 25, wherein
the first organic semiconductor layer is higher than the second semiconductor layer in HOMO energy level.

30. The thermoelectric conversion device according to claim 24 or 25, wherein
the materials that generate electrons and holes by thermal excitation are iron phthalocyanine or zinc phthalocyanine.

31. The thermoelectric conversion device according to claim 24 or 25, wherein
the materials that generate electrons and holes by thermal excitation are iron phthalocyanine contained in the first organic semiconductor layer, and zinc phthalocyanine contained in the second organic semiconductor layer.

32. The thermoelectric conversion device according to claim 24 or 25, wherein
the layer made from a carbonaceous substance is a layer made from graphite.

33. A thermoelectric conversion method comprising:
disposing the thermoelectric conversion device according to claim 24 or 25 in a thermal environment.
